# EUROPÄISCHE PATENTSCHRIFT

(11) **EP 3 532 480 B1**
(45) Veröffentlichungstag und Bekanntmachung des Hinweises auf die Patenterteilung: **25.11.2020**
(21) Anmeldenummer: 17793887.5
(22) Anmeldetag: 23.10.2017
(51) Int. Cl.: C07F 15/00, C09K 11/06, H01L 51/50, H01L 51/00

(54) **METALLKOMPLEXE**
METAL COMPLEXES
COMPLEXES MÉTALLIQUES

(30) Priorität: 25.10.2016 EP 16195512
(43) Veröffentlichungstag der Anmeldung: 04.09.2019
(73) Patentinhaber: Merck Patent GmbH, 64293 Darmstadt (DE)
(72) Erfinder: STOESSEL, Philipp, 60389 Frankfurt am Main (DE); EHRENREICH, Christian, 64285 Darmstadt (DE)
(86) Internationale Anmeldenummer: PCT/EP2017/076937
(87) Internationale Veröffentlichungsnummer: WO 2018/077769

(56) Entgegenhaltungen:
- WO-A1-2006/093466
- WO-A1-2006/097717
- KR-A- 20160 072 868
- US-A1- 2008 293 945
- MARAPPAN VELUSAMY ET AL: "Synthesis, structure and electroluminescent properies of cyclometalated iridium complexes possessing sterically hindered ligands", DALTON TRANSACTIONS: THE INTERNATIONAL JOURNAL FOR INORGANIC, ORGANOMETALLIC AND BIOINORGANIC CHEMISTRY; [6015A], ROYAL SOCIETY OF CHEMISTRY, GB, 30. März 2007 (2007-03-30), Seiten 3025-3034, XP002490863, ISSN: 1477-9226
- KYE-YOUNG KIM ET AL: "Photophysics of Platinum-Acetylide Substituted Hexa- peri -hexabenzocoronenes", INORGANIC CHEMISTRY, Bd. 45, Nr. 6, 1. März 2006 (2006-03-01), Seiten 2509-2519, XP055427035, EASTON, US ISSN: 0020-1669, DOI: 10.1021/ic051788v
- PINGWU DU ET AL: "Synthesis and Structural Characterization of a New Vapochromic Pt(II) Complex Based on the 1-Terpyridyl-2,3,4,5,6-pentaphenylbenzene (TPPPB) Ligand", INORGANIC CHEMISTRY, Bd. 47, Nr. 1, 1. Januar 2008 (2008-01-01) , Seiten 69-77, XP055427036, EASTON, US ISSN: 0020-1669, DOI: 10.1021/ic700947g
- HUANG C ET AL: "High-efficiency solution processable electrophosphorescent iridium complexes bearing polyphenylphenyl dendron ligands", JOURNAL OF ORGANOMETALLIC CHEMISTRY, ELSEVIER-SEQUOIA S.A. LAUSANNE, CH, Bd. 694, Nr. 9-10, 15. April 2009 (2009-04-15), Seiten 1317-1324, XP026075692, ISSN: 0022-328X, DOI: 10.1016/J.JORGANCHEM.2008.12.009 [gefunden am 2008-12-16]
- TIANSHI QIN ET AL: "A Divergent Synthesis of Very Large Polyphenylene Dendrimers with Iridium(III) Cores: Molecular Size Effect on the Performance of Phosphorescent Organic Light-Emitting Diodes", JOURNAL OF THE AMERICAN CHEMICAL SOCIETY, Bd. 131, Nr. 40, 14. Oktober 2009 (2009-10-14), Seiten 14329-14336, XP055427038, US ISSN: 0002-7863, DOI: 10.1021/ja905118t
- ZHIGANG ZHAO ET AL: "Construction of Hexagonal Prisms of Variable Size via Coordination-Driven Multicomponent Self-Assembly", INORGANIC CHEMISTRY, Bd. 49, Nr. 19, 4. Oktober 2010 (2010-10-04), Seiten 8653-8655, XP055427039, EASTON, US ISSN: 0020-1669, DOI: 10.1021/ic1014219
- YAO-RONG ZHENG ET AL: "Coordination-Driven Self-Assembly of Truncated Tetrahedra Capable of Encapsulating 1,3,5-Triphenylbenzene", INORGANIC CHEMISTRY, Bd. 49, Nr. 22, 15. November 2010 (2010-11-15), Seiten 10238-10240, XP055427040, EASTON, US ISSN: 0020-1669, DOI: 10.1021/ic1018373
- DEANNE NOLAN ET AL: "Propellers and Planes: Phosphorescent Pt II [sigma]-Acetylides from Polyaromatic Ligands", EUROPEAN JOURNAL OF INORGANIC CHEMISTRY - CHEMISCHE BERICHTE, Bd. 2011, Nr. 21, 21. Juni 2011 (2011-06-21), Seiten 3248-3256, XP055427041, DE ISSN: 1434-1948, DOI: 10.1002/ejic.201100424
- DEANNE NOLAN ET AL: "Structure-Property Relationships and 1 O 2 Photosensitisation in Sterically Encumbered Diimine Pt II Acetylide Complexes", CHEMISTRY - A EUROPEAN JOURNAL, Bd. 19, Nr. 46, 11. November 2013 (2013-11-11), Seiten 15615-15626, XP055427043, ISSN: 0947-6539, DOI: 10.1002/chem.201300759
- HARM P. DIJKSTRA ET AL: "Transcyclometalation, a versatile methodology for multiple metal-carbon bond formation with multisite ligands", CHEMICAL COMMUNICATIONS, Nr. 2, 18. Januar 2002 (2002-01-18), Seiten 126-127, XP055429997, ISSN: 1359-7345, DOI: 10.1039/b109516c
- HARM P. DIJKSTRA ET AL: "Hexakis(PCP-Platinum and -Ruthenium) Complexes by the Transcyclometalation Reaction and Their Use in Catalysis", ADVANCED SYNTHESIS & CATALYSIS, Bd. 344, Nr. 10, 1. Dezember 2002 (2002-12-01), Seiten 1135-1141, XP055429999, DE ISSN: 1615-4150, DOI: 10.1002/1615-4169(200212)344:10<1135::AID- ADSC1135>3.0.CO;2-9
- NEIL CUMPSTEY ET AL: "Investigating the Effect of Steric Crowding in Phosphorescent Dendrimers", MACROMOLECULES, Bd. 38, Nr. 23, 1. November 2005 (2005-11-01), Seiten 9564-9570, XP055430001, US ISSN: 0024-9297, DOI: 10.1021/ma050609q
- NEIL CUMPSTEY ET AL: "Highly branched phosphorescent dendrimers", PROCEEDINGS OPTICAL DIAGNOSTICS OF LIVING CELLS II, Bd. 5937, 18. August 2005 (2005-08-18), Seite 593725, XP055430003, US ISSN: 0277-786X, DOI: 10.1117/12.620443 ISBN: 978-0-8194-0228-8
- EL HAMAOUI B ET AL: "A phosphorescent hexa-peri-hexabenzocoronene platinum complex and its time-resolved spectroscopy", SYNTHETIC METALS, ELSEVIER SEQUOIA, LAUSANNE, CH, Bd. 156, Nr. 18-20, 1. November 2006 (2006-11-01), Seiten 1182-1186, XP027940314, ISSN: 0379-6779 [gefunden am 2006-11-01]
- BERA R N ET AL: "HIGHLY BRANCHED PHOSHORESCENT DENDRIMERS FOR EFFICIENT SOLUTION-PROCESSED ORGANIC LIGHT-EMITTING DIODES", ADVANCED FUNCTIONAL MATERIALS, WILEY - V C H VERLAG GMBH & CO. KGAA, DE, Nr. 17, 7. Mai 2007 (2007-05-07), Seiten 1149-1152, XP001509487, ISSN: 1616-301X, DOI: 10.1002/ADFM.200600118
- KYU HO SONG ET AL: "Template Synthesis of a Huge Macrocycle by Olefin Metathesis Using Easily Accessible [Pt(PEt3)2] Templates", CHEMISTRY - A EUROPEAN JOURNAL, Bd. 13, Nr. 18, 15. Juni 2007 (2007-06-15) , Seiten 5129-5134, XP055430007, ISSN: 0947-6539, DOI: 10.1002/chem.200700213
- TIANSHI QIN ET AL: "Red-Emitting Dendritic Iridium(III) Complexes for Solution Processable Phosphorescent Organic Light-Emitting Diodes", MACROMOLECULAR RAPID COMMUNICATIONS, Bd. 33, Nr. 12, 27. Juni 2012 (2012-06-27) , Seiten 1036-1041, XP055430016, DE ISSN: 1022-1336, DOI: 10.1002/marc.201100657
- DATABASE CA [Online] CHEMICAL ABSTRACTS SERVICE, COLUMBUS, OHIO, US; 2013, HSIEH, KUO HUANG ET AL: "Pentacene benzene group containing compound, polymer derived and producing method thereof", XP002777518, gefunden im STN Database accession no. 2013:117994 & TW 358 412 B (NATIONAL TAIWAN UNIVERSITY, TAIWAN) 21. Februar 2012 (2012-02-21) & TW 358 412 B (NATIONAL TAIWAN UNIVERSITY, TAIWAN) 21. Februar 2012 (2012-02-21)

## Beschreibung

Die vorliegende Erfindung betrifft Metallkomplexe, welche mit aromatischen oder heteroaromatischen Substituenten substituiert sind und welche sich für den Einsatz als Emitter in organischen Elektrolumineszenzvorrichtungen eignen.

Gemäß dem Stand der Technik werden in phosphoreszierenden organischen Elektrolumineszenzvorrichtungen (OLEDs) als Triplettemitter vor allem Iridium- oder auch Platinkomplexe eingesetzt, insbesondere orthometallierte Komplexe mit aromatischen Liganden, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)iridium(III) und Derivate davon, wobei als Liganden beispielsweise 1- oder 3-Phenylisochinoline, 2-Phenyl-chinoline oder Phenyl-carbene einsetzt werden. Dabei lassen sich die genannten Komplexe aus Lösung relativ schwer verarbeiten.

Iridiumkomplexe mit Liganden, die (Pentaphenyl)phenyl-Strukturen enthalten, werden in US 2010/0137461 A dargelegt. Allerdings umfassen diese Iridiumkomplexe zwingend monodentate Liganden oder Liganden, die lediglich über zwei Sauerstoffatome oder über ein Sauerstoff- und ein Stickstoffatom mit dem Iridiumatom verknüpft sind.

Aus WO 2006/093466 sind Iridiumkomplexe bekannt, welche Tetraphenylpyridyl-benzol und Derivate davon als Liganden enthalten. Komplexe mit einem tripodalen hexadentaten Liganden sind nicht offenbart.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug auf Effizienz, Betriebsspannung und/oder Lebensdauer zeigen. Durch orientierte Emission kann man eine höhere Quanteneffizienz durch verbesserte Lichtauskopplung aus dem Bauteil erhalten, so dass die OLED insgesamt eine höhere Effizienz aufweist. Als Folge davon kann das Bauteil mit weniger Strom getrieben werden, woraus als weiterer Vorteil eine höhere Lebensdauer folgt. Eine weitere Aufgabe ist die Bereitstellung von Metallkomplexen, die eine verbesserte Verarbeitbarkeit aufweisen, insbesondere aus Lösung.

Überraschend wurde gefunden, dass Iridiumkomplexe, welche einen oder mehrere Substituenten aus Arylen- bzw. Heteroarylengruppen Gruppen enthalten, die oben genannte Aufgabe lösen und sich sehr gut für die Verwendung in einer organischen Elektrolumineszenzvorrichtung eignen. Diese Komplexe und organische Elektrolumineszenzvorrichtungen, welche diese Komplexe enthalten, sind daher der Gegenstand der vorliegenden Erfindung.

Gegenstand der Erfindung ist somit eine Verbindung gemäß der folgenden Formel (1),

M(L)ₙ(L')ₘ Formel (1)

wobei für die verwendeten Symbole und Indizes gilt:
- M: ist Iridium;
- L: ist bei jedem Auftreten gleich oder verschieden ein bidentater, bevorzugt monoanionischer Ligand;
- L': ist bei jedem Auftreten gleich oder verschieden ein Ligand;
- n: ist 3;
- m: ist 0;
wobei die Liganden über eine trivalente Brücke verknüpft sind, wodurch ein Metallkomplex enthaltend Iridium und einen hexadentaten tripodalen Liganden gebildet wird,
dadurch gekennzeichnet, dass der Metallkomplex mindestens eine Teilstruktur der Formel (2) enthält, 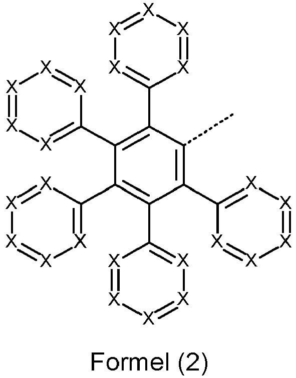 wobei die gestrichelte Bindung die Verknüpfung dieser Gruppe mit einem weiteren Teil des Metallkomplexes der Formel (1) darstellt und weiterhin gilt:
- X: ist bei jedem Auftreten gleich oder verschieden CR oder N mit der Maßgabe, dass maximal drei Symbole X pro Cyclus für N stehen;
- R: ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R auch miteinander ein Ringsystem bilden;
- R¹: ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können, dabei können zwei oder mehrere Substituenten R² auch miteinander ein mono- oder polycyclisches Ringsystem bilden;
wobei die Teilstruktur neben der mit einer gestrichelten Bindung dargestellten Verknüpfung weitere Bindungen mit Teilen des Metallkomplexes der Formel (1) aufweisen kann;
mit der Maßgabe, dass die bidentaten Liganden L des Metallkomplexes jeweils mindestens eine C-Ir-Verknüpfung aufweisen.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

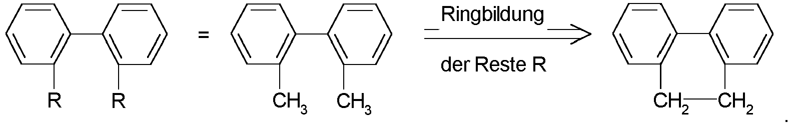

Ebenso ist die Ringbildung von bicyclischen, tricyclischen und oligocyclischen Strukturen möglich. Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

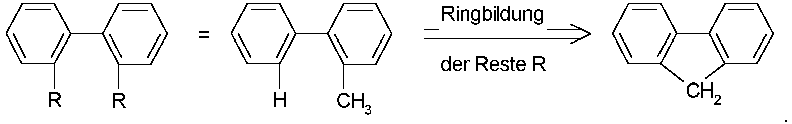

Ganz analog soll darunter auch verstanden werden, dass für den Fall, dass beide Reste Wasserstoffatome darstellen, statt der beiden Wasserstoffatome eine Ringbildung durch eine Einfachbindung erfolgt.

Die Bildung eines aromatischen Ringsystems soll durch das folgende Schema verdeutlicht werden:

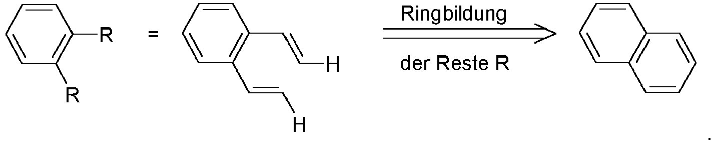

Dabei kann die Ringbildung an Resten erfolgen, die an direkt aneinander gebundene Kohlenstoffatome gebunden sind, oder an Resten, die an weiter entfernt liegende Kohlenstoffatome gebunden sind. Bevorzugt ist eine solche Ringbildung bei Resten, die an direkt aneinander gebundene Kohlenstoffatome oder an dasselbe Kohlenstoffatom gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden. Weiterhin soll im Sinne der vorliegenden Erfindung unter einer Arylgruppe eine Gruppe verstanden werden, in der zwei, drei oder mehr Phenylgruppen, die direkt aneinander gebunden sind, durch eine Gruppe CR₂ miteinander verbrückt sind, also beispielsweise eine Fluorengruppe, eine Spirobifluorengruppe oder eine Indenofluorengruppe.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1 -yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer bevorzugten Ausgestaltung kann die Teilstruktur der Formel (2) mindestens einer der Formeln (2-1), (2-2) und/oder (2-3) entsprechen, 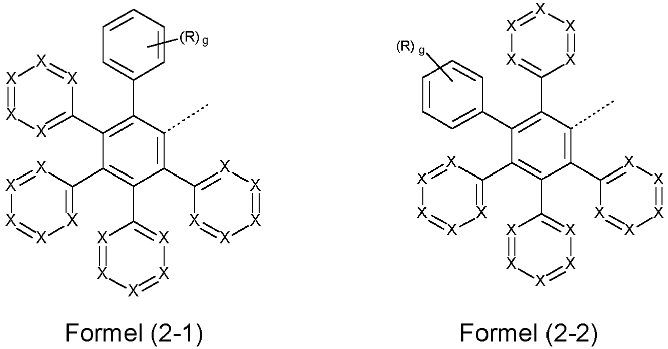 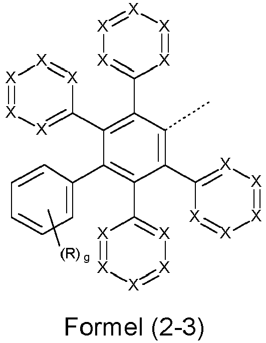 wobei die verwendeten Symbole R und X die zuvor, insbesondere für Formel (2) genannten Bedeutungen aufweisen und g 0, 1, 2, 3, 4 oder 5, vorzugsweise 0, 1, 2 oder 3 ist, wobei die Teilstruktur neben der mit einer gestrichelten Bindung dargestellten Verknüpfung weitere Bindungen mit Teilen des Metallkomplexes der Formel (1) aufweisen kann.

Vorzugsweise können die erfindungsgemäßen Metallkomplexe Teilstrukturen der Formel (2) umfassen, die mindestens einer der Formeln (2-1a), (2-1b), (2-1c), (2-1d), (2-2a) und/oder (2-2b) entsprechen, 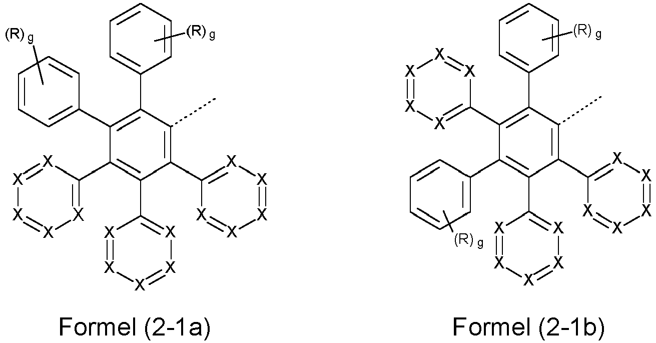 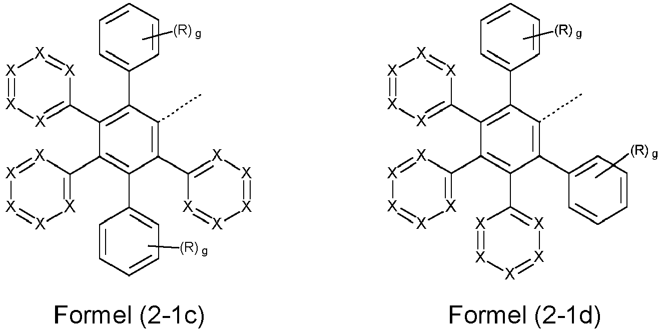 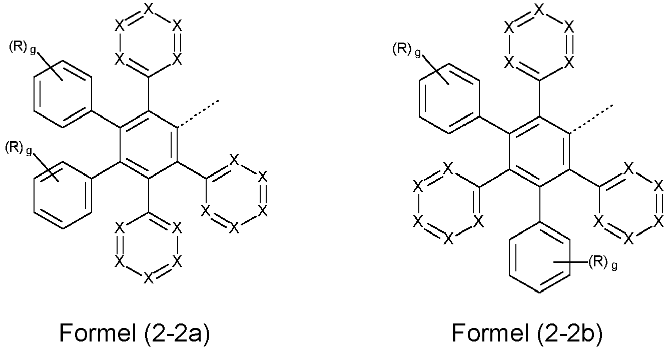 wobei die verwendeten Symbole R und X die zuvor, insbesondere für Formel (2) genannten Bedeutungen aufweisen und g gleich oder verschieden bei jedem Auftreten 0, 1, 2, 3, 4 oder 5, vorzugsweise 0, 1, 2 oder 3 ist, wobei die Teilstruktur neben der mit einer gestrichelten Bindung dargestellten Verknüpfung weitere Bindungen mit Teilen des Metallkomplexes der Formel (1) aufweisen kann.

Ferner kann vorgesehen sein, dass die zuvor dargelegte Teilstruktur der Formel (2) mindestens einer der Formeln (2-1e), (2-1f), (2-1g), (2-1h), (2-1i) und/oder (2-2c) entspricht, 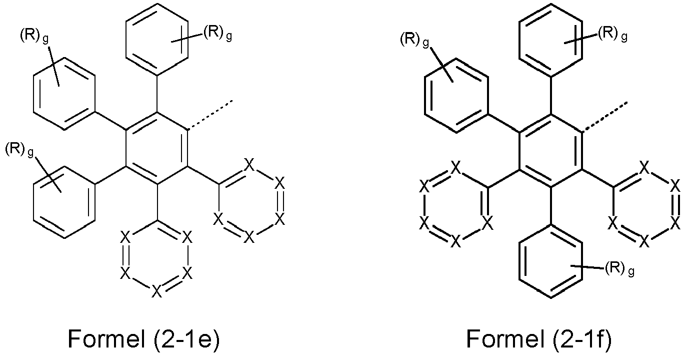 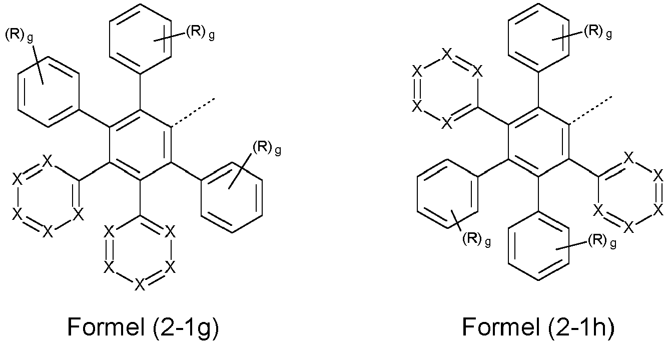 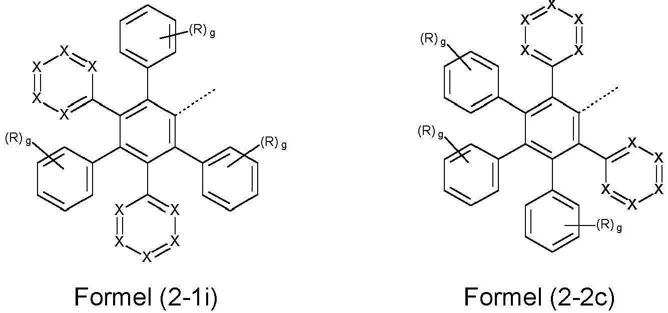 wobei die verwendeten Symbole R und X die zuvor, insbesondere für Formel (2) genannten Bedeutungen aufweisen und g gleich oder verschieden bei jedem Auftreten 0, 1, 2, 3, 4 oder 5, vorzugsweise 0, 1, 2 oder 3 ist, wobei die Teilstruktur neben der mit einer gestrichelten Bindung dargestellten Verknüpfung weitere Bindungen mit Teilen des Metallkomplexes der Formel (1) aufweisen kann.

Bevorzugt stehen höchstens zwei Gruppen X in den Formeln (2), (2-1), (2-1a) bis (2-1i), (2-2), (2-2a) bis (2-2c), (2-3) pro Ring für N. Besonders bevorzugt umfasst die Teilstruktur der Formel (2) oder deren bevorzugte Ausführungsformen höchstens zwei, besonders bevorzugt höchstens ein und speziell bevorzugt kein Stickstoffatom. Darüber hinaus sind Verbindungen bevorzugt, die dadurch gekennzeichnet sind, dass in Formeln (2), (2-1), (2-1a) bis (2-1i), (2-2), (2-2a) bis (2-2c), (2-3) pro Ring, mindestens vier, vorzugsweise alle X für CR stehen, wobei vorzugsweise höchstens 4, besonders bevorzugt höchstens 3 und speziell bevorzugt höchstens 2 der Gruppen CR, für die X steht, ungleich der Gruppe CH ist. Besonders bevorzugt umfasst die Teilstruktur der Formeln (2), (2-1), (2-1a) bis (2-1i), (2-2), (2-2a) bis (2-2c), (2-3) höchstens zwei, besonders bevorzugt höchstens einen und speziell bevorzugt keinen Rest R, der ungleich H ist.

Darüber hinaus kann vorgesehen sein, dass der Metallkomplex mindestens eine Teilstruktur der Formel (2-4) umfasst, 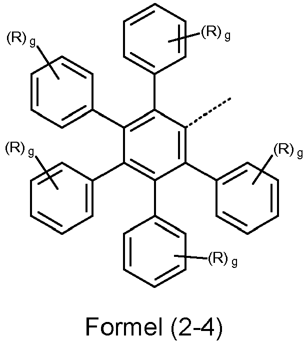 wobei die verwendeten Symbole R und X die zuvor, insbesondere für Formel (2) genannten Bedeutungen aufweisen und g gleich oder verschieden bei jedem Auftreten 0, 1, 2, 3, 4 oder 5, vorzugsweise 0, 1, 2 oder 3 ist, wobei die Teilstruktur neben der mit einer gestrichelten Bindung dargestellten Verknüpfung weitere Bindungen mit Teilen des Metallkomplexes der Formel (1) aufweisen kann.

Vorzugsweise kann vorgesehen sein, dass die Summe der Indices g in den Strukturen der Formel (2), (2-1), (2-1a) bis (2-1 i), (2-2), (2-2a) bis (2-2c), (2-3) und (2-4) jeweils höchstens 8, vorzugsweise höchstens 6, besonders bevorzugt höchstens 4, speziell bevorzugt höchstens 2 und ganz besonders bevorzugt höchstens 1 beträgt.

Vorzugsweise kann vorgesehen sein, dass die Teilstruktur gemäß Formel (2) oder deren bevorzugte Ausführungsformen keine weiteren Bindungen oder Verknüpfungen mit Teilen des Metallkomplexes aufweist, so dass die Teilstrukturen nur die durch die gestrichelte Linie in der zuvor dargelegten Formel (2) oder deren bevorzugte Ausführungsformen mit den weiteren Teilen des Metallkomplexes verknüpft ist.

In einer bevorzugten Ausführungsform ist die mit einer gestrichelten Bindung in Formel (2), (2-1), (2-1a) bis (2-1i), (2-2), (2-2a) bis (2-2c), (2-3), (2-4) dargestellte Verknüpfung der Teilstruktur gemäß Formel (2), (2-1), (2-1a) bis (2-1i), (2-2), (2-2a) bis (2-2c), (2-3) und/oder (2-4) mit einem aromatischen oder heteroaromatischen Ringsystem, vorzugsweise einem Aryl- oder Heteroarylrest mit vorzugsweise 5 bis 40 Ringatomen verbunden. Hierbei kann das aromatische oder heteroaromatische Ringsystem, vorzugsweise der Aryl- oder Heteroarylrest mit 5 bis 40 Ringatomen, vorzugsweise 5 bis 24 mit Ringatomen und speziell bevorzugt 6 bis 12 mit Ringatomen mit einem oder mehreren Resten R, wie dieser zuvor für Formel (2) definiert wurde, substituiert sein; vorzugsweise ist dieser Rest jedoch unsubstituiert. Dabei ist das aromatische oder heteroaromatische Ringsystem bzw. der Aryl- oder Heteroarylrest bevorzugt ein Teil eines Liganden L und koordiniert direkt an das Metall M.

Ferner kann vorgesehen sein, dass die mit einer gestrichelten Bindung in Formel (2), (2-1), (2-1a) bis (2-1i), (2-2), (2-2a) bis (2-2c), (2-3) und (2-4) dargestellte Verknüpfung der Teilstruktur gemäß Formel (2), (2-1), (2-1a) bis (2-1i), (2-2), (2-2a) bis (2-2c), (2-3) und/oder (2-4) mit einem Aryl- oder Heteroarylrest der Formel (Ar-1) verbunden ist, 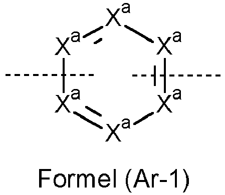 wobei eine der gestrichelten Bindungen die Verknüpfung dieser Gruppe mit weiteren Teilen des Metallkomplexes der Formel (1) darstellt und die andere der gestrichelten Bindungen die Verknüpfung dieser Gruppe mit einer der Teilstrukturen gemäß Formel (2), (2-1), (2-1a) bis (2-1i), (2-2), (2-2a) bis (2-2c), (2-3) oder (2-4) darstellt und die verwendeten Symbole X^{a} gleich oder verschieden bei jedem Auftreten N, CR oder C für den Fall, dass an X^{a} eine Bindung an die Teilstruktur der zuvor dargelegten Formel (2) oder deren bevorzugte Ausführungsformen oder an einen weiteren Teil des Metallkomplexes der Formel (1) darstellt, oder zwei benachbarte Gruppen X^{a} stehen zusammen für O, S, NR mit der Maßgabe, dass ein 5-Ring gebildet wird, und R jeweils unabhängig die zuvor, insbesondere für Formel (2) genannte Bedeutung aufweist, wobei die Teilstruktur neben der mit einer gestrichelten Bindung dargestellten Verknüpfung weitere Bindungen mit Teilen des Metallkomplexes der Formel (1) aufweisen kann.

Bevorzugt umfasst der Aryl- oder Heteroarylrest der Formel (Ar-1) oder dessen bevorzugte Ausführungsformen höchstens zwei, besonders bevorzugt höchstens ein und speziell bevorzugt kein Stickstoffatom. Darüber hinaus sind Verbindungen bevorzugt, die dadurch gekennzeichnet sind, dass in Formel (Ar-1) mindestens vier, vorzugsweise alle X^{a} für CR oder C stehen, wobei vorzugsweise höchstens 4, besonders bevorzugt höchstens 3 und speziell bevorzugt höchstens 2 der Gruppen CR für die X^{a} steht, ungleich der Gruppe CH oder C ist. Besonders bevorzugt umfasst der Aryl- oder Heteroarylrest der Formel (Ar-1) oder dessen bevorzugte Ausführungsformen höchstens zwei, besonders bevorzugt höchstens ein und speziell bevorzugt keinen Rest R der ungleich H ist.

In einer bevorzugten Ausgestaltung kann das zuvor beschriebene und mit der Teilstruktur gemäß Formel (2), (2-1), (2-1a) bis (2-1i), (2-2), (2-2a) bis (2-2c), (2-3) und/oder (2-4) verbundene aromatische oder heteroaromatische Ringsystem, insbesondere die in Formel (Ar-1) dargelegte bevorzugte Ausführungsform desselben, direkt mit dem Metallatom M verbunden sein.

Ferner kann vorgesehen sein, dass der Aryl- oder Heteroarylrest der Formel (Ar-1) mit einem weiteren Aryl- oder Heteroarylrest mit 5 bis 24 Ringatomen verbunden ist, der wiederum mit dem Metallatom M interagiert.

Demgemäß weisen die erfindungsgemäßen Metallkomplexe vorzugsweise Teilstrukturen der Formeln (2-5) und/oder (2-6) auf, 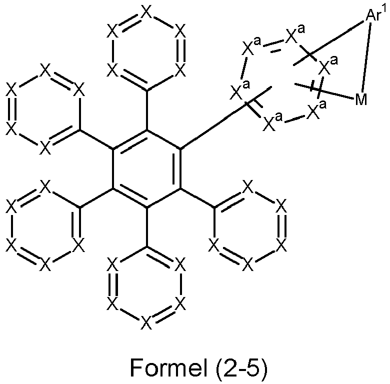 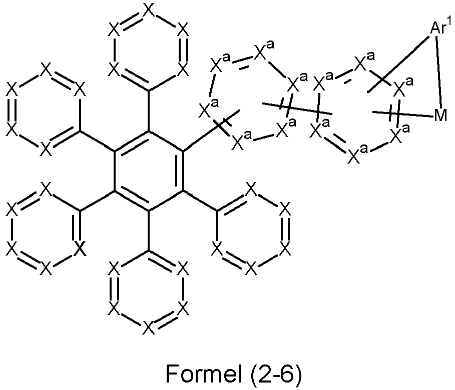 wobei die verwendeten Symbole R und X die zuvor, insbesondere für Formel (2) genannten Bedeutungen aufweisen, das Symbol M die zuvor insbesondere für Formel (1) genannte Bedeutung hat, das Symbol X^{a} die zuvor, insbesondere für Formel (Ar-1) genannte Bedeutung aufweist, und Ar¹ ein aromatisches oder heteroaromatisches Ringsystem, mit 5 bis 40 Ringatomen, darstellt, das mit einem oder mehreren Resten R, wie dieser zuvor für Formel (2) definiert wurde, substituiert sein kann, wobei die Teilstruktur weitere Bindungen mit Teilen des Metallkomplexes der Formel (1) aufweisen kann. In einer bevorzugten Ausführungsform weist die Teilstruktur keine weiteren Bindungen mit Teilen des Metallkomplexes der Formel (1) auf.

Die Gruppe Ar¹ in Formeln (2-5) und/oder (2-6) stellt ein aromatisches oder heteroaromatisches Ringsystem mit 5 bis 40 Ringatomen, vorzugsweise 5 bis 24 mit Ringatomen und speziell bevorzugt 6 bis 12 mit Ringatomen dar, das mit einem oder mehreren Resten R, wie dieser zuvor für Formel (2) definiert wurde, substituiert sein kann. Vorzugsweise stellt die Gruppe Ar¹ in den Formeln (2-5) und/oder (2-6) einen Aryl- oder Heteroarylrest mit 5 bis 40 Ringatomen, vorzugsweise 5 bis 24 mit Ringatomen und speziell bevorzugt 6 bis 12 mit Ringatomen dar, so dass die dargelegten Bindungen in den Formeln (2-5) und/oder (2-6) direkt mit der weiteren aromatischen oder heteroaromatischen Gruppen verbunden ist und die Gruppe Ar¹ mit der aromatischen oder heteroaromatischen Gruppe, an die die Gruppe Ar¹ bindet, wie dieser auch durch die Formel (Ar-1) dargelegt ist, eine durchgängige Konjugation bildet. Der Rest Ar¹ kann zusammen mit der aromatischen oder heteroaromatischen Gruppe, an die die Gruppe Ar¹ bindet, wie dieser auch durch die Formel (Ar-1) dargelegt ist, ein kondensiertes Ringsystem bilden, so dass die Gruppen R der jeweiligen Ringsyteme mit der in Formeln (2-5) und/oder (2-6) dargelegten Bindung ein aliphatisches, heteroaliphatisches, aromatisches oder heteroaromatisches Ringsystem bilden können.

In einer bevorzugten Ausführungsform der Erfindung koordiniert die Gruppe der Formel (Ar-1) direkt an M, insbesondere über ein Kohlenstoffatom, und die Teilstruktur der Formel (2) ist an (Ar-1) in der Position para zur Koordination an M gebunden. Bevorzugt weist die Gruppe der Formel (Ar-1) daher die Struktur der folgenden Formel (Ar-1 a) auf, 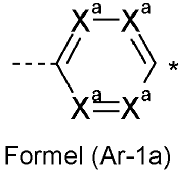 wobei * die Position der Koordination an M darstellt, die gestrichelte Bindung die Anknüpfung der Teilstruktur der Formel (2) darstellt und X^{a} die oben angegebenen Bedeutungen aufweist. Weiterhin bevorzugt ist in Formel (2-5) und (2-6) die Gruppe Ar¹ in der ortho-Position zur Koordination an M gebunden.

In einer bevorzugten Ausführungsform der vorliegenden Erfindung ist die Gruppe Ar¹ in Formeln (2-5) und/oder (2-6) eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Metall koordiniert, welche mit einem oder mehreren Resten R substituiert sein kann.

In einer weiteren bevorzugten Ausführungsform der vorliegenden Erfindung ist die Gruppe Ar¹ in Formeln (2-5) und/oder (2-6) eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Stickstoffatom an das Metall koordiniert, wobei diese Gruppe mit einem oder mehreren Resten R substituiert sein kann.

Bevorzugt stehen höchstens zwei Gruppen X beziehungsweise X^{a} in den Formeln (2-5) und/oder (2-6) pro Ring für N. Besonders bevorzugt umfasst die Teilstruktur der Formeln (2-5) und/oder (2-6) oder deren bevorzugte Ausführungsformen höchstens drei, besonders bevorzugt höchstens zwei und speziell bevorzugt genau ein Stickstoffatom, wobei diese Teilstrukturen Gruppen der Formeln X, X^{a} und Ar¹ enthalten. Darüber hinaus sind Verbindungen bevorzugt, die dadurch gekennzeichnet sind, dass in Formeln (2-5) und/oder (2-6) pro Ring mindestens vier, vorzugsweise alle X für CR stehen, wobei vorzugsweise höchstens 4, besonders bevorzugt höchstens 3 und speziell bevorzugt höchstens 2 der Gruppen CR, für die X steht, ungleich der Gruppe CH sind. Weiterhin sind Verbindungen umfassend eine Teilstruktur der Formeln (2-5) oder (2-6) oder deren bevorzugte Ausführungsformen bevorzugt, bei denen mindestens zwei, vorzugsweise mindestens drei der Gruppen X^{a} für CR und höchstens zwei, vorzugsweise genau eine oder keine der Gruppen X^{a} für N steht. Wenn eine Gruppe X^{a} für N steht, ist es bevorzugt, wenn dieses Stickstoffatom direkt an das Metall M koordiniert ist. Besonders bevorzugt steht keine der Gruppen X^{a} für N. Besonders bevorzugt umfasst die Teilstruktur der Formeln (2-5) und/oder (2-6) höchstens acht, vorzugsweise höchstens sechs, besonders bevorzugt höchstens vier, speziell bevorzugt höchstens zwei und ganz besonders bevorzugt höchstens ein und speziell bevorzugt keinen Rest R der ungleich H ist.

Vorzugsweise kann eine Gruppe X^{a} für ein Stickstoffatom stehen, welches an das Metallatom M koordiniert ist. Ferner kann der Rest Ar¹ ein Stickstoffatom enthalten, welches mit dem Metallatom M verknüpft ist. In diesem Fall können vorzugsweise alle Gruppen X^{a} für ein C-Atom oder eine Gruppe CR stehen.

In einer bevorzugten Ausführungsform bildet eine Teilstruktur der Formeln (2-5) und/oder (2-6) einen bidentaten Liganden L gemäß Formel (1). Demgemäß gelten die zuvor und nachfolgend für diese bidentaten Liganden dargelegten Bevorzugungen auch für die Teilstrukturen der Formeln (2-5) und/oder (2-6).

Die erfindungsgemäßen Metallkomplexe der Formel (1) können ein, zwei, drei oder mehr der zuvor näher dargelegten Teilstrukturen der Formel (2) oder deren bevorzugte Ausführungsformen enthalten. In einer speziellen Ausführungsform kann ein erfindungsgemäßer Metallkomplex der Formel (1) genau eine Teilstruktur der Formel (2) umfassen. Vorzugsweise können Metallkomplexe der Formel (1) zwei, besonders bevorzugt drei oder mehr der zuvor näher dargelegten Teilstrukturen der Formel (2) oder deren bevorzugte Ausführungsformen enthalten. Speziell bevorzugt umfassen die erfindungsgemäßen Metallkomplexe der Formel (1) ein, zwei, drei oder sechs Teilstrukturen der Formel (2) oder deren bevorzugte Ausführungsformen.

Im Folgenden werden die bidentaten Liganden beschrieben, die in Formel (1) mit dem Symbol L dargelegt und mit M verknüpft sind. Hierbei können die koordinierenden Atome der bidentaten Liganden gleich oder verschieden bei jedem Auftreten ausgewählt sein aus C, N, P, O, S und/oder B, besonders bevorzugt C, N und/oder O und ganz besonders bevorzugt C und/oder N. Dabei weisen die bidentaten Liganden bevorzugt ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome auf. Wie oben beschrieben, weisen die bidentaten Liganden mindestens eine Iridium-Kohlenstoffbindung auf. Dabei können die koordinierenden Atome von jedem der Liganden gleich sein, oder sie können unterschiedlich sein. Bevorzugt weist mindestens einer, besonders bevorzugt alle der bidentaten Liganden ein Kohlenstoffatom und ein Stickstoffatom oder zwei Kohlenstoffatome als koordinierende Atome auf, insbesondere ein Kohlenstoffatom und ein Stickstoffatom. Besonders bevorzugt weisen mindestens zwei der bidentaten Liganden und ganz besonders bevorzugt für M = Ir alle drei bidentaten Liganden ein Kohlenstoffatom und ein Stickstoffatom oder zwei Kohlenstoffatome als koordinierende Atome auf, insbesondere ein Kohlenstoffatom und ein Stickstoffatom. Besonders bevorzugt handelt es sich somit um einen Iridiumkomplex, in dem alle drei bidentaten Liganden ortho-metalliert sind, d. h. mit dem Iridium einen Metallacyclus bilden, in dem mindestens eine Iridium-Kohlenstoff-Bindung vorliegt.

Die Indizes in der zuvor dargelegten Formel (1) oder der bevorzugten Ausführungsformen dieser Formel ist von der Art des Metalls und einer möglichen Verknüpfung der Liganden abhängig.

Die drei bidentaten Liganden L können gleich oder verschieden sein. Wenn die bidentaten Liganden gleich sind, sind sie bevorzugt auch gleich substituiert. Wenn alle drei bidentaten Liganden gleich gewählt sind, entstehen bei polypodalen Komplexen C₃-symmetrische Iridiumkomplexe. Es kann auch vorteilhaft sein, die drei bidentaten Liganden unterschiedlich zu wählen bzw. zwei Liganden gleich und den dritten Liganden davon verschieden zu wählen, so dass C₁-symmetrische Metallkomplexe entstehen, weil dies größere Variationsmöglichkeiten der Liganden zulässt, so dass sich die gewünschten Eigenschaften des Komplexes, wie beispielsweise die Lage von HOMO und LUMO bzw. die Emissionsfarbe leichter variieren lassen. Außerdem lässt sich so auch die Löslichkeit der Komplexe verbessern, ohne lange aliphatische oder aromatische, löslichkeitsvermittelnde Gruppen anbringen zu müssen.

In einer bevorzugten Ausführungsform der Erfindung sind die drei bidentaten Liganden entweder gleich gewählt oder zwei der bidentaten Liganden sind gleich gewählt und der dritte bidentate Ligand ist unterschiedlich von den ersten beiden bidentaten Liganden.

Es ist weiterhin bevorzugt, wenn es sich bei dem Metallacyclus, der aus dem Metall und dem bidentaten Liganden aufgespannt wird, um einen Fünfring handelt, der vor allem dann bevorzugt ist, wenn die koordinierenden Atome C und N oder C und C sind. Dies wird im Folgenden schematisch dargestellt: 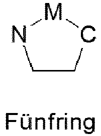 wobei N ein koordinierendes Stickstoffatom und C ein koordinierendes Kohlenstoffatom darstellt und die eingezeichneten Kohlenstoffatome Atome des bidentaten Liganden darstellen.

In einer bevorzugten Ausführungsform der Erfindung ist mindestens einer der bidentaten Liganden, besonders bevorzugt mindestens zwei der bidentaten Liganden, ganz besonders bevorzugt alle drei bidentaten Liganden des in Formel (1) dargelegten Metallkomplexes gleich oder verschieden bei jedem Auftreten ausgewählt aus den Strukturen der folgenden Formeln (L-1), (L-2) oder (L-3), 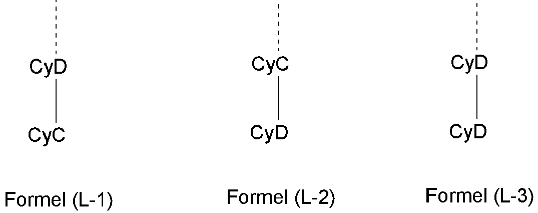 wobei für die verwendeten Symbole gilt:
CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche jeweils über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei sind die Liganden (L-1), (L-2) und/oder (L-3) miteinander über eine trivalente Brücke verknüpft und spannen so ein hexadentates Ligandensystem auf, wobei diese Bindungen an eine Brücke durch die gestrichelte Bindung angedeutet ist; dabei können mehrere der optionalen Substituenten miteinander ein Ringsystem bildenweiterhin sind die optionalen Reste bevorzugt ausgewählt aus den oben genannten Resten R und/oder der Teilstruktur der Formel (2).

Dabei koordiniert CyD in den Liganden der Formeln (L-1) und (L-2) bevorzugt über ein neutrales Stickstoffatom oder über ein Carben-Kohlenstoffatom. Weiterhin bevorzugt koordiniert eine der beiden Gruppen CyD in dem Liganden der Formel (L-3) über ein neutrales Stickstoffatom und und die andere der beiden Gruppen CyD über ein anionisches Stickstoffatom. Weiterhin bevorzugt koordiniert CyC in den Liganden der Formeln (L-1) und (L-2) über anionische Kohlenstoffatome.

Weiterhin bevorzugt bindet die Teilstruktur der Formel (2) an eine der Gruppen CyC oder CyD, bevorzugt an CyC. Dabei entspricht CyC bevorzugt der vorne aufgeführten Struktur der Formel (Ar-1), wenn in dieser Struktur eine Gruppe X^{a} für C steht, welches an M koordiniert, oder CyD entspricht der vorne aufgeführten Struktur der Formel (Ar-1), wenn in dieser Struktur eine Gruppe X^{a} für N steht, welches an M koordiniert.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD in den Formeln (L-1) und (L-2) bzw. die Substituenten an den beiden Gruppen CyD in Formel (L-3) miteinander einen Ring bilden, wodurch CyC und CyD bzw. die beiden Gruppen CyD bzw. die beiden Gruppen CyC auch zusammen eine einzige kondensierte Aryl- bzw. Heteroarylgruppe als bidentaten Liganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Metall koordiniert, welche mit einem oder mehreren Resten R substituiert sein kann und welche über eine kovalente Bindung mit CyD verbunden ist. Besonders bevorzugt ist CyC eine Gruppe der vorne aufgeführten Formel (Ar-1).

Bevorzugte Ausführungsformen der Gruppe CyC sind die Strukturen der folgenden Formeln (CyC-1) bis (CyC-20), 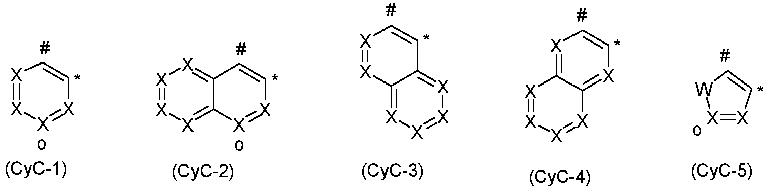 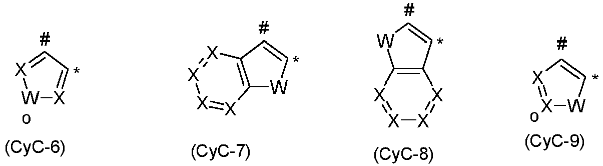 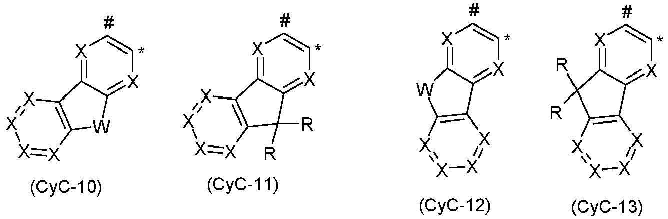 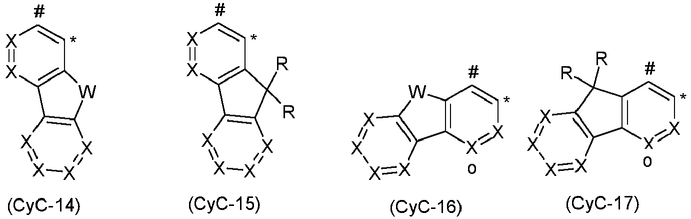 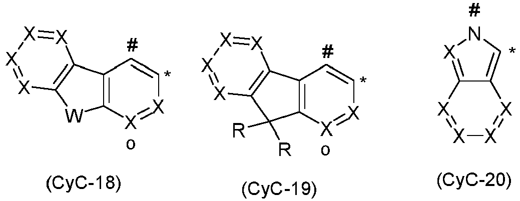 wobei CyC jeweils an der durch # gekennzeichneten Position an CyD bindet und an der durch * gekennzeichneten Position an das Metall koordiniert, R die oben genannten Bedeutungen aufweist und für die weiteren verwendeten Symbole gilt:
X ist bei jedem Auftreten gleich oder verschieden CR oder N, wobei vorzugsweise maximal zwei Symbole X pro Cyclus für N stehen;
W ist NR, O oder S;
wobei die Liganden über die Gruppe CyC durch eine Brücke verbunden sein können, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt. Die oben abgebildeten Strukturen, die kein mit "o" markiertes Symbol X enthalten, sind bevorzugt nicht direkt an eine Brücke gebunden, da eine solche Bindung an die Brücke aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn CyC an eine Brücke gebunden ist, ein Symbol X für C steht und die Brücke an dieses Kohlenstoffatom gebunden ist.

Besonders bevorzugte Gruppen CyC sind die Gruppen der folgenden Formeln (CyC-1a) bis (CyC-20a), 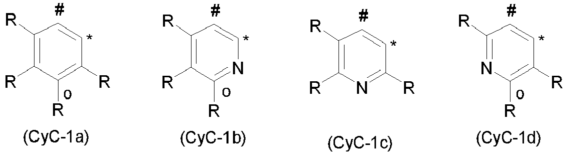 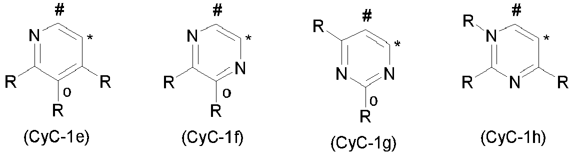 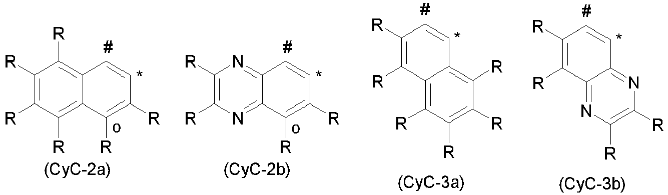 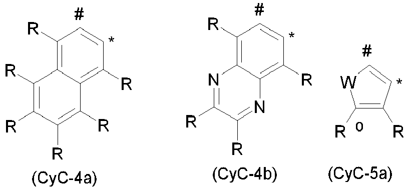 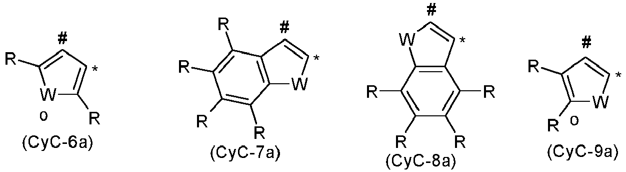 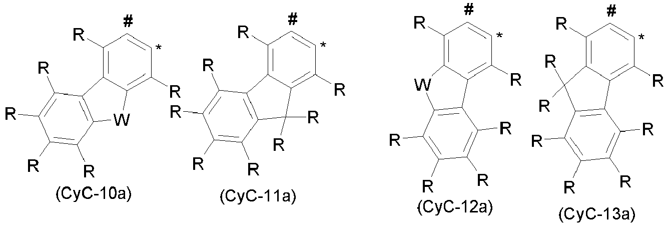 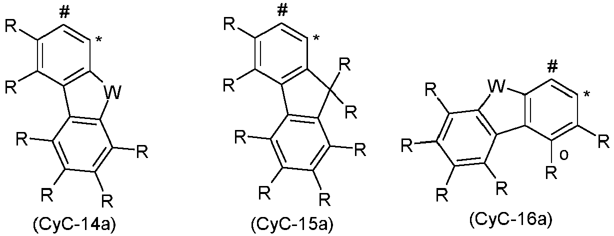 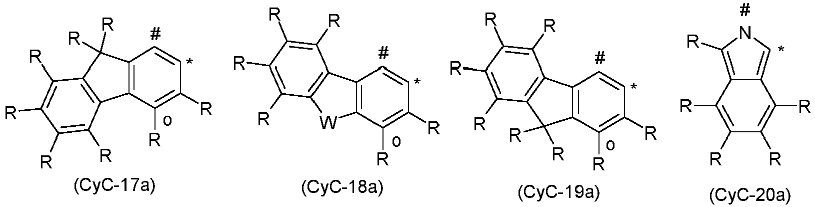 wobei die Symbole die oben genannten Bedeutungen aufweisen und, wenn eine Brücke an CyC gebunden ist, ein Rest R nicht vorhanden ist und die Brücke an das entsprechende Kohlenstoffatom gebunden ist.

Wenn eine Gruppe CyC an eine Brücke gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an eine Brücke gebunden.

Bevorzugte Gruppen unter den Gruppen (CyC-1) bis (CyC-19) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

Ferner kann vorgesehen sein, dass CyC eine Teilstruktur der Formel (2) bzw. die bevorzugten Ausführungsformen dieser Teilstruktur umfasst oder durch geeignete Substitution mit Resten R gebildet wird, wobei in diesem Fall die Gruppen X in Formel (2) für CR¹ stehen. Besonders bevorzugt stellt ein Rest R in den zuvor dargelegten Ausführungsformen der Gruppe CyC eine Teilstruktur der Formel (2) dar, so dass die in Formel (2) durch eine gestrichelte Bindung dargelegte Anbindungsstelle direkt mit dem in der Gruppe CyC dargelegten aromatischen oder heteroaromatischen Ringsystem verbunden ist.

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-14), 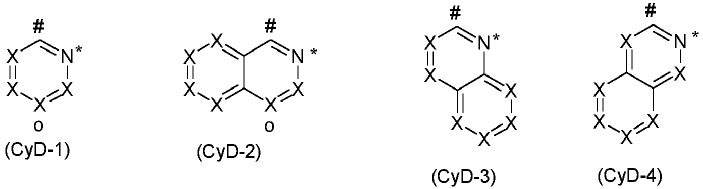 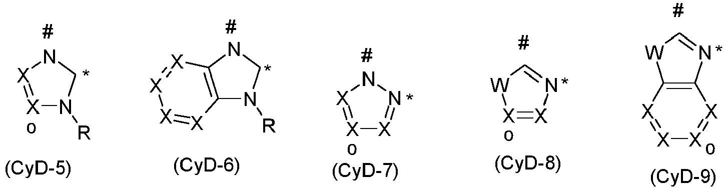 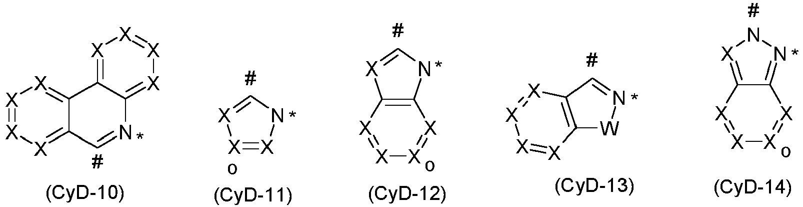 wobei die Gruppe CyD jeweils an der durch # gekennzeichneten Position an CyC bindet und an der durch * gekennzeichneten Position an das Metall koordiniert, wobei X, W und R die oben genannten Bedeutungen aufweisen und wobei die Liganden über die Gruppe CyD durch eine Brücke verbunden sein können, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt. Die oben abgebildeten Strukturen, die kein mit "o" markiertes Symbol X enthalten, sind bevorzugt nicht direkt an eine Brücke gebunden, da eine solche Bindung an die Brücke aus sterischen Gründen nicht vorteilhaft ist.

Dabei koordinieren die Gruppen (CyD-1) bis (CyD-4), (CyD-7) bis (CyD-10), (CyD-13) und (CyD-14) über ein neutrales Stickstoffatom, (CyD-5) und (CyD-6) über ein Carben-Kohlenstoffatom und (CyD-11) und (CyD-12) über ein anionisches Stickstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn CyD an eine Brücke gebunden ist, ein Symbol X für C steht und die Brücke an dieses Kohlenstoffatom gebunden ist.

Besonders bevorzugte Gruppen CyD sind die Gruppen der folgenden Formeln (CyD-1 a) bis (CyD-14b), 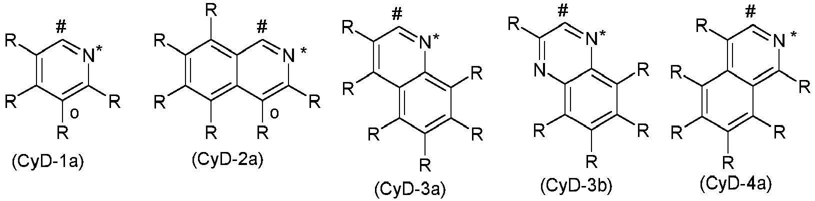 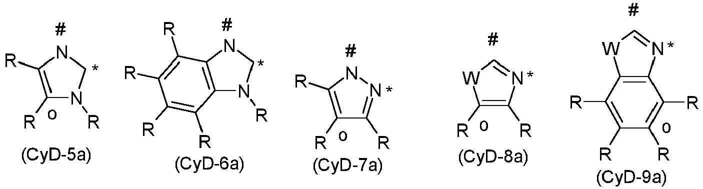 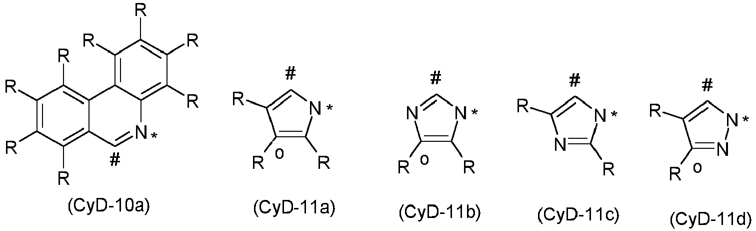 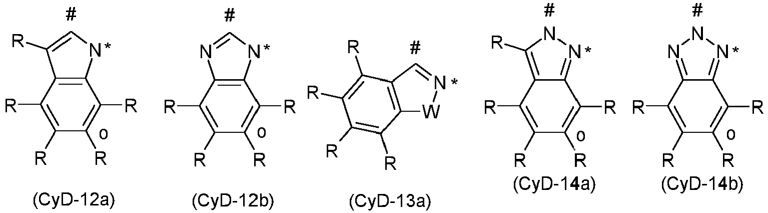 wobei die verwendeten Symbole die oben genannten Bedeutungen aufweisen und, wenn eine Brücke an CyD gebunden ist, ein Rest R nicht vorhanden ist und die Brücke an das entsprechende Kohlenstoffatom gebunden ist. Wenn die Gruppe CyD an eine Brücke gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an eine Brücke gebunden.

Bevorzugte Gruppen unter den Gruppen (CyD-1) bis (CyD-10) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1 a), (CyD-2a), (CyD-3a), (CyD-4a), (CyD-5a) und (CyD-6a), insbesondere (CyD-1 a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen und CyD eine Heteroarylgruppe mit 6 bis 10 aromatischen Ringatomen. Dabei können CyC und CyD mit einem oder mehreren Resten R substituiert sein.

Ferner kann vorgesehen sein, dass CyD eine Teilstruktur der Formel (2) bzw. die bevorzugten Ausführungsformen dieser Teilstruktur umfasst oder durch geeignete Substitution mit Resten R gebildet wird, wobei in diesem Fall die Gruppen X in Formel (2) für CR¹ stehen. Besonders bevorzugt stellt ein Rest R in den zuvor dargelegten Ausführungsformen der Gruppe CyD eine Teilstruktur der Formel (2) dar, so dass die in Formel (2) durch eine gestrichelte Bindung dargelegte Anbindungsstelle direkt mit dem in der Gruppe CyD dargelegten aromatischen oder heteroaromatischen Ringsystem verbunden ist. Speziell bevorzugt ist die Teilstruktur der Formel (2) bzw. die bevorzugten Ausführungsformen dieser Teilstruktur an eine Gruppe CyC gebunden oder wird durch eine entsprechende Substitution gebildet und CyD weist keine Teilstruktur der Formel (2) auf.

Die oben genannten bevorzugten Gruppen (CyC-1) bis (CyC-20) und (CyD-1) bis (CyD-14) können in den Liganden der Formeln (L-1) und (L-2) beliebig miteinander kombiniert werden. Hierbei muss mindestens eine der Gruppen CyC bzw. CyD eine geeignete Anknüpfungsstelle an eine Brücke aufweisen, wobei geeignete Anknüpfungsstellen in den oben genannten Formeln mit "o" gekennzeichnet sind. Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden. Kombinationen, in denen weder CyC noch CyD eine solche geeignete Anknüpfungsstelle für eine Brücke aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1 a), (CyD-2a) und (CyD-3a), kombiniert wird.

Bevorzugte Liganden (L-1) sind die Strukturen der folgenden Formeln (L-1-1) und (L-1-2), und bevorzugte Liganden (L-2) sind die Strukturen der folgenden Formeln (L-2-1) bis (L-2-4), 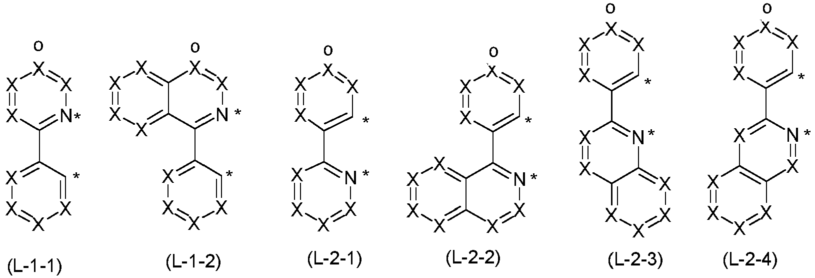 wobei die verwendeten Symbole die oben genannten Bedeutungen aufweisen und die Liganden durch eine Brücke verbunden sind , wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt.

Besonders bevorzugte Liganden (L-1) sind die Strukturen der folgenden Formeln (L-1-1a) und (L-1-2b), und besonders bevorzugte Liganden (L-2) sind die Strukturen der folgenden Formeln (L-2-1 a) bis (L-2-4a), 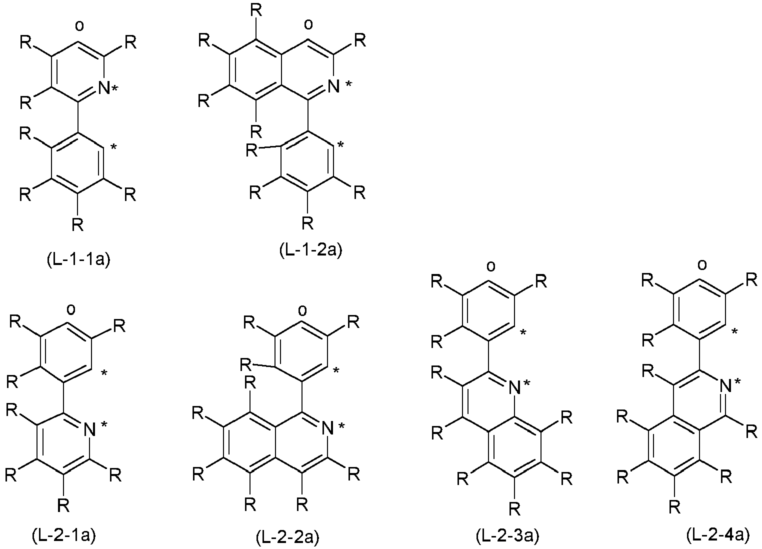 wobei die verwendeten Symbole die oben genannten Bedeutungen aufweisen und die Liganden durch eine Brücke verbunden sind, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt.

Ebenso können die oben genannten bevorzugten Gruppen CyD in den Liganden der Formel (L-3) beliebig miteinander kombiniert werden, wobei es bevorzugt ist, eine neutrale Gruppe CyD, also eine Gruppe (CyD-1) bis (CyD-10), (CyD-13) oder (CyD-14), mit einer anionischen Gruppe CyD, also einer Gruppe (CyD-11) oder CyD-12), zu kombinieren, wobei die Liganden durch eine Brücke verbunden sind, wobei die Bindung an die Brücke bevorzugt über die mit "o" markierte Position erfolgen kann, wobei geeignete Anknüpfungsstellen in den oben genannten Formeln mit "o" gekennzeichnet sind.

Wenn zwei Reste R, von denen einer an CyC und der andere an CyD in den Formeln (L-1) und (L-2) gebunden sind bzw. von denen einer an die eine Gruppe CyD und der andere an die andere Gruppe CyD in Formel (L-3) gebunden sind, miteinander ein aromatisches Ringsystem bilden, können sich überbrückte Liganden und beispielsweise auch Liganden ergeben, die insgesamt eine einzige größere Heteroarylgruppe darstellen, wie beispielsweise Benzo[h]chinolin, etc.. Die Ringbildung zwischen den Substituenten an CyC und CyD in den Formeln (L-1) und (L-2) bzw. zwischen den Substituenten an den beiden Gruppen CyD in Formel (L-3) erfolgt dabei bevorzugt durch eine Gruppe gemäß einer der folgenden Formeln (RB-1) bis (RB-10), 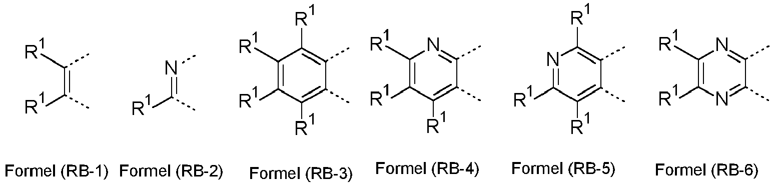 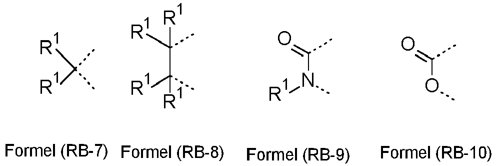 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Möglichkeiten eingebaut werden, beispielsweise kann bei der Gruppe der Formel (RB-10) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (RB-7) besonders dann bevorzugt, wenn sich dadurch die Ringbildung zu einem Sechsring ergibt, wie beispielsweise unten durch die Formeln (L-23) und (L-24) dargestellt.

Bevorzugte Liganden, die durch Ringbildung zweier Reste R an den unterschiedlichen Cyclen entstehen, sind die im Folgenden aufgeführten Strukturen der Formeln (L-5) bis (L-32), 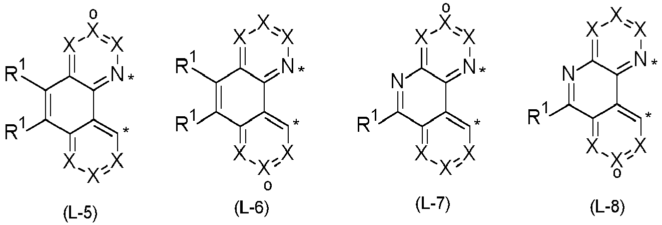 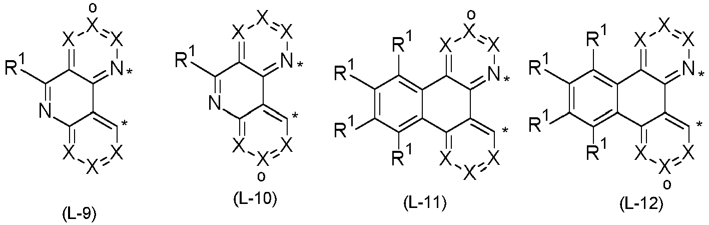 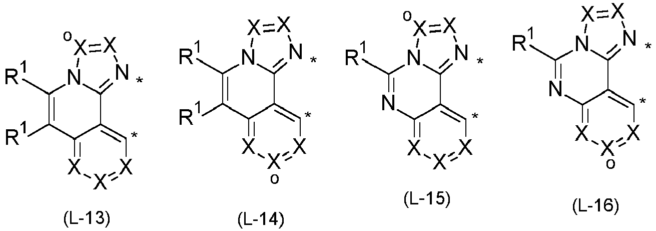 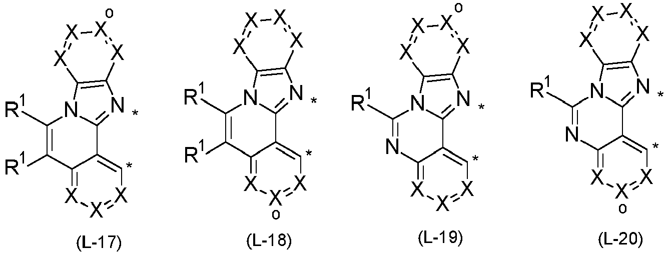 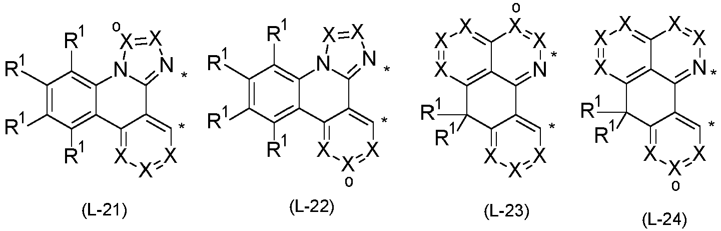 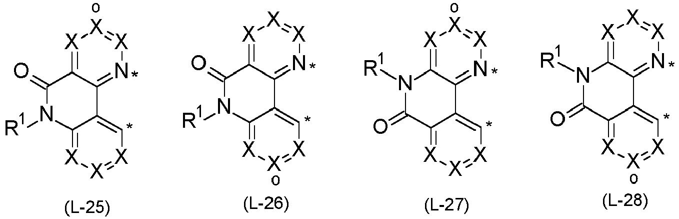 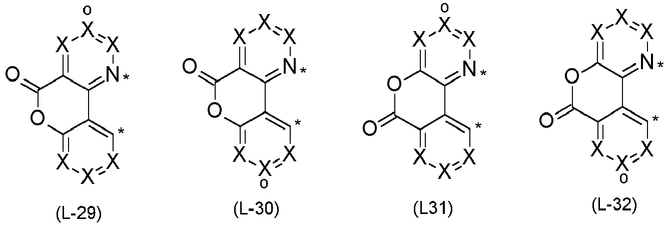 wobei die verwendeten Symbole die oben genannten Bedeutungen aufweisen, wobei die Liganden durch eine Brücke verbunden sind, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt.

In einer bevorzugten Ausführungsform der Liganden der Formeln (L-5) bis (L-32) steht insgesamt ein Symbol X für N und die anderen Symbole X stehen für CR, oder alle Symbole X stehen für CR mit der Maßgabe, dass ein Symbol X für C steht und die Brücke an dieses Kohlenstoffatom gebunden ist.

In einer weiteren Ausführungsform der Erfindung ist es bevorzugt, falls in den Gruppen (CyC-1) bis (CyC-20) oder (CyD-1) bis (CyD-14) oder in den Liganden (L-5) bis (L-3) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1 a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Ligand ist der Ligand der folgenden Formel (L-33) oder (L-34), 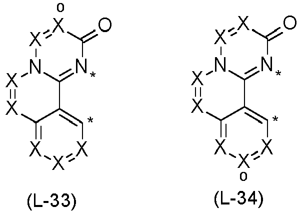 wobei R die oben genannten Bedeutungen aufweist, * die Position der Koordination an das Metall darstellt, wobei die Liganden durch eine Brücke verbunden sind, wobei die Bindung an die Brücke bevorzugt über die mit "o" markierte Position erfolgen kann, und für die weiteren verwendeten Symbole gilt,
- X: ist bei jedem Auftreten gleich oder verschieden CR oder N mit der Maßgabe, dass maximal ein Symbol X pro Cyclus für N steht, wobei X C ist, falls an dieser Position der Ligand mit einer Brücke verbunden ist.

Wenn zwei Reste R, die in den Liganden (L-33) bzw. (L-34) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der folgenden Formel (BR-11), 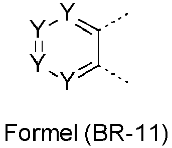 wobei die gestrichelten Bindungen die Verknüpfung dieser Gruppe im Liganden symbolisieren und Y gleich oder verschieden bei jedem Auftreten für CR¹ oder N steht und bevorzugt maximal ein Symbol Y für N steht.

In einer bevorzugten Ausführungsform des Liganden (L-33) bzw. (L-34) ist maximal eine Gruppe der Formel (50) vorhanden. Es handelt sich also bevorzugt um Liganden der folgenden Formeln (L-35) bis (L-40), 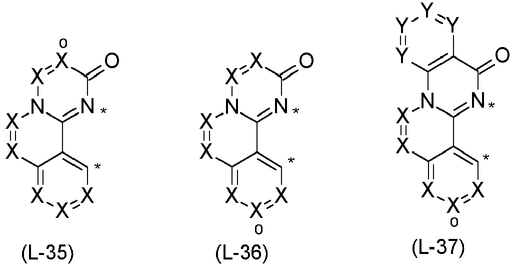 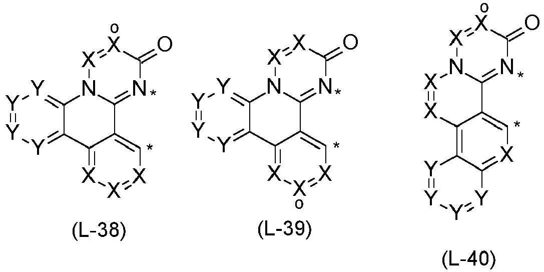 wobei X bei jedem Auftreten gleich oder verschieden für CR oder N steht, jedoch die Reste R nicht miteinander ein aromatisches oder heteroaromatisches Ringsystem bilden und die weiteren Symbole die oben genannten Bedeutungen aufweisen, wobei die Liganden durch eine Brücke verbunden sind, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt.

In einer bevorzugten Ausführungsform der Erfindung stehen im Liganden der Formel (L-33) bis (L-40) insgesamt 0, 1 oder 2 der Symbole X und, falls vorhanden, Y für N. Besonders bevorzugt stehen insgesamt 0 oder 1 der Symbole X und, falls vorhanden, Y für N.

In einer bevorzugten Ausführungsform der Erfindung steht die Gruppe X, die in ortho-Position zur Koordination an das Metall vorliegt, für CR. Dabei ist in dieser Rest R, der in ortho-Position zur Koordination an das Metall gebunden ist, bevorzugt ausgewählt aus der Gruppe bestehend aus H, D, F und Methyl.

In einer weiteren Ausführungsform der Erfindung ist es bevorzugt, falls eines der Atome X oder, wenn vorhanden, Y für N steht, wenn benachbart zu diesem Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Weitere bevorzugte bidentate Liganden sind die Strukturen der folgenden Formel (L-46), 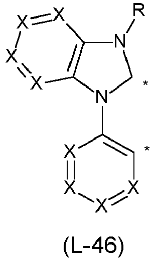 wobei X und R die oben genannten Bedeutungen aufweisen und * die Position der Koordination an das Metall darstellt, wobei die Liganden durch eine Brücke verbunden sind. Hierbei steht die an N gebundene Gruppe R vorzugsweise nicht für H, sondern für eine Alkyl-, Heteroalkyl-, Aryl- oder Heteroarylgruppe, wie diese zuvor für R dargelegt wurde. Vorzugsweise stehen höchstens zwei X pro Ring für N, besonders bevorzugt stehen alle X für CR, wobei die Liganden über einen Rest R verbrückt sein können.

Bevorzugte Liganden der Formel (L-46) sind daher die Liganden der folgenden Formeln (L-46a), 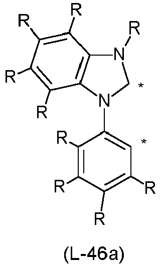 wobei die verwendeten Symbole die oben genannten Bedeutungen aufweisen.

Im Folgenden werden bevorzugte Iridiumkomplexe beschrieben. Wie oben beschrieben, handelt es sich dabei um organometallische Komplexe. Ein organometallischer Komplex im Sinne der vorliegenden Erfindung ist Komplex, welcher mindestens eine Metall-Kohlenstoffbindung zum Liganden aufweist.

In einer bevorzugten Ausführungsform der Erfindung ist der Iridiumkomplex nicht geladen, d. h. elektrisch neutral. Dabei enthält der Iridiumkomplex bevorzugt einen tripodalen, hexadentaten, trianionischen Liganden.

Die Bindung des Liganden an das Iridium kann sowohl eine Koordinationsbindung als auch eine kovalente Bindung sein bzw. der kovalente Anteil an der Bindung kann je nach Ligand variieren. Wenn in der vorliegenden Anmeldung die Rede davon ist, dass der Ligand bzw. der Ligand an das Iridium koordiniert oder bindet, so bezeichnet dies im Sinne der vorliegenden Anmeldung jede Art der Bindung des Liganden an das Iridium, unabhängig vom kovalenten Anteil der Bindung.

In einer bevorzugten Ausführungsform der Erfindung ist das Metall Ir(III) ist und der Metallkomplex weist drei bidentate Liganden auf, wobei zwei der bidentaten Liganden an das Iridium über jeweils ein Kohlenstoffatom und ein Stickstoffatom oder über zwei Kohlenstoffatome koordinieren und der dritte der bidentaten Liganden an das Iridium über ein Kohlenstoffatom und ein Stickstoffatom oder über zwei Kohlenstoffatome koordiniert.

Besonders bevorzugt handelt es sich um einen Iridiumkomplex mit einem tripodalen, hexadentaten Liganden, wie er nachfolgend beschrieben wird. Dabei enthält der tripodale, hexadentate Ligand drei bidentate Teilliganden, die gleich oder verschieden sein können und die an ein Iridiumatom koordinieren, wobei die drei bidentaten Teilliganden über eine Brücke der folgenden Formel (3) oder Formel (4) verknüpft sind 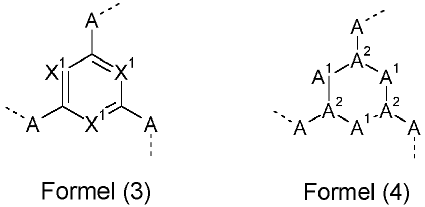 wobei die gestrichelte Bindung die Bindung der bidentaten Liganden an diese Struktur darstellt, R, R¹ und R² die oben genannten Bedeutungen aufweisen und weiterhin gilt:
- X¹: ist bei jedem Auftreten gleich oder verschieden CR oder N;
- A¹: ist bei jedem Auftreten gleich oder verschieden C(R)₂ oder O;
- A²: ist bei jedem Auftreten gleich oder verschieden CR, P(=O), B oder SiR, mit der Maßgabe, dass für A² = P(=O), B oder SiR das Symbol A¹ für O steht und das Symbol A, das an dieses A² gebunden ist, nicht für -C(=O)-NR'- oder -C(=O)-O- steht;
- A: ist bei jedem Auftreten gleich oder verschieden -CR=CR-, -C(=O)-NR'-, -C(=O)-O- oder eine Gruppe der folgenden Formel (5), 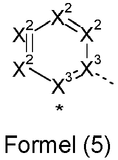 wobei die gestrichelte Bindung die Position der Bindung der bidentaten Liganden an diese Struktur darstellt und * die Position der Verknüpfung der Einheit der Formel (5) mit der zentralen cyclischen Gruppe darstellt;
- X²: ist bei jedem Auftreten gleich oder verschieden CR oder N oder zwei benachbarte Gruppen X² stehen zusammen für NR, O oder S, so dass ein Fünfring entsteht, und die verbleibenden X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² für N stehen;
- X³: ist bei jedem Auftreten C, oder eine Gruppe X³ steht für N und die andere Gruppe X³ in demselben Cyclus steht für C; mit der Maßgabe, dass zwei benachbarte Gruppen X² zusammen für CR oder N stehen, wenn in dem Cyclus eine der Gruppen X³ für N steht;
- R': ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
dabei können die drei bidentaten Teilliganden außer durch die Brücke der Formel (3) oder (4) auch noch durch eine weitere Brücke zu einem Kryptat geschlossen sein.

Wenn zwei Reste R bzw. R¹ bzw. R² miteinander ein Ringsystem bilden, so kann dieses mono- oder polycyclisch, aliphatisch, heteroaliphatisch, aromatisch oder heteroaromatisch sein. Dabei können die Reste, die miteinander ein Ringsystem bilden, benachbart sein, d.h. dass diese Reste an dasselbe Kohlenstoffatom oder an Kohlenstoffatome, die direkt aneinander gebunden sind, gebunden sind, oder sie können weiter voneinander entfernt sein.

Die Struktur der hexadentaten, tripodalen Liganden kann schematisch durch die folgende Formel (Lig) dargestellt werden: 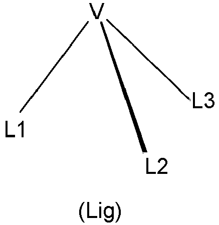 wobei V die Brücke gemäß Formel (3) oder (4) darstellt und L1, L2 und L3 gleich oder verschieden bei jedem Auftreten jeweils bidentate Teilliganden darstellen, bevorzugt monoanionische bidentate Teilliganden. Dabei bedeutet bidentat, dass der jeweilige Ligand im Komplex M über zwei Koordinationsstellen an das Iridium koordiniert bzw. bindet. Tripodal bedeutet, dass der Ligand drei Teilliganden aufweist, die an die Brücke V bzw. die Brücke der Formel (3) oder (4) gebunden sind. Da der Ligand drei bidentate Teilliganden aufweist, ergibt sich insgesamt ein hexadentater Ligand, also ein Ligand, der über sechs Koordinationsstellen an das Iridium koordiniert bzw. bindet. Der Begriff "bidentater Teilligand" bedeutet im Sinne dieser Anmeldung, dass es sich bei dieser Einheit um einen bidentaten Liganden handeln würde, wenn die Brücke der Formel (3) bzw. (4) nicht vorhanden wären. Durch die formale Abstraktion eines Wasserstoffatoms an diesem bidentaten Liganden und die Anknüpfung an die Brücke der Formel (3) bzw. (4) ist dieser jedoch kein separater Ligand, sondern ein Teil des so entstehenden hexadentaten Liganden, so dass hierfür der Begriff "Teilligand" verwendet wird.

Der mit diesem Liganden der Formel (Lig) gebildete Iridiumkomplex kann somit schematisch durch die folgende Formel dargestellt werden: 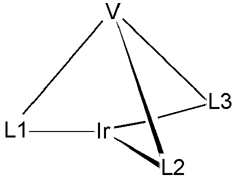 wobei V die Brücke gemäß Formel (3) oder (4) darstellt und L1, L2 und L3 gleich oder verschieden bei jedem Auftreten jeweils bidentate Teilliganden darstellen.

Im Folgenden werden bevorzugte Ausführungsformen der Brücke der Formel (3) bzw. (4) ausgeführt. Geeignete Ausführungsformen der Gruppe der Formel (3) sind die Strukturen der folgenden Formeln (6) bis (9), und geeignete Ausführungsformen der Gruppe der Formel (4) sind die Strukturen der folgenden Formeln (10) bis (14), 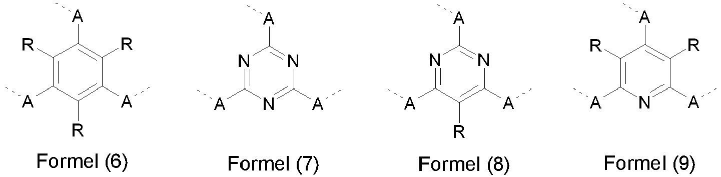 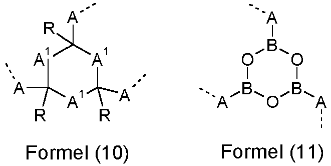 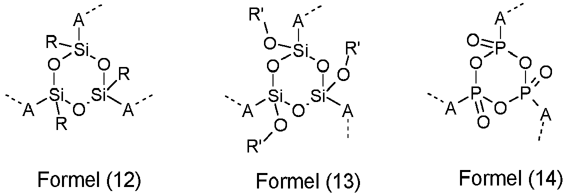 wobei die Symbole die oben genannten Bedeutungen aufweisen.

Für bevorzugte Reste R am trivalenten zentralen Benzolring der Formel (6), am Pyrimidinring der Formel (8), am Pyridinring der Formel (9) sowie am zentralen (hetero)aliphatischen Ring der Formeln (10) bis (14) gilt:
- R: ist bei jedem Auftreten gleich oder verschieden H, D, F, CN, eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, oder ein aromatisches oder heteroaromatisches Ringsystem mit 5 bis 24 aromatischen Ringatomen, das jeweils durch einen oder mehrere Reste R¹ substituiert sein kann;
- R¹: ist bei jedem Auftreten gleich oder verschieden H, D, F, CN, eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können.

Für besonders bevorzugte Reste R am trivalenten zentralen Benzolring der Formel (6), am Pyrimidinring der Formel (8), am Pyridinring der Formel (9) sowie am zentralen (hetero)aliphatischen Ring der Formeln (10) bis (14) gilt:
- R: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R¹ substituiert sein kann, oder ein aromatisches oder heteroaromatisches Ringsystem mit 6 bis 12 aromatischen Ringatomen, das jeweils durch einen oder mehrere Reste R¹ substituiert sein kann;
- R¹: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R² substituiert sein kann, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.

In einer bevorzugten Ausführungsform der Erfindung stehen alle Gruppen X¹ in der Gruppe der Formel (3) für CR, so dass der zentrale trivalente Cyclus der Formel (3) ein Benzol darstellt. Besonders bevorzugt stehen alle Gruppen X¹ für CH. In einer weiteren bevorzugten Ausführungsform der Erfindung stehen alle Gruppen X¹ für ein Stickstoffatom, so dass der zentrale trivalente Cyclus der Formel (3) ein Triazin darstellt. Bevorzugte Ausführungsformen der Formel (3) sind somit die Strukturen der Formeln (6) und (7). Besonders bevorzugt ist die Struktur der Formel (6) eine Struktur der folgenden Formel (6'), 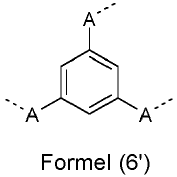 wobei die Symbole die oben genannten Bedeutungen aufweisen.

In einer weiteren bevorzugten Ausführungsform der Erfindung stehen alle Gruppen A² in der Gruppe der Formel (4) für CR. Besonders bevorzugt stehen alle Gruppen A² für CH. Bevorzugte Ausführungsformen der Formel (4) sind somit die Strukturen der Formel (10). Besonders bevorzugt ist die Struktur der Formel (10) eine Struktur der folgenden Formel (10') oder (10"), 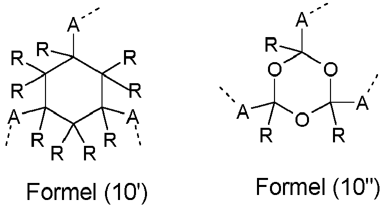 wobei die Symbole die oben genannten Bedeutungen aufweisen und R bevorzugt für H steht.

Im Folgenden werden bevorzugte Ausführungsformen der Gruppe der Formel (5) beschrieben. Die Gruppe der Formel (5) kann einen heteroaromatischen Fünfring oder einen aromatischen oder heteroaromatischen Sechsring darstellen. In einer bevorzugten Ausführungsform der Erfindung enthält die Gruppe der Formel (5) maximal zwei Heteroatome in der aromatischen bzw. heteroaromatischen Einheit, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc..

Wenn beide Gruppen X³ in Formel (5) für Kohlenstoffatome stehen, sind bevorzugte Ausführungsformen der Gruppe der Formel (5) die Strukturen der folgenden Formeln (15) bis (31), und wenn eine Gruppe X³ für ein Kohlenstoffatom und die andere Gruppe X³ in demselben Cyclus für ein Stickstoffatom steht, sind bevorzugte Ausführungsformen der Gruppe der Formel (5) die Strukturen der folgenden Formeln (32) bis (39), 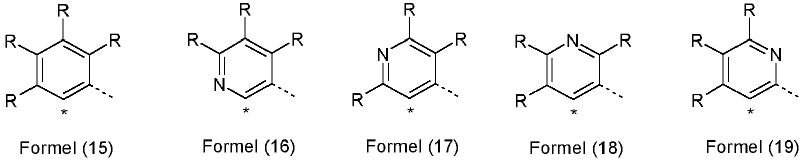 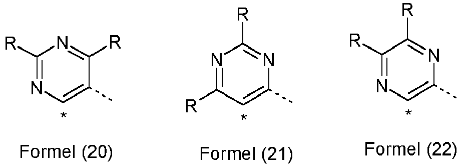 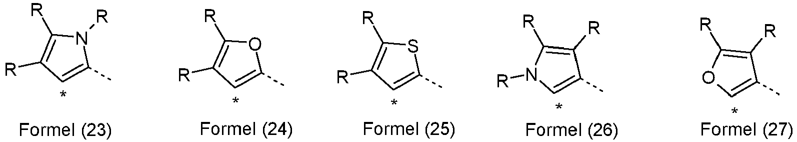 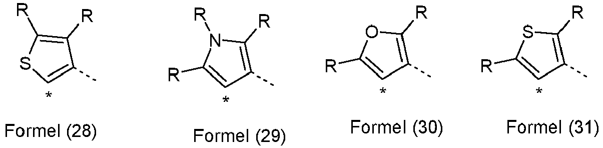 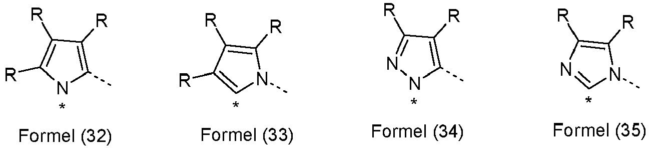 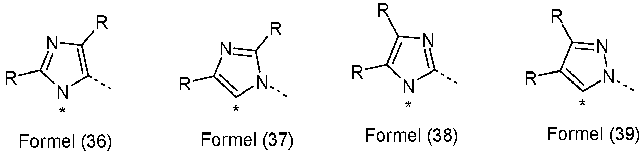 wobei die Symbole die oben genannten Bedeutungen aufweisen.

Besonders bevorzugt sind die Sechsring-Aromaten und -Heteroaromaten der oben abgebildeten Formeln (15) bis (19). Ganz besonders bevorzugt ist ortho-Phenylen, also eine Gruppe der oben genannten Formel (15).

Dabei können auch benachbarte Substituenten R miteinander ein Ringsystem bilden, so dass kondensierte Strukturen, auch kondensierte Aryl- und Heteroarylgruppen, wie beispielsweise Naphthalin, Chinolin, Benzimidazol, Carbazol, Dibenzofuran oder Dibenzothiophen, entstehen können. Eine solche Ringbildung ist im Folgenden schematisch an Gruppen der oben genannten Formel (15) aufgeführt, was zu Gruppen der folgenden Formeln (15a) bis (15j) führt: 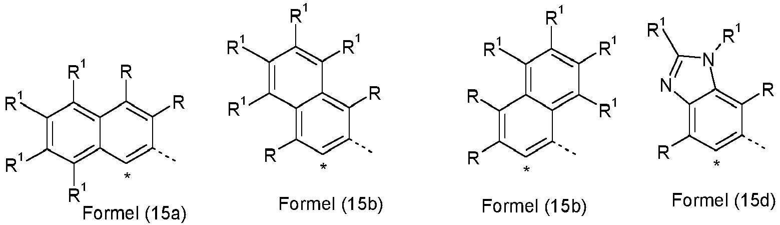 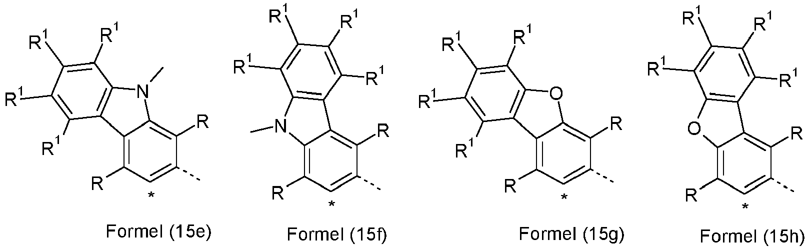 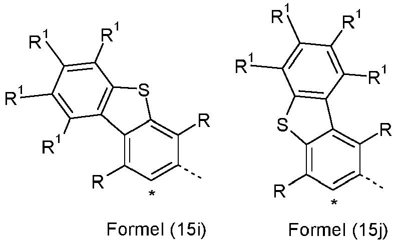 wobei die Symbole die oben genannten Bedeutungen aufweisen.

Generell können die ankondensierten Gruppen an jeder Position der Einheit gemäß Formel (5) ankondensiert sein, wie durch die ankondensierte Benzogruppe in den Formeln (15a) bis (15c) dargestellt. Die Gruppen, wie sie in den Formeln (15d) bis (15j) an die Einheit der Formel (5) ankondensiert sind, können daher auch an anderen Positionen der Einheit der Formel (5) ankondensiert werden.

Die Gruppe der Formel (3) kann besonders bevorzugt durch die folgenden Formeln (3a) bis (3m) dargestellt werden, und die Gruppe der Formel (4) kann besonders bevorzugt durch die folgenden Formeln (4a) bis (4m) dargestellt werden: 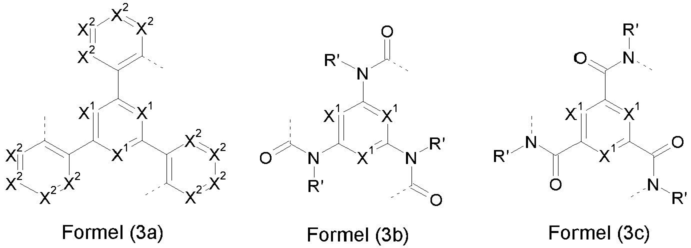 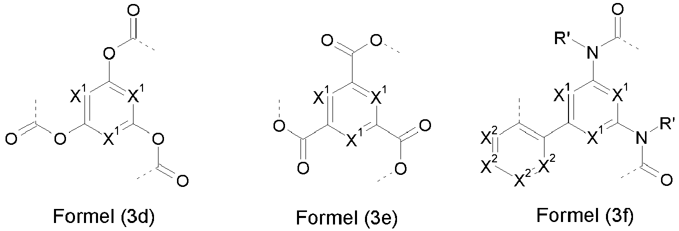 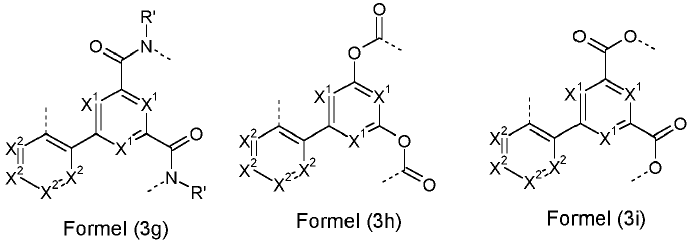 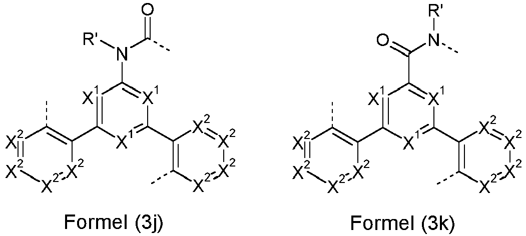 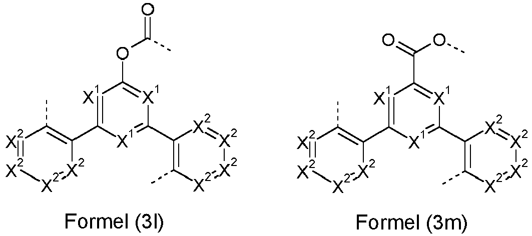 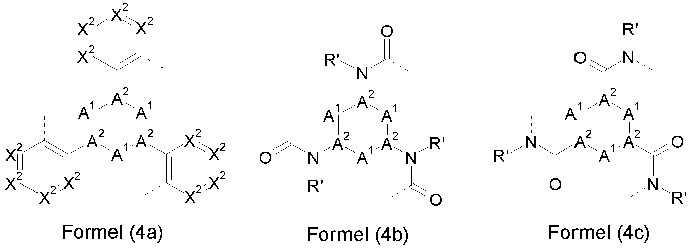 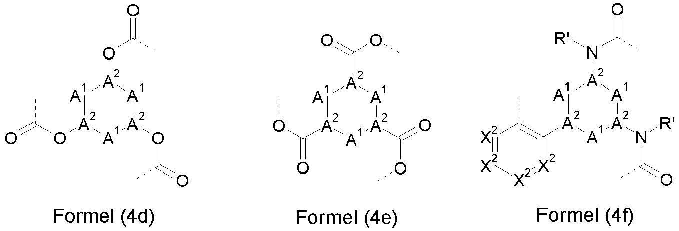 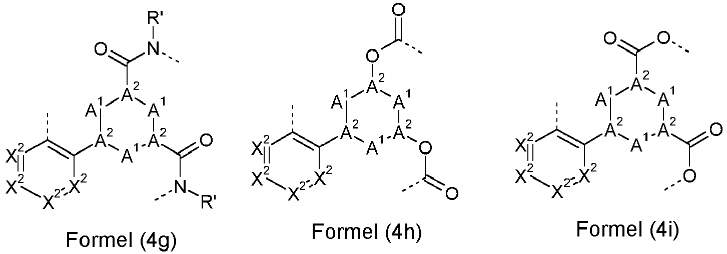 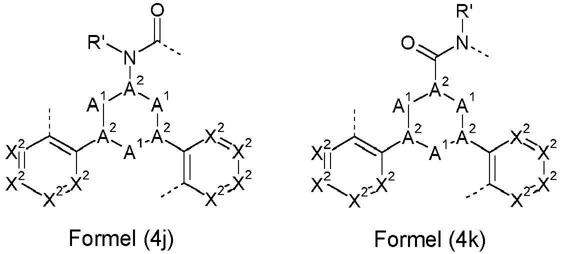 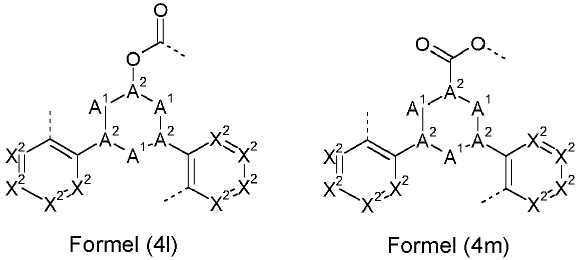 wobei die Symbole die oben genannten Bedeutungen aufweisen. Bevorzugt steht X² gleich oder verschieden bei jedem Auftreten für CR.

In einer bevorzugten Ausführungsform der Erfindung ist die Gruppe der Formeln (3a) bis (3m) ausgewählt aus den Gruppen der Formeln (6a') bis (6m') und die Gruppe der Formel (4a) bis (4m) aus den Gruppen der Formeln (10a') bis (10m'), 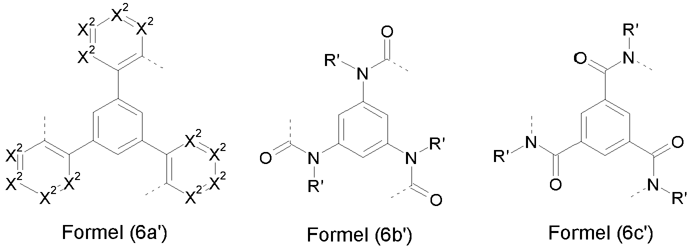 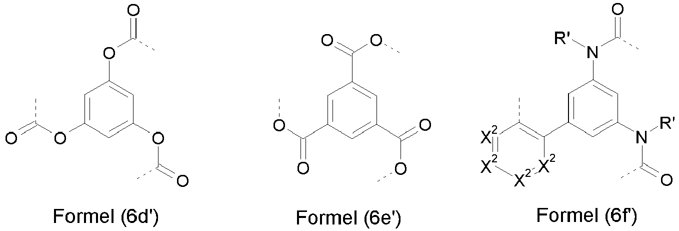 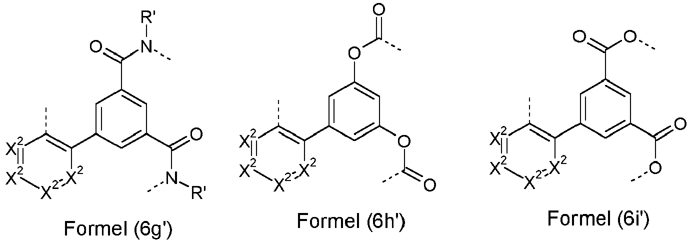 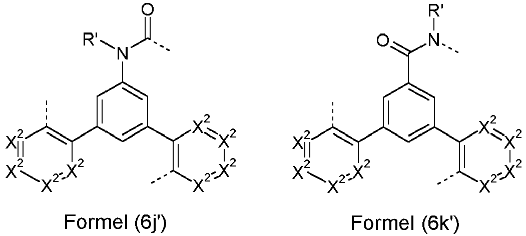 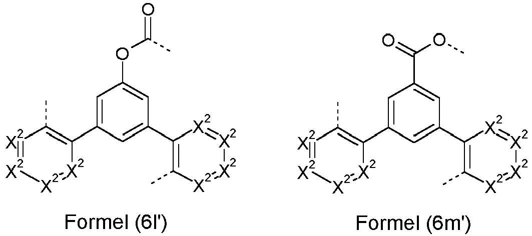 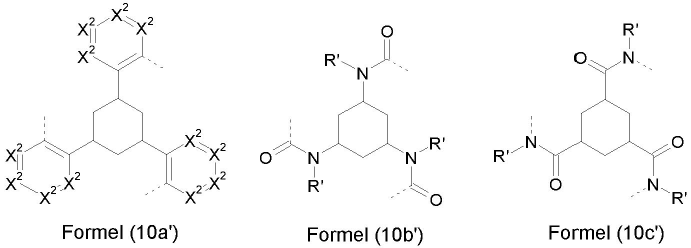 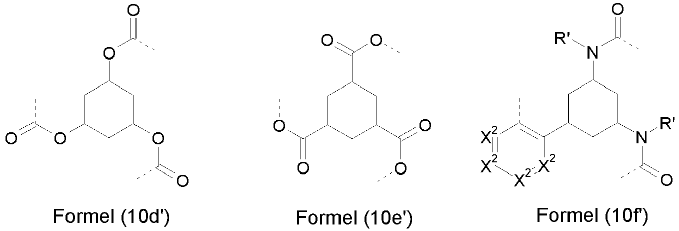 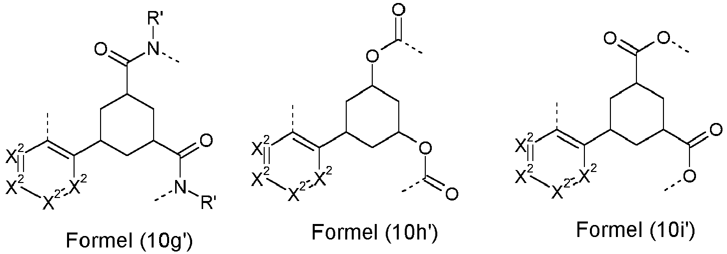 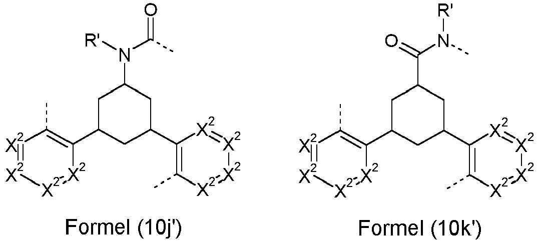 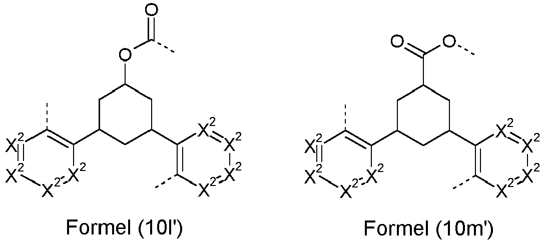 wobei die Symbole die oben genannten Bedeutungen aufweisen. Bevorzugt steht X² gleich oder verschieden bei jedem Auftreten für CR.

Eine besonders bevorzugte Ausführungsform der Gruppe der Formel (3) ist die Gruppe der folgenden Formel (6a"), 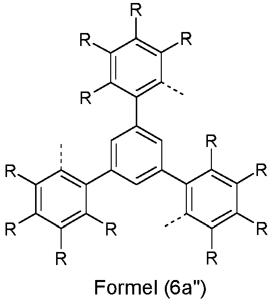 wobei die Symbole die oben genannten Bedeutungen aufweisen.

Besonders bevorzugt sind die Gruppen R in den oben genannten Formeln gleich oder verschieden H, D oder eine Alkylgruppe mit 1 bis 4 C-Atomen. Ganz besonders bevorzugt ist R = H. Ganz besonders bevorzugt ist also die Struktur der folgenden Formeln (6a'"), 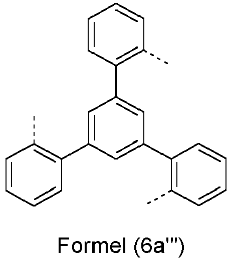 wobei die Symbole die oben genannten Bedeutungen aufweisen.

Im Folgenden werden bevorzugte Substituenten beschrieben, wie sie an den oben beschriebenen Teilliganden und Liganden, aber auch an der bivalenten Arylen- oder Heteroarylengruppe in der Struktur der Formel (5) vorliegen können.

In einer bevorzugten Ausführungsform der Erfindung enthält der erfindungsgemäße Metallkomplex zwei Substituenten R oder zwei Substituenten R¹, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke der Formeln (3) bzw. (4) bzw. den bevorzugten Ausführungsformen vorliegen und/oder an einem oder mehreren der bidentaten Liganden vorliegen. Der aliphatische Ring, der durch die Ringbildung von zwei Substituenten R miteinander oder von zwei Substituenten R¹ miteinander gebildet wird, wird bevorzugt durch eine der folgenden Formeln (40) bis (46) beschrieben, 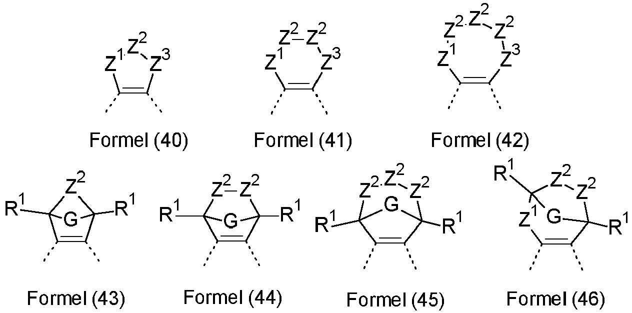 wobei R¹ und R² die oben genannten Bedeutungen aufweisen, die gestrichelten Bindungen die Verknüpfung der beiden Kohlenstoffatome im Liganden andeuten und weiterhin gilt:
- Z¹, Z³: ist gleich oder verschieden bei jedem Auftreten C(R³)₂, O, S, NR³ oder C(=O);
- Z²: ist C(R¹)₂, O, S, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In einer bevorzugten Ausführungsform der Erfindung ist R³ ungleich H.

In den oben abgebildeten Strukturen der Formeln (40) bis (46) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (40) bis (42) dadurch erreicht, dass Z¹ und Z³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (43) bis (46) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (43) bis (46) für H steht, handelt es sich dabei daher um ein nicht-azides Proton im Sinne der vorliegenden Anmeldung.

In einer bevorzugten Ausführungsform der Struktur gemäß Formel (40) bis (46) steht maximal eine der Gruppen Z¹, Z² und Z³ für ein Heteroatom, insbesondere für O oder NR³, und die anderen Gruppen stehen für C(R³)₂ bzw. C(R¹)₂ oder Z¹ und Z³ stehen gleich oder verschieden bei jedem Auftreten für O oder NR³ und Z² steht für C(R¹)₂. In einer besonders bevorzugten Ausführungsform der Erfindung stehen Z¹ und Z³ gleich oder verschieden bei jedem Auftreten für C(R³)₂ und Z² steht für C(R¹)₂ und besonders bevorzugt für C(R³)₂ oder CH₂.

Bevorzugte Ausführungsformen der Formel (40) sind somit die Strukturen der Formel (40-A), (40-B), (40-C) und (40-D), und eine besonders bevorzugte Ausführungsform der Formel (40-A) sind die Strukturen der Formel (40-E) und (40-F), 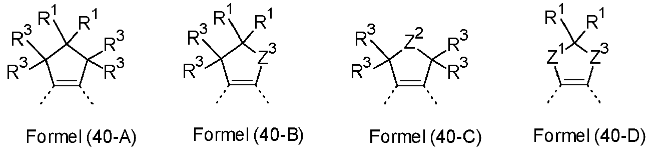 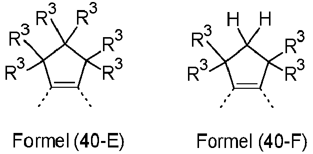 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (41) sind die Strukturen der folgenden Formeln (41-A) bis (41-F), 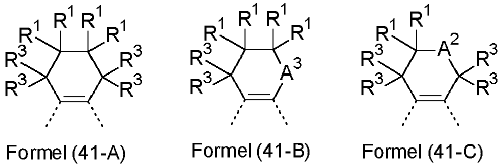 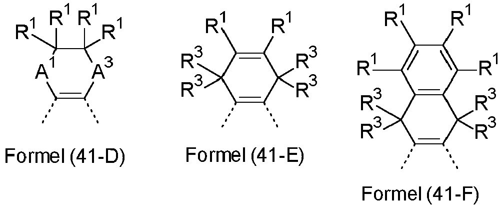 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (42) sind die Strukturen der folgenden Formeln (42-A) bis (42-E), 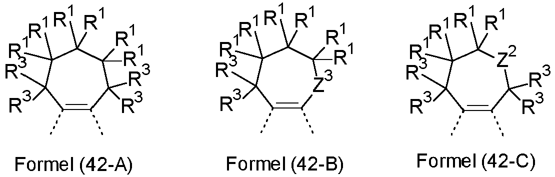 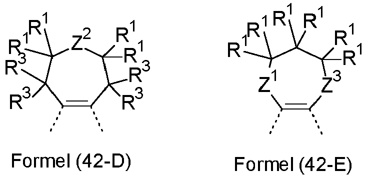 wobei R¹ und R³ die oben genannten Bedeutungen aufweisen und Z¹, Z² und Z³ gleich oder verschieden bei jedem Auftreten für O oder NR³ steht.

In einer bevorzugten Ausführungsform der Struktur gemäß Formel (43) stehen die Reste R¹, die an den Brückenkopf gebunden sind, für H, D, F oder CH₃. Weiterhin bevorzugt steht Z² für C(R¹)₂ oder O, und besonders bevorzugt für C(R³)₂. Bevorzugte Ausführungsformen der Formel (54) sind somit eine Strukturen der Formel (43-A) und (43-B), und eine besonders bevorzugte Ausführungsform der Formel (43-A) ist eine Struktur der Formel (43-C), 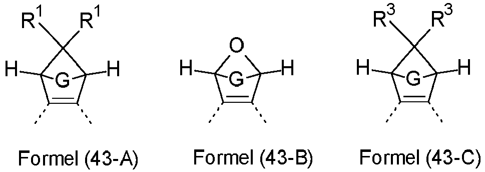 wobei die verwendeten Symbole die oben genannten Bedeutungen aufweisen.

In einer bevorzugten Ausführungsform der Struktur gemäß Formel (44), (45) und (46) stehen die Reste R¹, die an den Brückenkopf gebunden sind, für H, D, F oder CH₃. Weiterhin bevorzugt steht Z² für C(R¹)₂. Bevorzugte Ausführungsformen der Formel (44), (45) und (46) sind somit die Strukturen der Formeln (44-A), (45-A) und (46-A), 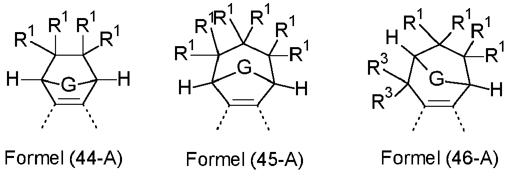 wobei die verwendeten Symbole die oben genannten Bedeutungen aufweisen.

Weiterhin bevorzugt steht die Gruppe G in den Formeln (43), (43-A), (43-B), (43-C), (44), (44-A), (45), (45-A), (46) und (46-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (40) bis (46) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (40) bis (46) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (40) sind die im Folgenden abgebildeten Gruppen:

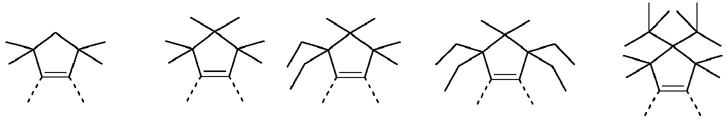

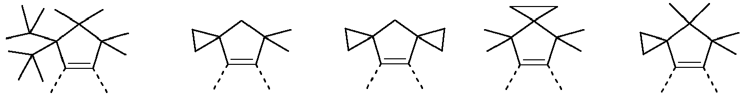

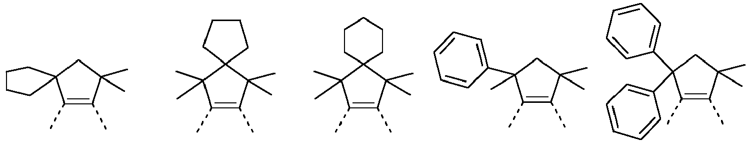

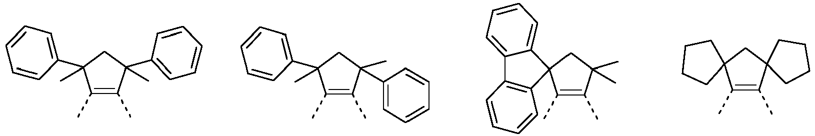

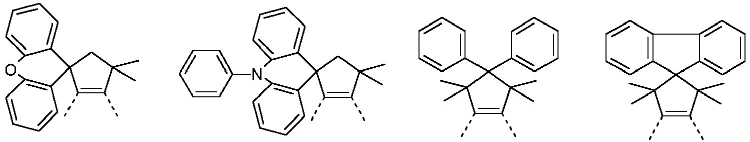

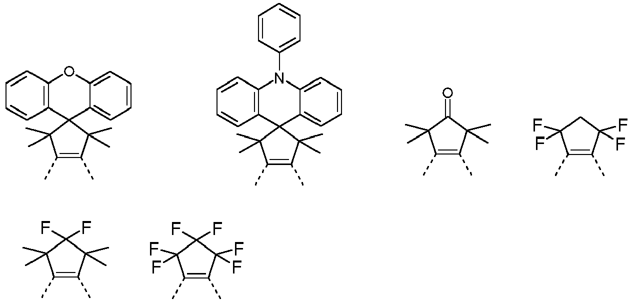

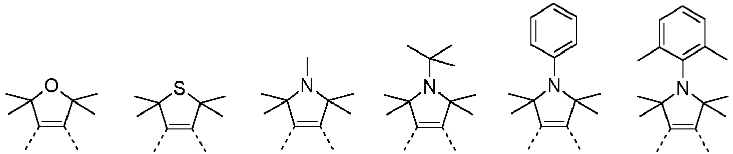

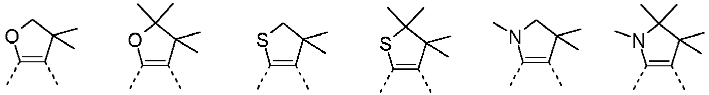

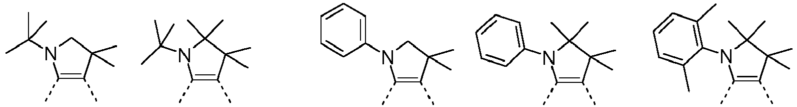

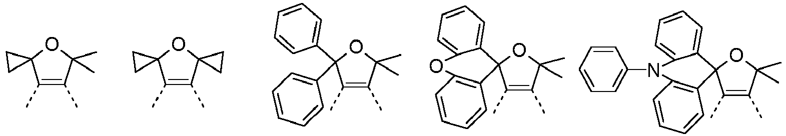

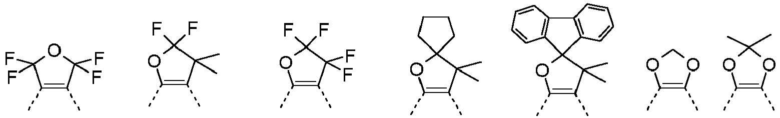

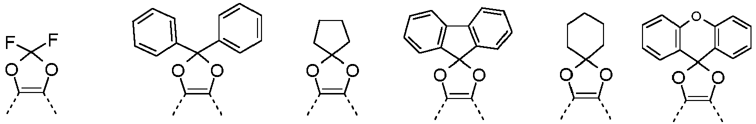

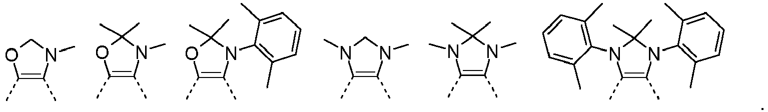

Beispiele für besonders geeignete Gruppen der Formel (41) sind die im Folgenden abgebildeten Gruppen:

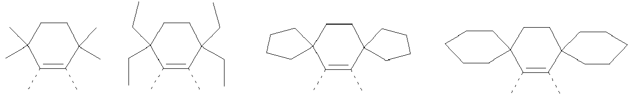

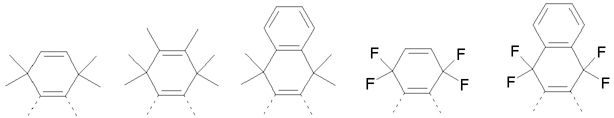

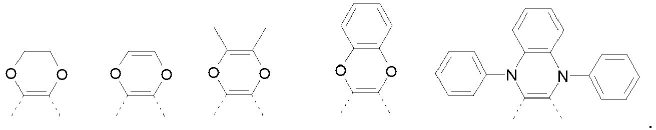

Beispiele für besonders geeignete Gruppen der Formel (42), (45) und (46) sind die im Folgenden abgebildeten Gruppen:

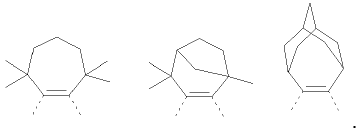

Beispiele für besonders geeignete Gruppen der Formel (43) sind die im Folgenden abgebildeten Gruppen:

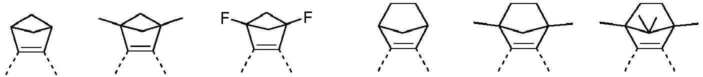

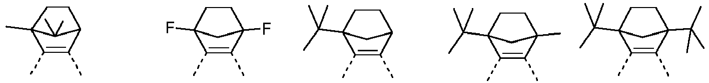

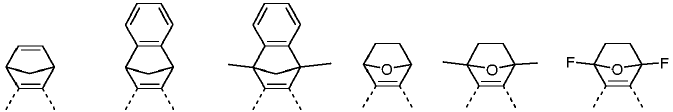

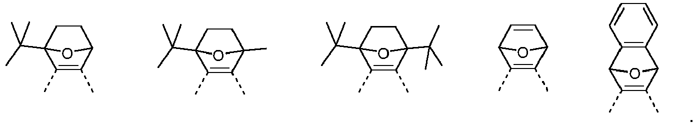

Beispiele für besonders geeignete Gruppen der Formel (44) sind die im Folgenden abgebildeten Gruppen:

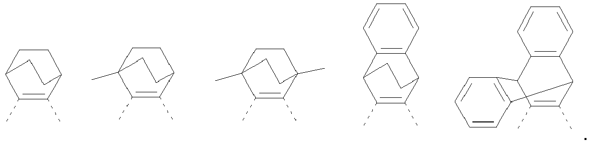

Wenn in den Teilstrukturen der Formeln (2), (2-1), (2-1a) bis (2-1i), (2-2), (2-2a) bis (2-2c), (2-3), (2-4), (2-6) und/oder (2-6) beziehungsweise in den der Aryl- oder Heteroarylresten der Formel (Ar-1) beziehungsweise in den bidentaten Teilliganden bzw. Liganden bzw. in den bivalenten Arylen- bzw. Heteroarylengruppen der Formel (5), welche in den Formeln (3) bzw. (4) bzw. den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono-oder polycyclisches, aliphatisches Ringsystem bilden.

Bevorzugte Ausführungsformen der erfindungsgemäßen Verbindungen können chirale Strukturen darstellen. Je nach genauer Struktur der Komplexe und Liganden, ist die Bildung von Diastereomeren und mehreren Enantiomerenpaaren möglich.

Die erfindungsgemäßen Komplexe können dann sowohl die Mischungen der verschiedenen Diastereomere bzw. die entsprechenden Racemate wie auch die einzelnen isolierten Diastereomere bzw. Enantiomere umfassen.

Werden einkernige chirale Komplex-Synthesebausteine zum Aufbau von mehrkernigen erfindungsgemäßen Komplexe verwendet, werden diese üblicherweise als Racemat der Δ- und Λ-Isomeren eingesetzt. Dies führt in den mehrkernigen erfindungsgemäßen chiralen Verbindungen zu Diastereomerengemischen, z. B. für zweikernige Verbindungen zu Δ,Δ-/Λ,Λ-und (meso)Δ,Λ-Formen. Diese werden, sofern nicht anderes vermerkt, als Diastereomerengemisch weiter um- bzw. eingesetzt. Daneben besteht die Möglichkeit diese durch chomatographische Methoden oder durch fraktionierte Kristallisation zu trennen.

Werden die enatiomenrenreinen Δ- bzw. Λ-Isomeren einkerniger Komplex-Synthesebausteine zum Aufbau von mehrkernigen erfindungsgemäßen Komplexe verwendet, können z. B. für zweikernige Verbindungen Δ,Δ-bzw. Λ,Λ- bzw. (meso)Δ,Λ-Formen gezielt dargestellt werden. Analoges gilt auch für drei- und höhekernige erfindungsgemäßen Komplexe.

Die dazu notwendigen Δ- bzw. Λ-Isomeren einkerniger chiraler Komplex-Synthesebausteine können wie folgt erhalten werden. Werden in der Synthese der einkernigen Komplex-Synthesebausteine C₃- bzw. C₃ᵥ-symmetrische Liganden eingesetzt, fällt üblicherweise ein racemisches Gemisch der C₃-symmetrischen Komplexe, also des Δ- und des Λ-Enantiomers, an. Diese können durch gängige Methoden (Chromatographie an chiralen Materialien / Säulen oder Racemattrennung durch Kristallisation) getrennt werden. Dies ist im folgenden Schema am Beispiel eines C₃-symmetrischen Liganden der zu tripodalen Metallkomplexen führt, der drei Phenylpyridin-Teilliganden trägt, gezeigt und gilt in analoger Form auch für alle anderen C₃- bzw. C₃ᵥ-symmetrischen Liganden zur Synthese von tripodalen Komplexen und in analoger Weise auch für die Komplexe des Typs IrL₃, wobei L einen zweizähnigen Liganden darstellt.

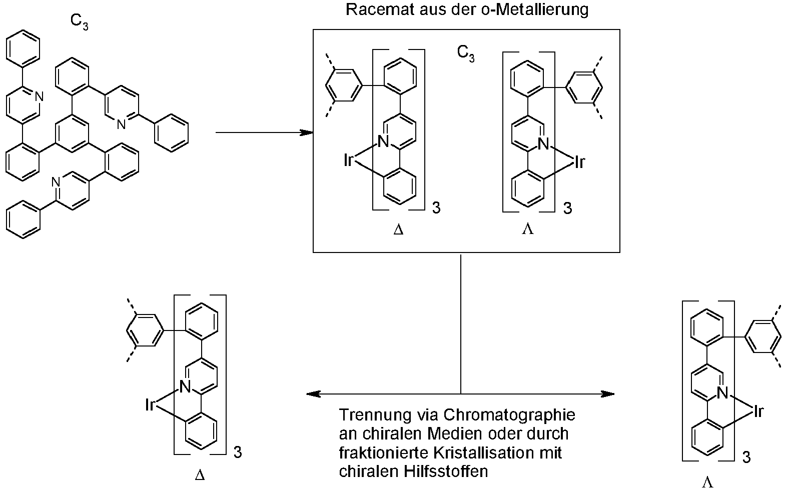

Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie im Folgenden schematisch dargestellt.

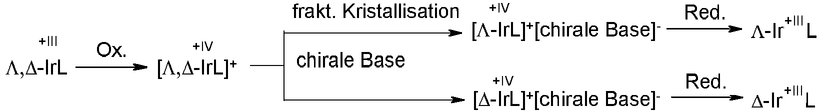

Daneben ist eine enantiomerenreine bzw. enantiomerenanreichernde Synthese durch Komplexierung in einem chiralen Medium (z. B. R- oder S-1,1 -Binaphthol) möglich.

Analoge Verfahren können auch mit Komplexen Cₛ-symmetrischer Liganden durchgeführt werden.

Werden in der Komplexierung C₁-symmetrische Liganden eingesetzt, fällt üblicherweise ein Diastereomerengemisch der Komplexe an, das durch gängige Methoden (Chromatographie, Kristallisation) getrennt werden kann.

Enantiomerenreine C₃-symmetrische Komplexe können auch gezielt synthetisiert werden, wie im folgenden Schema dargestellt. Dazu wird ein enantiomerenreiner, C₃-symmetrischer Ligand dargestellt, komplexiert, das erhaltene Diasteroemerengemisch wird getrennt und anschließend wird die chirale Gruppe abgespalten.

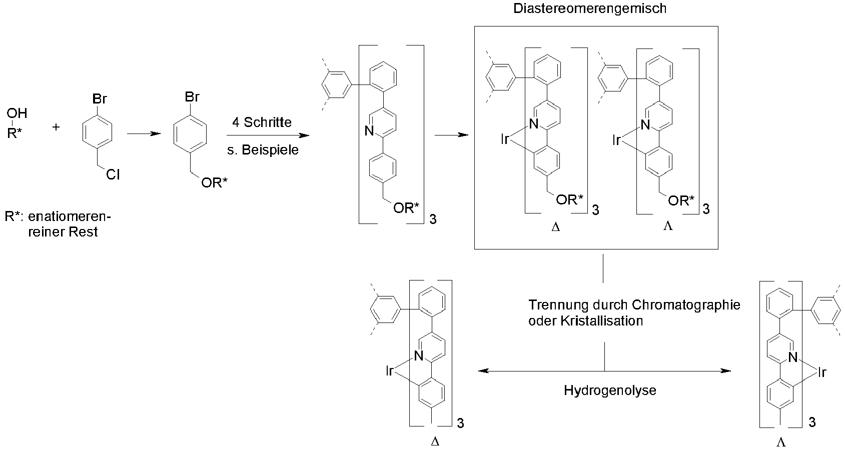

Die so erhaltenen Δ- bzw. Λ-Isomeren einkerniger Komplex-Synthesebausteine können abschließend funktionalisiert, z. B. halogeniert bzw. boryliert, werden und dann via Kupplungsreaktionen, z. B. Suzuki-Kupplung, zu mehrkernigen erfindungsgemäßen Komplexen verknüpft werden.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die Herstellung der erfindungsgemäßen Metallkomplexe kann durch verschiedene Verfahren erfolgen. Bevorzugt kann jedoch vorgesehen sein, einen Metallkomplex als Edukt einzusetzen, der unter Bildung einer Teilstruktur gemäß Formel (2) mit einer aromatischen oder heteroaromatischen Verbindung umgesetzt wird.

Daher ist ein weiterer Gegenstand der vorliegenden Erfindung ein Verfahren zur Herstellung der erfindungsgemäßen Metallkomplexe, bei dem ein Metallkomplex mit einer aromatischen oder heteroaromatischen Verbindung umgesetzt wird. Vorzugsweise kann ein Cyclopentadienon-Derivat mit einem Alkin-Derivat umgesetzt werden, wobei dies in einer Diels-Alder-Reaktion erfolgen kann. Das Diels-Alder-Produkt reagiert anschließend unter Abspaltung von CO zu einem erfindungsgemäßen Komplex. Insbesondere kann vorgesehen sein, dass das in einer Diels-Alder-Reation umzusetzende Alkin-Derivat ein Metallkomplex darstellt.

Die einzusetzenden Komplexe können auf zwei Wegen dargestellt werden. Zum einen kann der Ligand, der beispielsweise eine Alkinfunktion umfasst dargestellt und dann an das Metall bzw. Metallfragmente koordiniert werden. Generell wird hierzu ein Iridium- bzw. Platinsalz mit dem entsprechenden freien Liganden umgesetzt.

Ferner können entsprechende Alkinderivate von Metallkomplexen durch Umsetzung von Metallkomplexen, die entsprechende reaktive Gruppen enthalten, mit aromatischen oder heteroaromatischen Alkinverbindungen erhalten werden. Hierfür geeignete Kupplungsreaktionen, z. B. Suzuki-Kupplung, sind allgemein bekannt, wobei sich die sogenannte Sonogashira-Reaktion hierfür als besonders zweckmäßig erwiesen hat. Die Umsetzungsbedinungen für eine Suzuki-Kupplung oder eine Sonogashira-Reaktion sind in der Fachwelt weithin bekannt, wobei in diesem Zusammenhang die Beispiele wertvolle Hinweise liefern.

Die als Edukt für eine Suzuki-Kupplung oder eine Sonogashira-Reaktion einzusetzenden reaktiven Metallkomplexe können beispielsweise durch bekannte Halogenierungen, vorzugsweise Bromierungen aus bekannten Metallkomplexen erhalten werden.

Iridiumkomplexe, die sich als Edukte eignen, können durch Umsetzung der entsprechenden freien Liganden mit Metallalkoholaten der Formel (47), mit Metallketoketonaten der Formel (48), mit Metallhalogeniden der Formel (49) oder mit Metallcarboxylaten der Formel (50) erhalten werden, 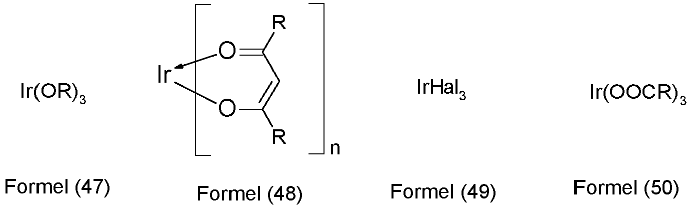 wobei R die oben angegebenen Bedeutungen hat, Hal = F, Cl, Br oder I ist und die Iridiumedukte auch als die entsprechenden Hydrate vorliegen können. Dabei steht R bevorzugt für eine Alkylgruppe mit 1 bis 4 C-Atomen.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-tetramethylheptan-3,5-dionato)iridium, und IrCl₃·xH₂O, wobei x üblicherweise für eine Zahl zwischen 2 und 4 steht.

Die Synthese der erfindungsgemäß einzusetzenden Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, Hydrochinon, etc.. Dabei ist die Verwendung von Hydrochinon besonders bevorzugt.

Erläuterungen zu den Herstellungsverfahren können den Beispielen entnommen werden.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Metallkomplexe können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (44) bis (50) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Die erfindungsgemäßen Verbindungen können auch mit einem Polymer gemischt oder kovalent in ein Polymer eingebaut werden. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. In einer bevorzugten Ausführungsform der vorliegenden Erfindung werden die erfindungsgemäßen Verbindungen, wenn sie in Oligomeren, Dendrimeren oder Polymeren eingesetzt werden, darin als Endgruppe eingesetzt.

Weiterer Gegenstand der Erfindung sind daher Oligomere, Polymere oder Dendrimere enthaltend eine oder mehrere der oben aufgeführten erfindungsgemäßen Verbindungen, wobei ein oder mehrere Bindungen der erfindungsgemäßen Verbindung zum Polymer, Oligomer oder Dendrimer vorhanden sind. Je nach Verknüpfung der erfindungsgemäßen Verbindung bildet diese daher eine Seitenkette des Oligomers oder Polymers oder ist in der Hauptkette verknüpft oder stellt eine Endgruppe dar. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Verbindungen in Oligomeren, Dendrimeren und Polymeren gelten dieselben Bevorzugungen, wie oben beschrieben.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan oder Mischungen dieser Lösemittel.

Ein weiterer Gegenstand der vorliegenden Erfindung ist daher eine Formulierung, enthaltend mindestens einen erfindungsgemäßen Metallkomplex und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Nochmals ein weiterer Gegenstand der vorliegenden Erfindung ist daher eine Zusammensetzung enthaltend eine erfindungsgemäße Verbindung und wenigstens ein weiteres organisch funktionelles Material. Funktionelle Materialen sind generell die organischen oder anorganischen Materialien, welche zwischen Anode und Kathode eingebracht sind. Vorzugsweise ist das organisch funktionelle Material ausgewählt aus der Gruppe bestehend aus fluoreszierenden Emittern, phosphoreszierenden Emittern, Hostmaterialien, Elektronentransportmaterialien, Elektroneninjektionsmaterialien, Lochleitermaterialien, Lochinjektionsmaterialien, Elektronenblockiermaterialien, Lochblockiermaterialien, Wide-Band-Gap-Materialien und n-Dotanden.

Der oben beschriebene erfindungsgemäße Metallkomplex bzw. die oben aufgeführten bevorzugten Ausführungsformen können in der elektronischen Vorrichtung als aktive Komponente oder als Sauerstoff-Sensibilisatoren oder in der Photokatalyse verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator. Hierbei kann der erfindungsgemäße Metallkomplex vorzugsweise als phosphoreszierender Emitter eingesetzt werden. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen (Grätzel-Zellen) verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Weiterhin bevorzugt sind Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Metallkomplex und dem Matrixmaterial enthält zwischen 0.1 und 99 Gew.-%, vorzugsweise zwischen 1 und 90 Gew.-%, besonders bevorzugt zwischen 3 und 40 Gew.-%, insbesondere zwischen 5 und 25 Gew.-% des erfindungsgemäßen Metallkomplexes bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 95 und 75 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazo-lylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe als Co-Matrix für längerwellig emittierende Triplettemitter, beispielsweise für grün oder rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist.

Die erfindungsgemäßen Metallkomplexe lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht, je nach Wahl des Metalls und genauer Struktur des Liganden. Wenn es sich bei dem erfindungsgemäßen Metallkomplex um einen Aluminiumkomplex handelt, so wird dieser bevorzugt in einer Elektronentransportschicht eingesetzt. Ebenso lassen sich die erfindungsgemäßen Metallkomplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyanohexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. In einer bevorzugten Ausführungsform der Erfindung wird die Schicht, die die erfindungsgemäße Verbindung enthält, aus Lösung aufgebracht.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Die erfindungsgemäßen Metallkomplexe zeigen orientierte Emission. Dies ermöglicht höhere Quanteneffizienzen durch verbesserte Lichtauskopplung aus dem Bauteil und somit eine höhere Effizienz der OLED. Dadurch lässt sich auch die Lebensdauer steigern, da die OLED mit geringerem Strom betrieben werden kann.
2. Die erfindungsgemäßen Metallkomplexe lassen sich in sehr hoher Ausbeute und sehr hoher Reinheit bei außergewöhnlich kurzen Reaktionszeiten und vergleichsweise geringen Reaktionstemperaturen synthetisieren.
3. Die erfindungsgemäßen Metallkomplexe weisen eine hervorragende thermische Stabilität auf.
4. Bevorzugte erfindungsgemäße Metallkomplexe, insbesondere verbrückte Metallkomplexe, zeigen weder thermisch noch photochemisch fac/mer- bzw. mer/fac-Isomerisierung, was zu Vorteilen in der Anwendung dieser Komplexe führt.
5. Die erfindungsgemäßen Metallkomplexe weisen teilweise ein sehr schmales Emissionsspektrum auf, was zu einer hohen Farbreinheit der Emission führt, wie sie insbesondere für Displayanwendungen wünschenswert ist.
6. Die erfindungsgemäßen Metallkomplexe weisen eine sehr gute Verarbeitbarkeit aus Lösung und eine ausgezeichnete Löslichkeit in vielen organischen Lösungsmitteln auf.
7. Organische Elektrolumineszenzvorrichtungen enthaltend die erfindungsgemäßen Metallkomplexe als emittierende Materialien weisen eine sehr gute Lebensdauer auf.
8. Organische Elektrolumineszenzvorrichtungen enthaltend die erfindungsgemäßen Metallkomplexe als emittierende Materialien weisen eine hervorragende Effizienz auf.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### Synthesebeispiele

**A: Metallorganische literaturbekannte Synthone:**

| | |
|---|---|
| 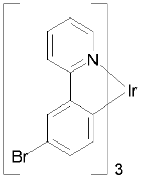 | 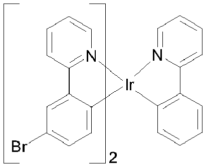 |
| 454454-92-3 | 453538-21-1 |
| MS1 | MS2 |
| 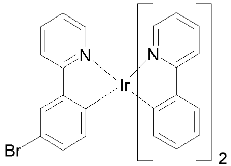 | 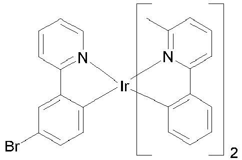 |
| 454454-89-8 | 1149344-63-7 |
| MS3 | MS4 |
| 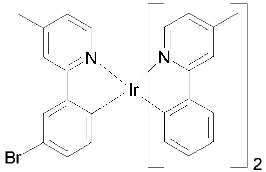 | 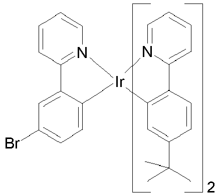 |
| 1149344-49-9 | 1252029-12-1 |
| MS5 | MS6 |
| 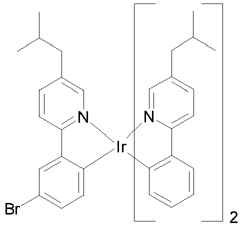 | 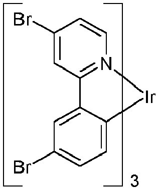 |
| 1149344-55-7 | 1309878-11-1 |
| MS7 | MS8 |
| 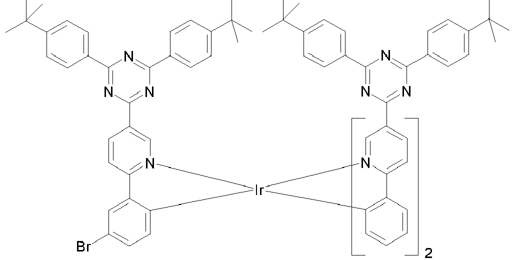 | |
| 1820909-79-2 | |
| MS9 | |
| 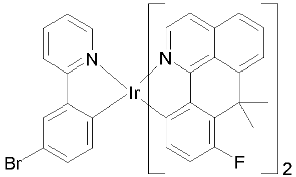 | 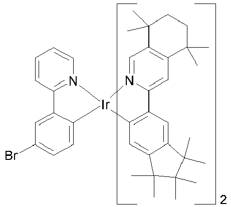 |
| 1423076-38-3 | 1803296-02-7 |
| MS10 | MS11 |
| 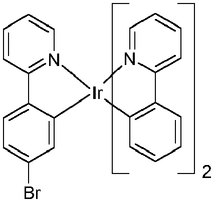 | 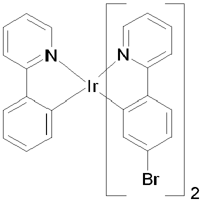 |
| 501330-36-5 | 1627953-70-1 |
| MS12 | MS13 |
| 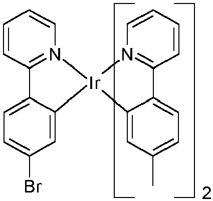 | 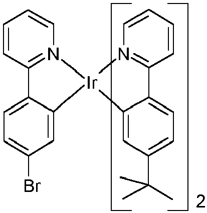 |
| 1455513-03-7 | 1252029-10-9 |
| MS14 | MS15 |
| 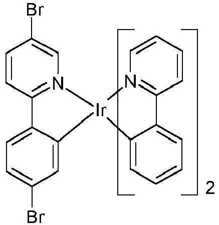 | 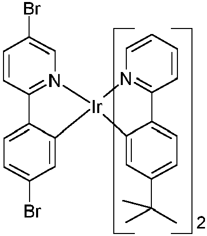 |
| 929088-09-5 | 1252029-11-0 |
| MS16 | MS17 |
| 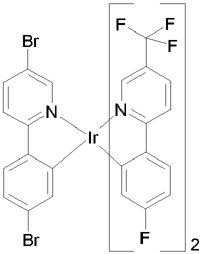 | 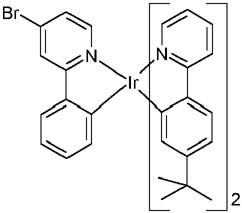 |
| 387859-69-0 | 1651859-59-4 |
| MS18 | MS19 |
| 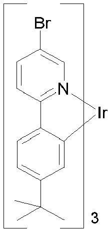 | 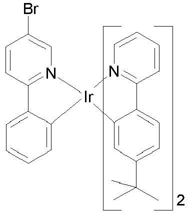 |
| 1651859-63-0 | 1252029-09-6 |
| MS20 | MS21 |
| 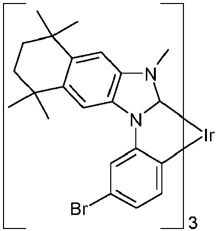 | 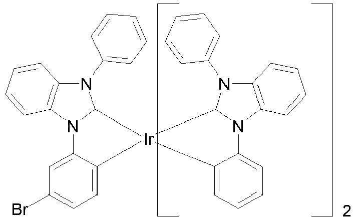 |
| 1803319-99-4 | 1651822-19-3 |
| MS22 | MS23 |
| 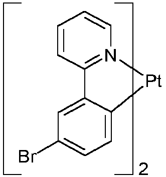 | |
| 690269-08-0 | |
| MS24 | |

### B: Synthese hexadentater Liganden L:

### Beispiel L1:

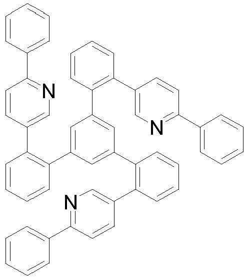

Ein Gemisch aus 54.1 g (100 mmol) 1,3,5-Tris(2-bromphenyl)benzol, [380626-56-2], 98.4 g (350 mmol) 2-Phenyl-5-(4,4,5,5-tetramethyl-[1,3,2]-dioxaborolan-2-yl)-pyridin [879291-27-7], 106.0 g (1 mol) Natriumcarbonat, 5.8 g (5 mmol) Tetrakis(triphenylphosphino)-palladium(0), 750 ml Toluol, 200 ml Ethanol und 500 ml Wasser wird unter sehr gutem Rühren 24 h unter Rückfluss erhitzt. Nach 24 h fügt man 300 ml 5 Gew.-%ige wässrige Acetylcystein-Lösung zu, rührt weitere 16 h unter Rückfluss, lässt erkalten, trennt die wässrige Phase ab und engt die organische Phase zur Tockene ein. Man nimmt den braunen Schaum nach Einengen der organischen Phase aus der Suzuki-Kupplung in 300 ml eines Gemischs aus Dichlormethan:Ethylacetat (8:1, vv) auf und filtriert über ein mit Dichlormethan: Ethylacetat (8:1, vv) vorgeschlämmtes Kieselgelbett (Durchmesser 15 cm, Länge 20 cm), um braune Anteile zu entfernen. Nach Einengen wird der verbliebene Schaum aus 800 ml Ethylacetat unter Zusatz von 400 ml Methanol in der Siedehitze und dann ein zweites Mal aus 1000 ml reinem Ethylacetat umkristallisiert und anschließend im Hochvakuum (p ca. 10⁻⁵ mbar, T 280 °C) Kugelrohr-sublimiert. Ausbeute: 50.6 g (66 mmol), 66 %. Reinheit: ca. 99.7 %ig n. ¹H-NMR.

### Beispiel L2:

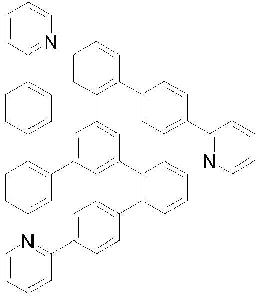

Analog kann Ligand L2 dargestellt werden. Anstelle von 2-Phenyl-5-(4,4,5,5-tetramethyl-[1,3,2]-dioxaborolan-2-yl)-pyridin [879291-27-7] wird 2-[4-(4,4,5,5-Tetramethyl-[1,3,2]-dioxaborolan-2-yl)phenyl]-pyridin [908350-80-1] verwendet. Ausbeute: 56.0 g (73 mmol), 73 %. Reinheit: ca. 99.7 %ig n. ¹H-NMR.

### C: Synthese der Metallkomplexe Ir(L):

### Beispiel Ir(L1):

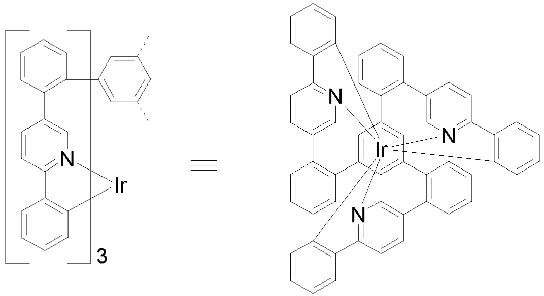

Ein Gemisch aus 7.66 g (10 mmol) des Liganden L1, 4.90 g (10 mmol) Tris(acetylacetonato)iridium(III) [15635-87-7] und 120 g Hydrochinon [123-31-9] werden in einem 500 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 - 260 °C, gemessen am Pt-100 Thermofühler, der in die aufgeschmolzene, gerührte Reaktionsmischung eintaucht, erhitzt. Während der nächsten 1.5 h wird das Reaktionsgemisch bei 250 - 260 °C gehalten, wobei wenig Kondensat abdestilliert und sich im Wasserabscheider sammelt. Nach Erkalten wird der Schmelzkuchen mechanisch zerkleinert und mit 500 ml Methanol ausgekocht. Die so erhaltene beige Suspension wird über eine Umkehrfritte filtriert, der beige Feststoff wird einmal mit 50 ml Methanol gewaschen und dann im Vakuum getrocknet. Rohausbeute: quantitativ. Der so erhaltene Feststoff wird in 1500 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer weitgehend eingeengt, wobei gleichzeitig kontinuierlich MeOH bis zur Kristallisation zugetropft wird. Nach Absaugen, waschen mit wenig MeOH und Trocknen im Vakuum erfolgt die weitere Reinigung des gelben Produkts durch dreimalige kontinuierliche Heißextraktion mit Toluol:Acetonitril (3:1, vv) und fünfmalige Heißextraktion mit Toluol (Vorlagemenge jeweils ca. 150 ml, Extraktionshülse: Standard Soxhletthülsen aus Cellulose der Fa. Whatman) unter sorgfältigem Luft- und Lichtausschluss. Ausbeute: 8.52 g (8.9 mmol), 89 %. Reinheit: > 99.9 % nach HPLC.

### Beispiel Ir(L2):

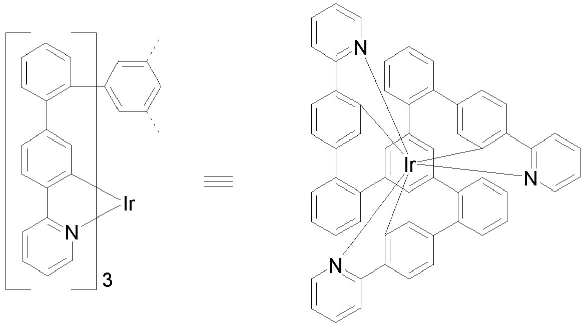

Analog kann Ir(L2) unter Verwendung von L2 statt L1 dargestellt werden. Die Reinigung erfolgt durch dreimalige Umkristallisation aus NMP unter Zusatz von Methanol beim Auskülen der Lösung. Ausbeute: 8.04 g (8.4 mmol), 84 %. Reinheit: > 99.7 % nach HPLC.

### D: Halogenierung des Metallkomplexes Ir(L):

### Allgemeine Durchführung:

Eine Lösung bzw. Suspension von 10 mmol eines Komplexes, der in para-Position zum Iridium A x C-H-Gruppen trägt, in 500 ml bis 2000 ml Dichlormethan, je nach Löslichkeit der Metallkomplexe, wird unter Licht- und Luftausschluss bei -30 bis +30 °C mit A x 10.5 mmol N-Halogensuccinimid (Halogen: Cl, Br, I; A = 1 entspricht Mono-, A = 2 entspricht Di-, A = 3 entspricht Trihalogenierung) versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol ausgekocht, der Feststoff wird abgesaugt, dreimal mit ca. 30 ml Methanol gewaschen und dann im Vakuum getrocknet. Man erhält so die in para-Position zum Iridium bromierten Iridium-Komplexe. Komplexe mit einem HOMO (CV) von ca. -5.1 bis -5.0 eV und betragsmäßig kleiner neigen zur Oxidation (Ir(III) > Ir(IV)), wobei das Oxidationsmittel Brom, freigesetzt aus NBS, ist. Diese Oxidationsreaktion ist durch eine deutliche Grünfärbung der ansonsten gelben bis roten Lösungen / Suspensionen der Emitter zu erkennen. In solchen Fällen wird ein weiteres Äquivalent NBS zugesetzt. Zur Aufarbeitung setzt man 300 - 500 ml Methanol und 2 ml Hydrazin Hydrat als Reduktionsmittel zu, wodurch sich die grünen Lösungen / Suspension gelb verfärben (Reduktion Ir(IV) > Ir(III). Dann zieht man im Vakuum das Lösungsmittel weitgehend ab, versetzt mit 300 ml Methanol, saugt den Feststoff ab, wäscht dreimal mit je 100 ml Methanol und trocknet im Vakuum. Unterstöchiometrische Bromierungen, z. B. Mono- und Dibromierungen von Komplexen mit 3 C-H-Gruppen para-Position zum Iridium, verlaufen meist weniger selektiv als die stöchiometrischen Bromierungen. Die Rohprodukte dieser Bromierungen können chromatographisch (CombiFlash Torrent der Fa. A. Semrau) getrennt werden.

### Beispiel IrL1-3Br:

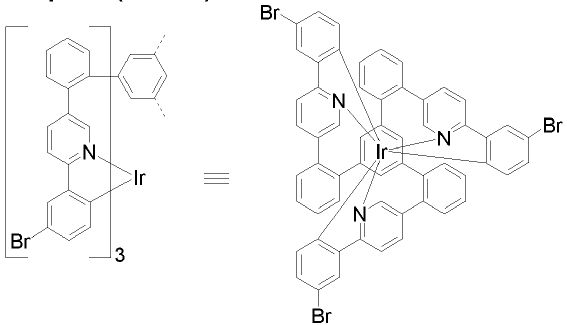

Eine bei 0 °C gerührte Suspension von 9.6 g (10 mmol) Ir(L1) in 2000 ml DCM wird auf einmal mit 5.6 g (31.5 mmol) N-Bromsuccinimid versetzt und dann weitere 20 h gerührt. Nach Entfernen von ca. 1900 ml des DCMs im Vakuum wird die gelbe Suspension mit 100 ml Methanol versetzt, unter Rühren ausgekocht, der Feststoff wird abgesaugt, dreimal mit ca. 30 ml Methanol gewaschen und dann im Vakuum getrocknet. Ausbeute: 11.3 g (9.5 mmol), 95 %. Reinheit: > 99.0 %ig nach NMR.

Analog können folgende Komplexe dargestellt werden:

| Bsp. | Edukt > bromierter Komplex | Ausbeute |
|---|---|---|
| Tribromierung | | |
| Ir(L2-3Br) | 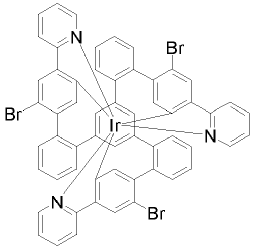 | |
| | Ir(L2) + 40 mmol NBS > Ir(L2-3Br) Lösungsmittel DCM | |

| Dibromierung | | |
|---|---|---|
| Ir(L1-2Br) | 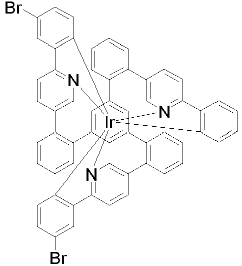 | 33 % |
| | Ir(L1) + 21 mmol NBS > Ir(L1-2Br) Lösungsmittel DMSO | |
| Ir(L2-2Br) | 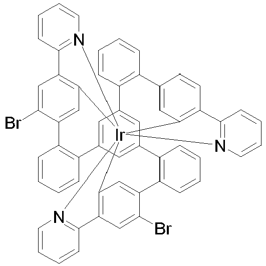 | 26 % |
| | Ir(L2) + 21 mmol NBS > Ir(L2-2Br) Lösungsmittel DMSO / 60 °C | |

| Monobrom ierung | | |
|---|---|---|
| Ir(L1-1 Br) | 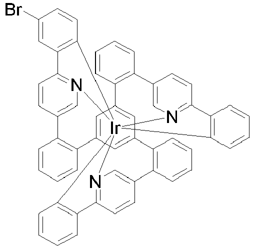 | 24 % |
| | Ir(L1) + 10.5 mmol NBS > Ir(L1-1Br) Lösungsmittel DMSO | |
| Ir(L2-1 Br) | 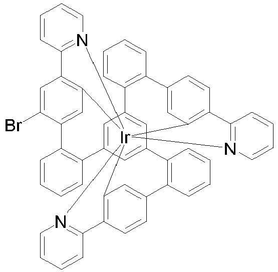 | 19 % |
| | Ir(L2) + 10.5 mmol NBS > Ir(L2-1Br) Lösungsmittel DMSO / 60 °C | |

### E: Darstellung der Metallkomplexe mit Alkinfunktion

### 1) Mittels Sonogashira-Kupplung

### Beispiel Ir(100)

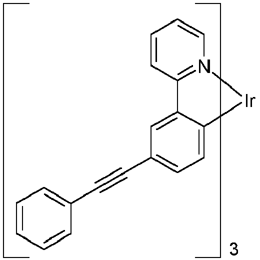

Ein Gemisch aus 26.8 g (30 mmol) MS1, 12.2 g (120 mmol) Phenylacetylen [25038-69-1], 150 ml Dimethylacetamid (DMAC) und 50 ml Triethylamin wird mit 191 mg (1 mmol) Kupfer(I)iodid, 224 mg (1 mmol) Palladium(II)acetat und 525 mg (2 mmol) Triphenylphosphin versetzt und dann 16 h bei 130 °C im Autoklaven gerührt. Nach Erkalten entfernt man das Lösungsmittel weitgehend im Vakuum, nimmt den Rückstand in 500 ml Dichlormethan auf, filtriert über ein mit Dichlormethan vorgeschlämmtes Celitebett ab und wäscht mit 100 ml Dichlormethan nach. Das Filtrat wird dreimal mit je 300 ml Wasser und einmal mit 300 ml gesättigter Kochsalzlösung gewaschen, über Magnesiumsulfat getrocknet und dann zur Trockene eingeengt. Das so erhaltene Rohprodukt wird mit Dichlormethan an Kieselgel chromatographiert. Ausbeute: 11.5 g (12 mmol), 40 %; Reinheit: > 99.0 %ig nach NMR.

Analog können aus den entsprechenden Alkinen folgende Verbindungen dargestellt werden, wobei die Reagentien und Katalysatoren entsprechend der molaren Menge an Bromfunktionen angepasst werden.

| Bsp. | Produkt | Ausbeute |
|---|---|---|
| | Edukte | |
| Ir(101) | 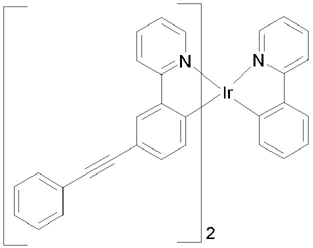 | 64 % |
| | MS2 / 25038-69-1 | |
| Ir(102) | 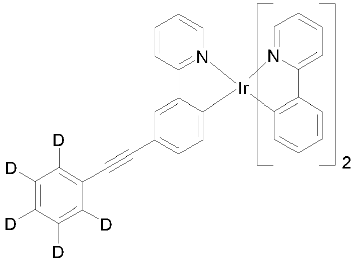 | 72 % |
| | MS3 / 25837-46-1 | |
| Ir(103) | 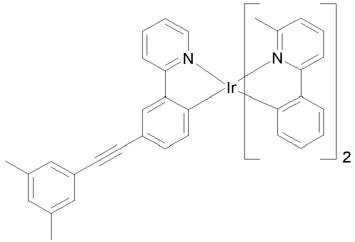 | 59 % |
| | MS4 / 6366-06-9 | |
| Ir(104) | 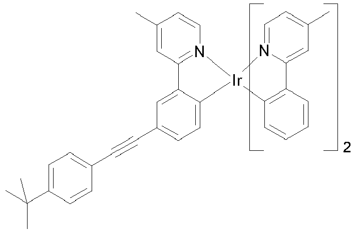 | 68 % |
| | MS5 / 772-38-3 | |
| Ir(105) | 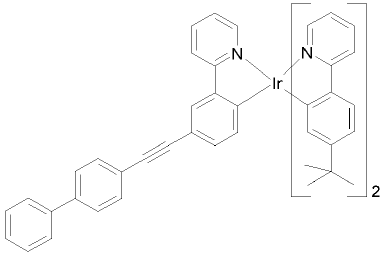 | 66 % |
| | MS6 / 29079-00-3 | |
| Ir(106) | 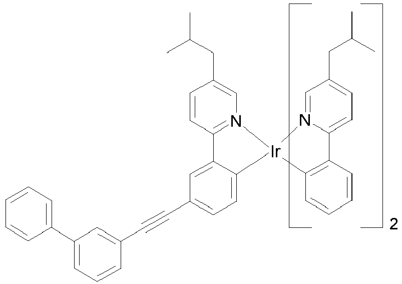 | 70 % |
| | MS7 / 58650-11-6 | |
| Ir(107) | 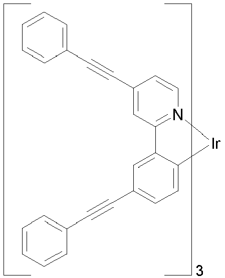 | 34 % |
| | MS8 / 25038-69-1 | |
| Ir(108) | 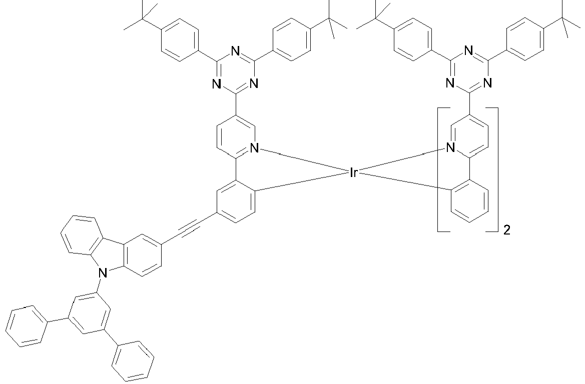 | 54% |
| | MS9/1679326-74-9 | |
| Ir(109) | 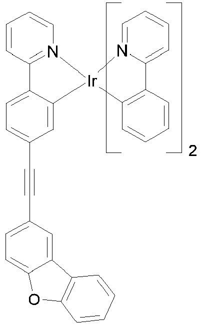 | 60% |
| | MS12/1378260-35-5 | |
| Ir(110) | 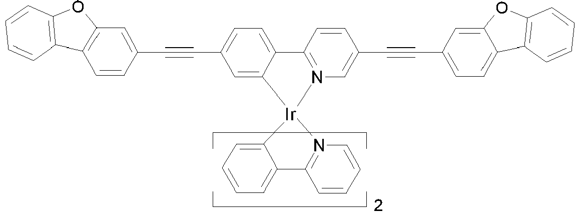 | 58 % |
| | MS16/1427176-74-6 | |
| Ir(111) | 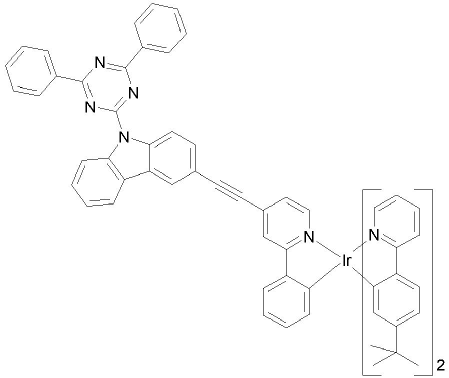 | 47 % |
| | M S19/1679326-69-2 | |
| Ir(112) | 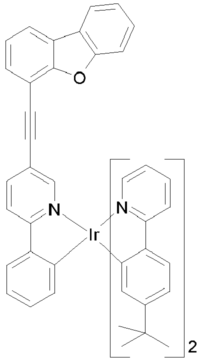 | 56 % |
| | MS21 /1378255-47-0 | |
| Ir(113) | 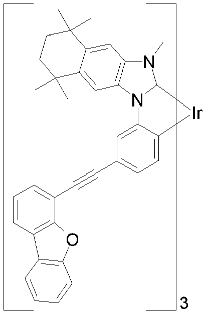 | 45 % |
| | MS22 / 1548471-54-0 | |
| Ir(114) | 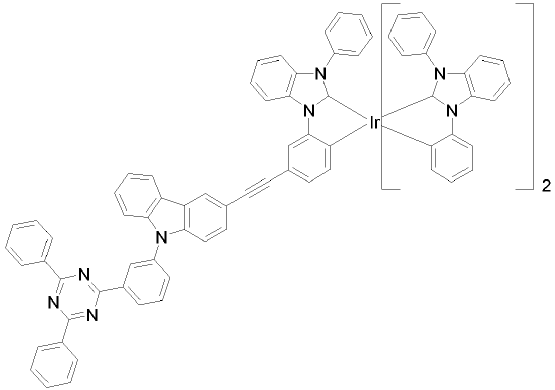 | 53 % |
| | MS23/1621630-10-1 | |
| Ir(115) | 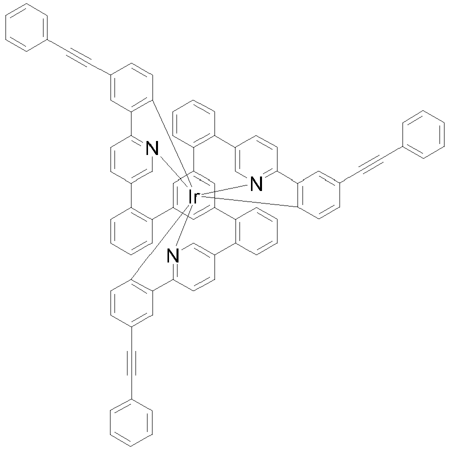 | 58 % |
| | Ir(L1-3Br)/25038-69-1 | |
| Ir(116) | 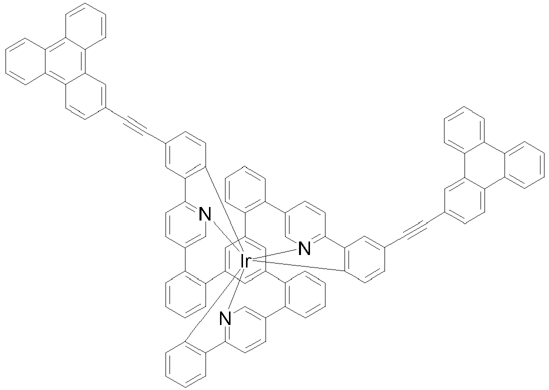 | 66 % |
| | Ir(L1-2Br)/1271731-38-4 | |
| Ir(117) | 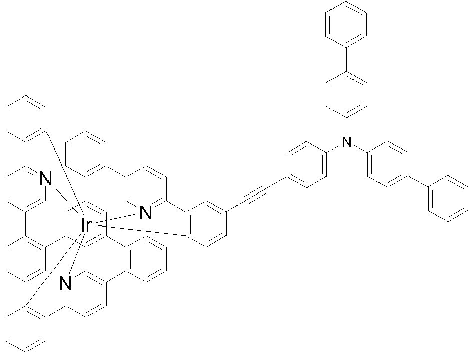 | 31 % |
| | Ir(L1-1Br)11187569-85-2 | |
| Pt(100) | 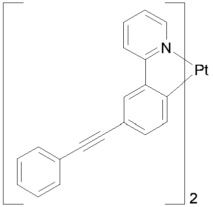 | 23 % |
| | MS24 / 25038-69-1 | |

### 2) Mittels Suzukikupplung

### Beispiel Ir(200)

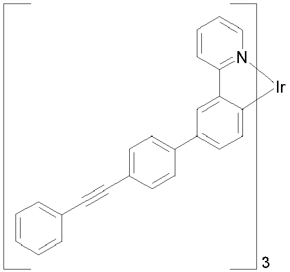

Ein Gemisch aus 26.8 g (30 mmol) MS1, 30.4 g (100 mmol) 4,4,5,5-Tetramethyl-2-[4-(2-phenylethynyl)-1,3,2-dioxaborolan [1190376-20-5], 69.1 g (300mmol) Trikaliumphosphat-monohydrat, 3.5 g (3 mmol) Tetrakis-(triphenylphosphino)-palladium(0), 50 g Glaskugeln (3 mm Durchmesser) und 500 ml DMSO werden unter gutem Rühren 25 h auf 90 °C erhitzt. Nach Erkalten entfernt man das Lösungsmittel weitgehend im Vakuum, nimmt den Rückstand in 500 ml Dichlormethan auf, filtriert über ein mit Dichlormethan vorgeschlämmtes Celitebett ab und wäscht mit 100 ml Dichlormethan nach. Das Filtrat wird dreimal mit je 300 ml Wasser und einmal mit 300 ml gesättigter Kochsalzlösung gewaschen, über Magnesiumsulfat getrocknet und dann zur Trockene eingeengt. Das so erhaltene Rohprodukt wird mit Dichlormethan an Kieselgel chromatographiert. Ausbeute: 25.6 g (21.6 mmol), 72 %. Reinheit: ca. 99.0 %ig nach NMR.

Analog können aus den entsprechenden Alkinen folgende Verbindungen dargestellt werden, wobei die Reagentien und Katalysatoren entsprechend der molaren Menge an Bromfunktionen angepasst werden.

| Bsp. | Produkt Edukte | Ausbeute |
|---|---|---|
| Einkernige Metallkomplexe | | |
| Ir(201) | 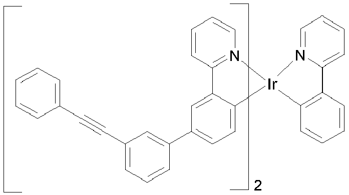 | 70 % |
| | MS2 / 258339-61-6 | |
| Ir(202) | 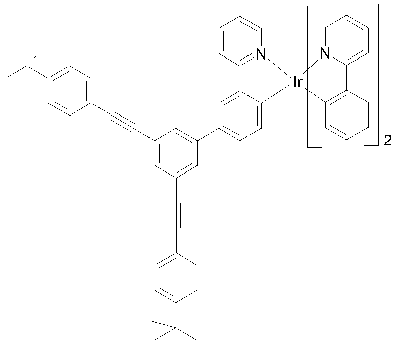 | 86 % |
| | MS3 / 872690-05-6 | |
| Ir(203) | 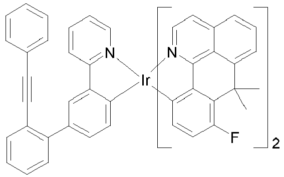 | 48 % |
| | MS10/124160-41-4 | |
| Ir(204) | 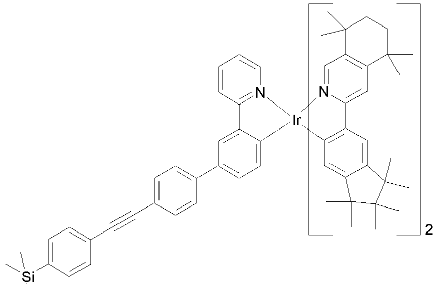 | 85 % |
| | MS11/1217485-96-5 | |
| Ir(205) | 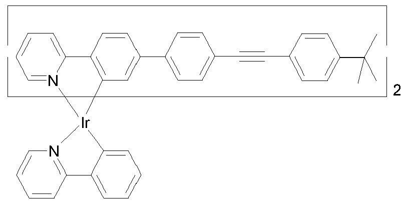 | 66 % |
| | MS13/872690-03-4 | |
| Ir(206) | 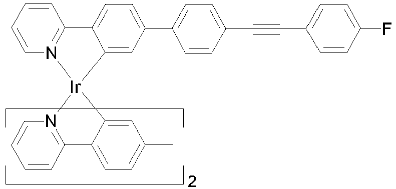 | 78 % |
| | MS14/1648789-04-1 | |
| Ir(207) | 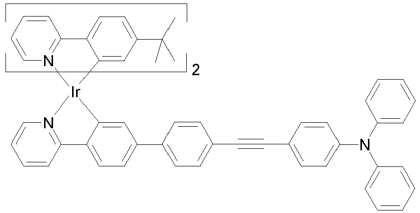 | 74 % |
| | MS15/1607819-42-0 | |
| Ir(208) | 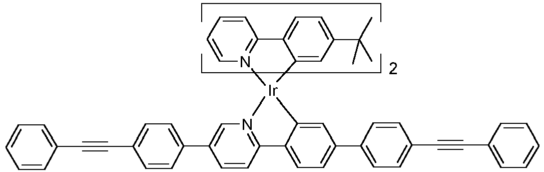 | 71 % |
| | MS17/1190376-20-5 | |
| Ir(209) | 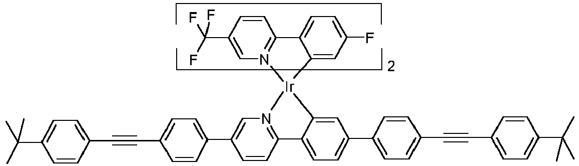 | 70 % |
| | MS18/1217485-96-5 | |
| Ir(210) | 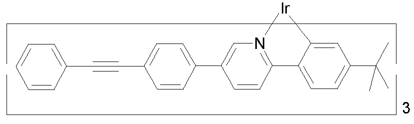 | 68 % |
| | M20 / 1190376-20-5 | |
| Ir(211) | 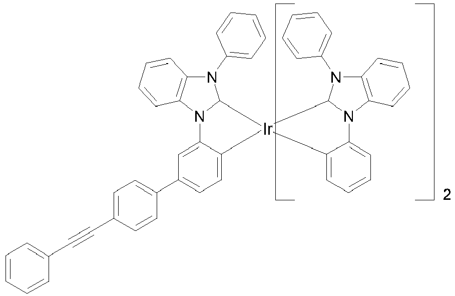 | 82 % |
| | MS23 / 1190376-20-5 | |
| Ir(212) | 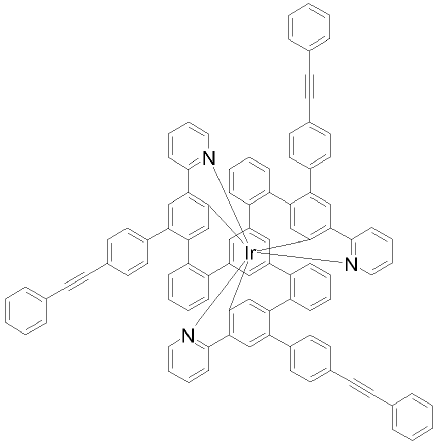 | 80 % |
| | Ir(L2-3Br)/1190376-20-5 | |
| Ir(213) | 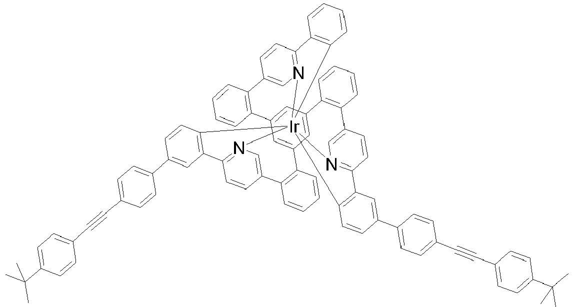 | 75 % |
| | Ir(L1-2Br)/872690-03-4 | |
| Ir(214) | 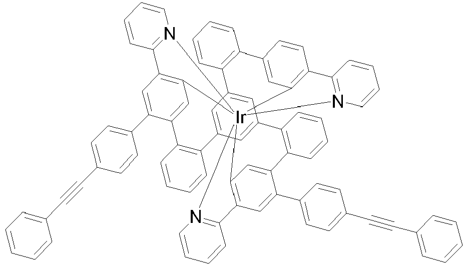 | 83 % |
| | Ir(L2-2Br)/1190376-20-5 | |
| Ir(215) | 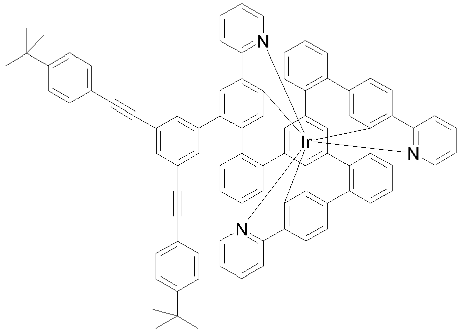 | 88 % |
| | Ir(L2-1Br) / 872690-05-6 | |
| Ir(216) | 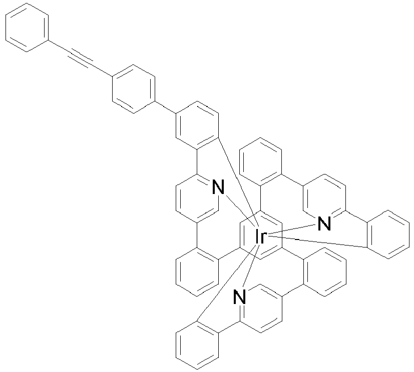 | 74 % |
| | Ir(L1-1Br)/1190376-20-5 | |
| Ir(217) | 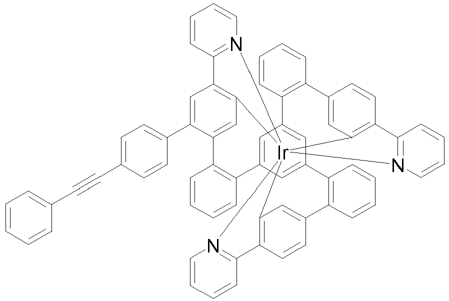 | 88 % |
| | Ir(L2-1Br) / 1190376-20-5 | |

| Zweikernige Metallkomplexe | | |
|---|---|---|
| Ir(300) | 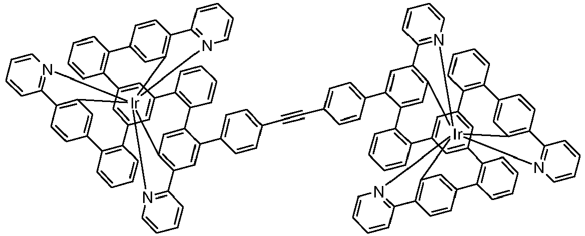 | 54 % |
| | Ir(L2-1Br)/915772-85-9 | |
| Ir(301) | 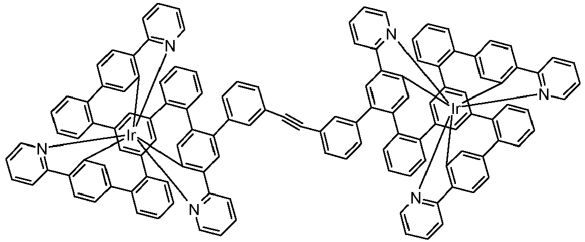 | 57 % |
| | Ir(L2-1Br) / 1222008-08-3 | |

### E: Darstellung der erfindungsgemäßen Metallkomplexe:

### Beispiel Ir(500) (nicht erfindungsgemäß):

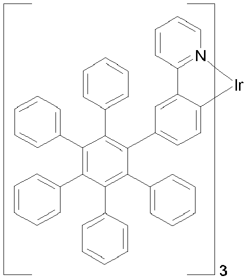

Ein Gemisch aus 9.6 g (10 mmol) Ir(100), 12.7 g (33 mmol) 2,3,4,5-Tetraphenyl-2,4-cyclopentadien-1-on [479-33-4] und 30 ml Diphenylether (alternativ kann 3-Phenoxytoluol verwendet werden) wird 24 h auf 255-260 °C erhitzt. Nach Erkalten auf 60 °C tropft man die Reaktionsmischung in 200 ml gut gerührtes Methanol ein, rührt 1 h nach, saugt vom ausgefallenen Feststoff ab, wäscht diesen dreimal mit je 50 ml Methanol und trocknet im Vakuum. Das so erhaltene Rohprodukt wird an Kieselgel chromatographiert (n-Heptan/Ethylacetat 9:1). Anschließend wird der Feststoff fünfmal mit Ethylacetat/Acetonitril (1:2) heißextrahiert (Vorlagemenge 250 ml) und dann im Hochvakuum bei 180 °C von Lösemittelresten befreit. Ausbeute: 10.5 g (5.2 mmol), 52 %. Reinheit: ca. 99.9 %ig nach HPLC.

Analog können folgende Verbindungen dargestellt werden, wobei das stöchiometrische Verhältnis von Alkin zu Carbonylkomponente entsprechend angepasst wird. Die mit * markierten Verbindungen sind nicht erfindungsgemäß.

| Bsp. | Produkt | Ausbeute |
|---|---|---|
| | Edukte | |
| Ir(501)* | 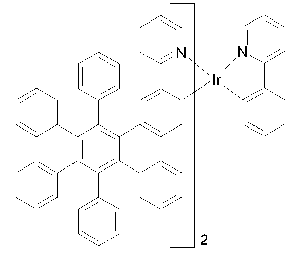 | 27 % |
| | Ir(101)/479-33-4 | |
| Ir(502)* | 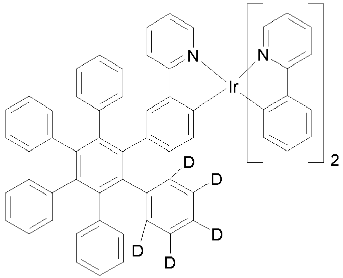 | 30 % |
| | Ir(102)/479-33-4 | |
| Ir(503)* | 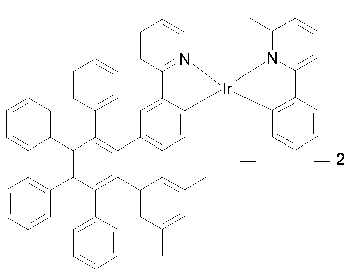 | 25 % |
| | Ir(103)/479-33-4 | |
| Ir(504)* | 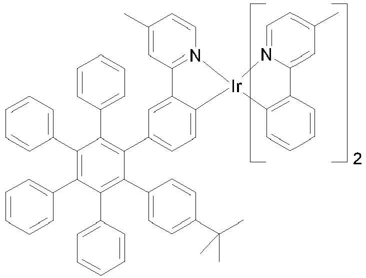 | 33 % |
| | Ir(104)/479-33-4 | |
| Ir(505)* | 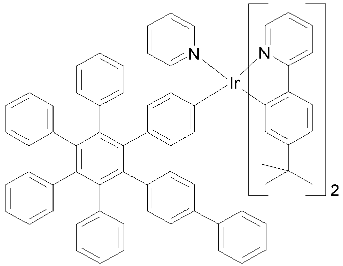 | 29 % |
| | Ir(105)/479-33-4 | |
| Ir(506)* | 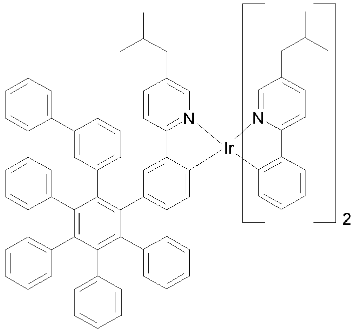 | 34 % |
| | Ir(106)/479-33-4 | |
| Ir(507)* | 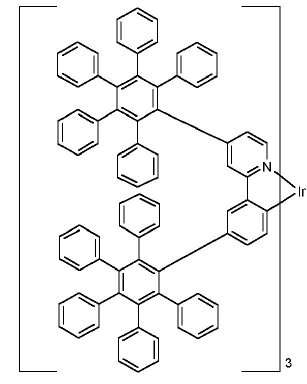 | 24 % |
| | Ir(107)/479-33-4 | |
| Ir(508)* | 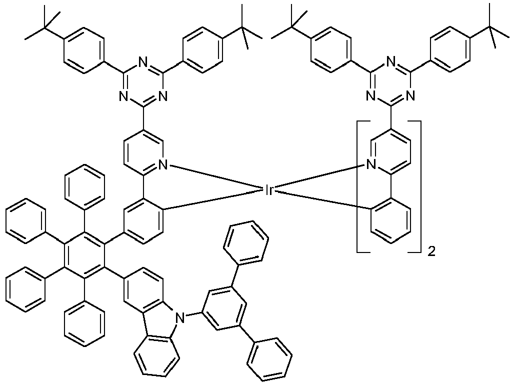 | 30 % |
| | Ir(108)/479-33-4 | |
| Ir(509)* | 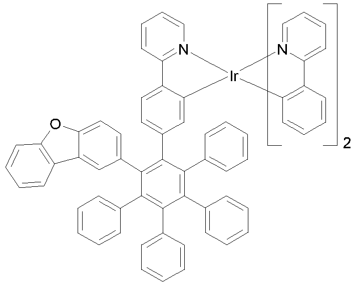 | 35 % |
| | Ir(109) / 479-33-4 | |
| Ir(510)* | 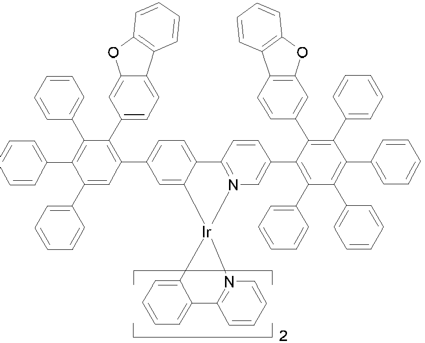 | 28 % |
| | Ir(110) / 479-33-4 | |
| Ir(511)* | 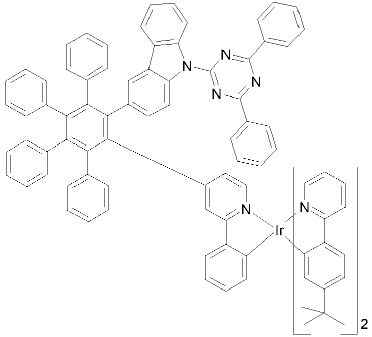 | 21 % |
| | Ir(111) / 479-33-4 | |
| Ir(512)* | 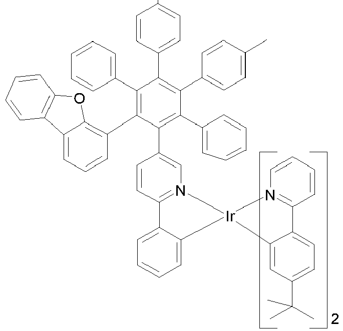 | 26 % |
| | Ir(112) / 38305-61-2 | |
| Ir(513)* | 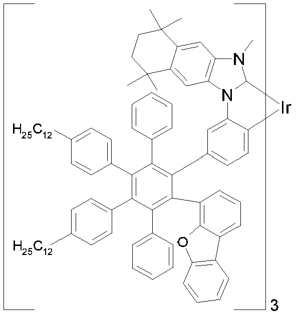 | 31 % |
| | Ir(113) / 217489-63-9 | |
| Ir(514)* | 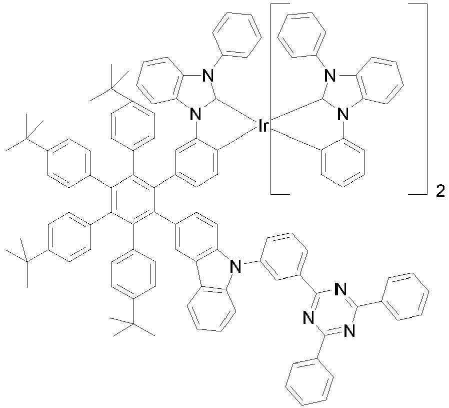 | 24 % |
| | Ir(114) / 196505-83-6 | |
| Ir(515) | 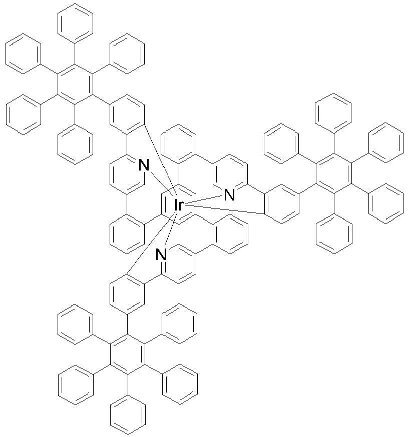 | 64 % |
| | Ir(115) / 479-33-4 | |
| Ir(516) | 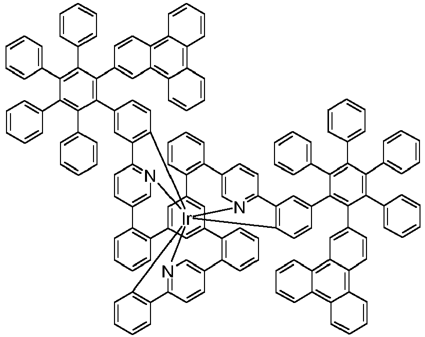 | 67 % |
| | Ir(116) / 479-33-4 | |
| Ir(517) | 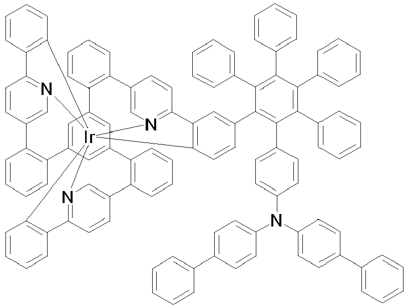 | 63 % |
| | Ir(117) / 479-33-4 | |
| Pt(500)* | 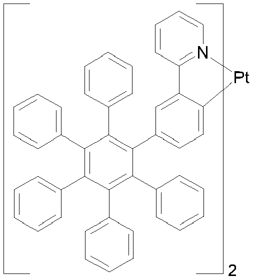 | 18 % |
| | Pt(100) / 479-33-4 | |
| Ir(518)* | 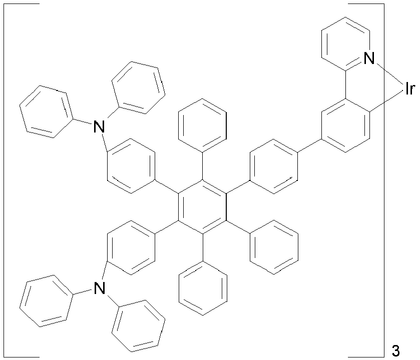 | 32 % |
| | Ir(200) / 675610-03-4 | |
| Ir(519)* | 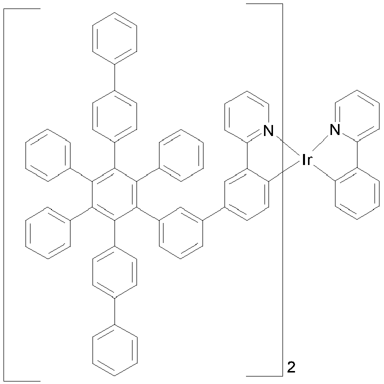 | 34 % |
| | Ir(201) / 19059-92-8 | |
| Ir(520)* | 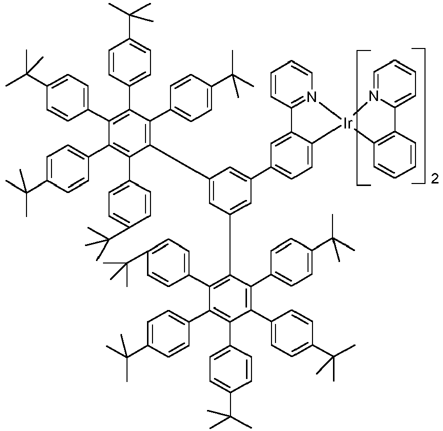 | 28 % |
| | Ir(202) /196505-83-6 | |
| Ir(521)* | 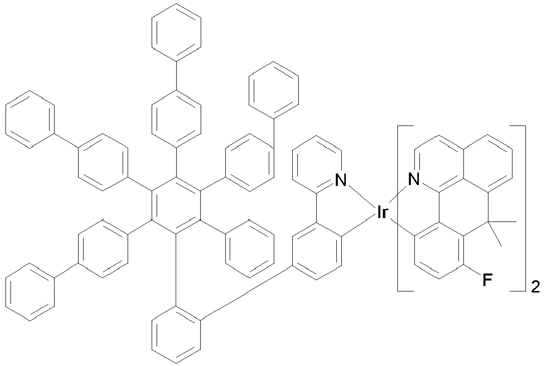 | 17 % |
| | Ir(203) / 15811-84-4 | |
| Ir(522)* | 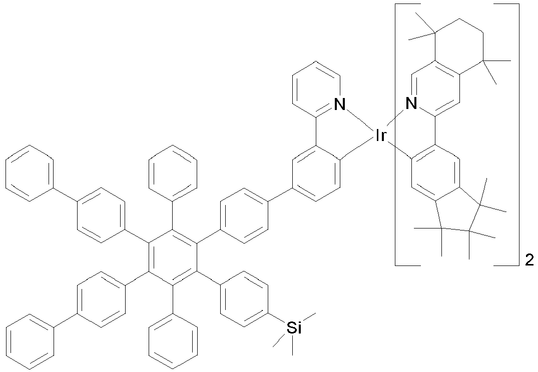 | 26 % |
| | Ir(204) /109770-30-1 | |
| Ir(523)* | 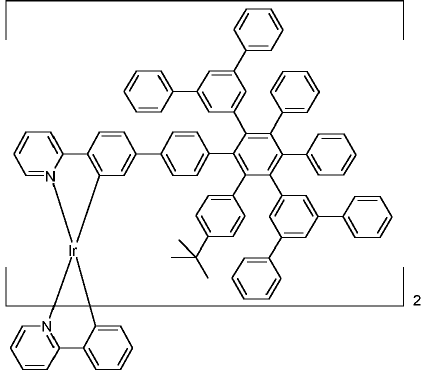 | 28 % |
| | Ir(205) / 297154-58-6 | |
| Ir(524)* | 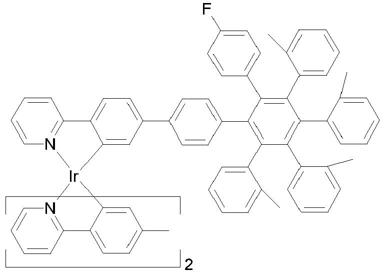 | 31 % |
| | Ir(206)/ 77243-07-3 | |
| Ir(525)* | 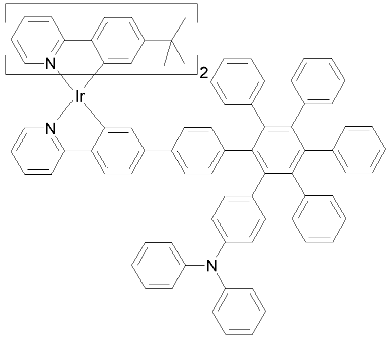 | 20 % |
| | Ir(207) / 479-33-4 | |
| Ir(526)* | 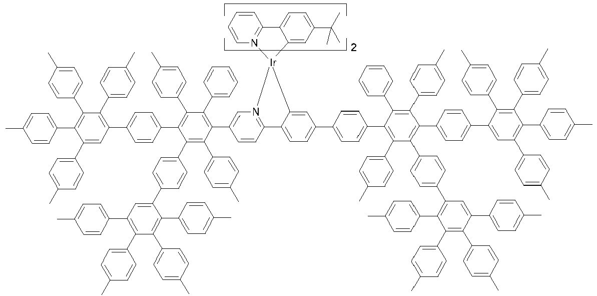 | 23 % |
| | Ir(208) / 717105-86-7 | |
| Ir(527)* | 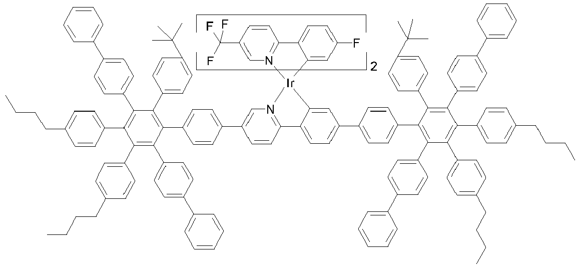 | 25 % |
| | Ir(209) / 1386995-55-6 | |
| Ir(528)* | 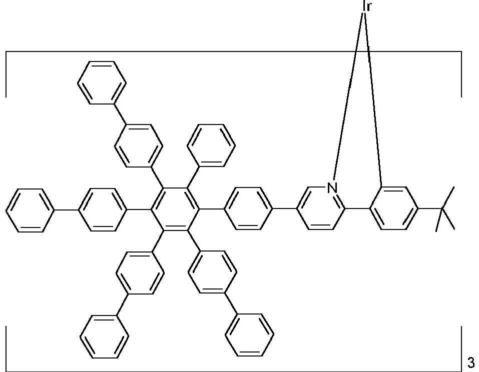 | 21 % |
| | Ir(210) | |
| Ir(529)* | 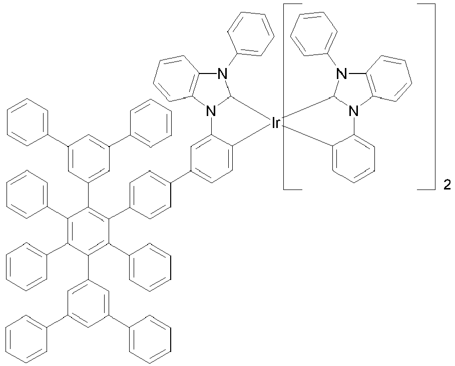 | 26 % |
| | Ir(211) / 297154-58-6 | |
| Ir(530) | 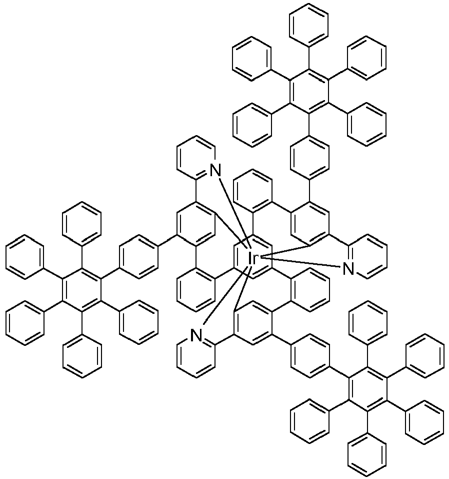 | 64 % |
| | Ir(212) / 479-33-4 | |
| Ir(531) | 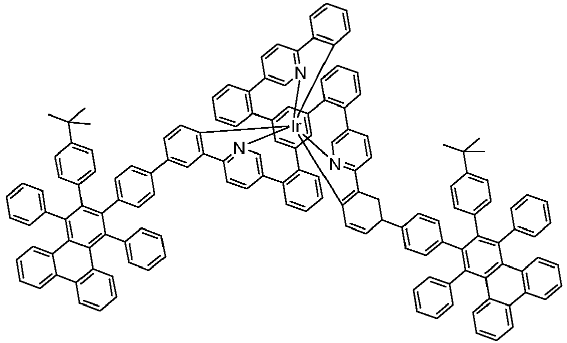 | 69 % |
| | Ir(213) / 5660-91-3 | |
| Ir(532) | 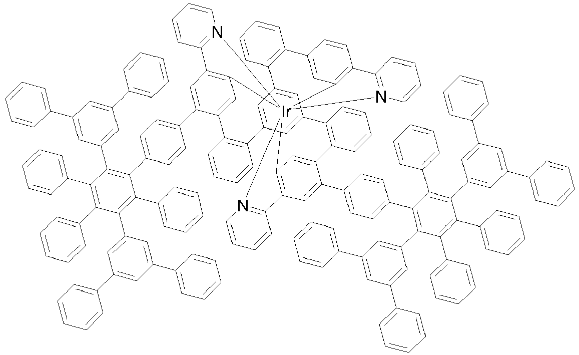 | 64 % |
| | Ir(214) / 297154-58-6 | |
| Ir(533) | 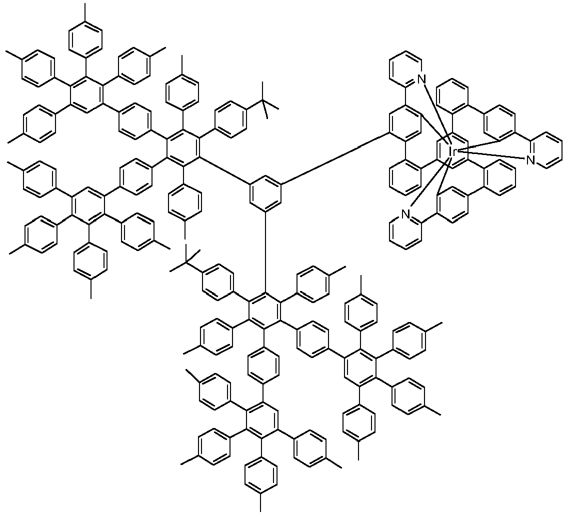 | 61 % |
| | Ir(215) / 717105-86-7 | |
| Ir(534) | 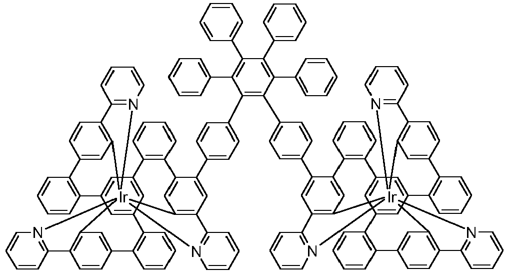 | 51 % |
| | Ir(300) / 479-33-4 | |
| Ir(535) | 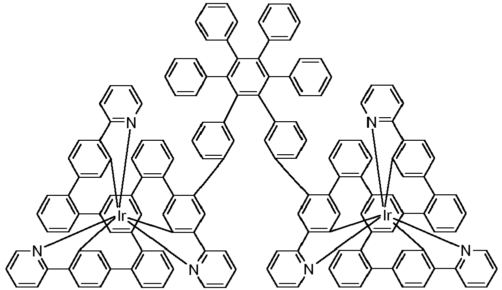 | 49 % |
| | Ir(301) / 479-33-4 | |

### Beispiel: Löslichkeit

Die erfindungsgemäßen Verbindungen sind in unpolaren (Aromaten, Alkylaromaten, Cyclohexan) und dipolar-aprotischen Lösungsmitteln (Ketonen, Ether, Estern, Amiden, Sulfonen, Sulfoxiden, etc., wie Aceton, Butanon, Cyclohexanon, Di-n-butylether, THF, Dioxan, 3-Phenoxytoluol, Anisol, Ethylacatat, Butylacetat, Hexylacetat, Benzoesäuremethylester, DMF, DMAC, NMP, DMSO, Dimethylsulfon, Sulfolan, etc.) und deren Gemischen sehr gut löslich und bilden langzeitstabile Lösungen. Bevorzugte Konzentrationen sind 5-500 mg/ml, besonders bevorzugt 20-200 mg/ml. Diese Eigenschaft ist für die Verarbeitung aus Lösung in Form von Lösungen allein oder in Kombination mit anderen Materialien von entscheidender Bedeutung, insbesondere im Hinblick auf das Drucken hochaufgelöster Vollfarbdisplays.

**Vergleich der Löslichkeit:**

| Verbindung | Löslichkeit mg/ml bei Raumtemperatur | | | | |
|---|---|---|---|---|---|
| | Cyclohexan | Toluol | 3-Phenoxytoluol | n-Butylbenzoat | DMF |
| IrRef1 | < 3 | ∼ 10 | ∼ 100 | ∼ 20 | --- |
| Ir(L2-3Ph) | << 1 | < 5 | > 10 | < 5 | ∼ 5 |
| Ir(500) | > 5 | > 100 | > 150 | > 80 | > 70 |
| Ir(530) | > 5 | > 100 | > 150 | > 80 | > 70 |

### Beispiel: Vergleich der PL-Spektren

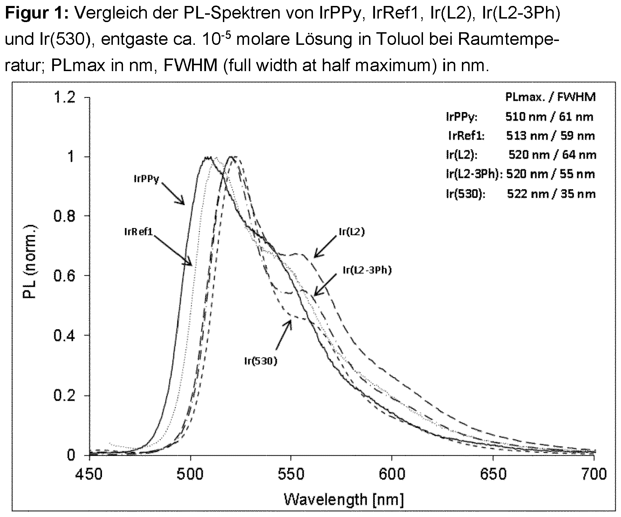

Die Verbindungen zeichnen sich insbesondere durch schmale Emissionsspektren (Photolumineszenz (PL) bzw. Elektrolumineszenz) aus, wie dies in Figur 1 ersichtlich ist. In Figur 1 ist ein Vergleich der PL-Spektren von IrPPy, IrRef1, Ir(L2), Ir(L2-3Ph) und Ir(530) dargestellt, wobei für die Messung der Spektren entgaste ca. 10⁻⁵ molare Lösungen in Toluol bei Raumtemperatur verwendet werden; PLmax in nm, FWHM (full width at half maximum) in nm. Schmale Emissionsspektren sind entscheidend für den Bau von farbreinen und hocheffizienten OLED-Bauteilen, sowohl für bottom emission als auch für top emission Bauteile mit weak oder strong cavity.

### Beispiel: Herstellung der OLEDs

### Lösungs-prozessierte Devices:

### A: Aus niedermolekularen löslichen Funktionsmaterialien

Die erfindungsgemäßen Iridium-Komplexe können aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, in diesem Fall wird ein HL-X von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol oder 3-Phenoxytoluol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices vom Typ1 enthalten eine Emissionsschicht aus M1:M2:IrL (40%:35%:25%), die vom Typ2 enthalten eine Emissionsschicht aus M1 :M2:IrLa:IrLb (30%:35%:30%:5%), d.h. sie enthalten zwei verschiedene Ir-Komplexe. Die Emissionsschicht wird in einer Inertgasatmosphäre, im vorliegenden Fall Argon, aufgeschleudert und 10 min bei 160 °C ausgeheizt. Darüber wird die Lochblockierschicht (15nm ETM1) und die Elektronentransportschicht (35 nm ETM1 (50%) / ETM2 (50%)) aufgedampft (Aufdampfanlagen von Lesker o.a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 1 fasst die erhaltenen Daten zusammen.

**Tabelle 1: Ergebnisse mit aus Lösung prozessierten Materialien**

| | | | | | |
|---|---|---|---|---|---|
| die mit * gekennzeichneten Beispiele sind nicht erfindungsgemäß) | | | | | |

| **Bsp.** | **Emitter Device** | **EQE (%) 1000 cd/m²** | **Spannung (V) 1000 cd/m²** | **CIE x/y** | **LD50 (h) 1000 cd/m²** |
|---|---|---|---|---|---|
| Ref-Red1 | IrRef1 | 17.3 | 6.4 | 0.65/0.35 | 220000 |
| | IrRef3 | | | | |
| | Typ2 | | | | |
| Red1 | Ir530 | 18.1 | 6.3 | 0.65/0.35 | 270000 |
| | IrRef3 | | | | |
| | Typ2 | | | | |
| Red2 | Ir530 | 18.6 | 6.1 | 0.61/0.39 | 230000 |
| | Ir508 | | | | |
| | Typ2 | | | | |
| Ref-Green1 | IrRef1 | 18.1 | 5.2 | 0.34/0.61 | 210000 |
| | Typ1 | | | | |
| Ref-Green2 | IrRef2 | 20.6 | 5.2 | 0.33/0.62 | 250000 |
| | Typ1 | | | | |
| Green1* | Ir(500) | 19.6 | 5.0 | 0.32/0.62 | 290000 |
| | Typ1 | | | | |
| Green2 | Ir(530) | 22.3 | 5.2 | 0.30/0.65 | 360000 |
| | Typ1 | | | | |
| Green3 | Ir(531) | 20.7 | 5.1 | 0.33/0.62 | 270000 |
| | Typ1 | | | | |
| Green4 | Ir(534) | 22.0 | 5.1 | 0.31/0.66 | 340000 |
| | Typ1 | | | | |
| Green5 | Ir(532) | 22.1 | 5.0 | 0.33/0.62 | 290000 |
| | Typ1 | | | | |
| Green6 | Ir(533) | 21.9 | 4.8 | 0.32/0.63 | 320000 |
| | Typ1 | | | | |
| Green7 | Ir(534) | 22.7 | 4.9 | 0.32/0.63 | 340000 |
| | Typ1 | | | | |
| Green8* | Ir(509) | 20.5 | 5.1 | 0.35/0.61 | 230000 |
| | Typ1 | | | | |
| Green9* | Ir(510) | 20.1 | 5.0 | 0.38/0.59 | 260000 |
| | Typ1 | | | | |
| Green10* | Ir(511) | 20.9 | 5.2 | 0.44/0.55 | 330000 |
| | Typ1 | | | | |
| Green11 | Ir(515) | 21.9 | 4.9 | 0.34/0.61 | 290000 |
| | Typ1 | | | | |
| Green12 | Ir(516) | 22.3 | 5.0 | 0.34/0.61 | 310000 |
| | Typ1 | | | | |
| Green13 | Ir(517) | 21.7 | 4.7 | 0.35/0.62 | 330000 |
| | Typ1 | | | | |

**Tabelle 2: Strukturformeln der verwendeten Materialien**

| | |
|---|---|
| 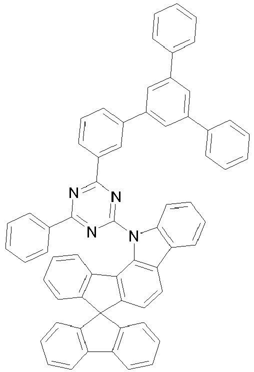 | 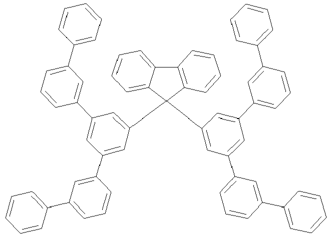 |
| M1 | M2 |
| 1616231-60-7 | 1246496-85-4 |
| 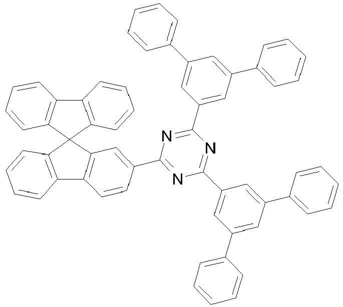 | 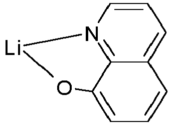 |
| ETM1 | ETM2 |
| 1233200-52-6 | 25387-93-3 |
| | 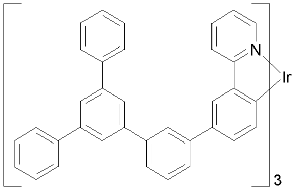 |
| | IrRef1 |
| | 1269508-30-6 |
| 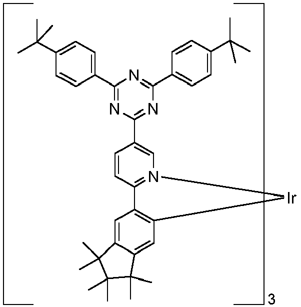 | 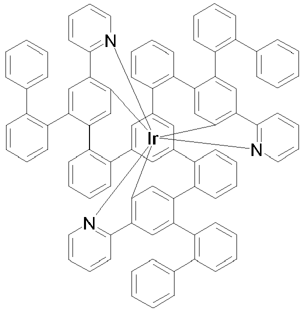 |
| IrRef3 | IrRef2 |
| 1870013-87-8 | WO 2016/124304 |

## Patentansprüche

1. Metallkomplex umfassend mindestens eine Struktur der allgemeinen Formel (1),
M(L)ₙ(L')ₘ Formel (1)
wobei für die verwendeten Symbole und Indizes gilt:
M ist Iridium;
L ist bei jedem Auftreten gleich oder verschieden ein bidentater Ligand;
L' ist bei jedem Auftreten gleich oder verschieden ein Ligand;
n ist 3;
m ist 0;
wobei die Liganden über eine trivalente Brücke verknüpft sind, wodurch ein Metallkomplex enthaltend Iridium und einen hexadentaten tripodalen Liganden gebildet wird,
**dadurch gekennzeichnet, dass** der Metallkomplex mindestens eine Teilstruktur der Formel (2) enthält: 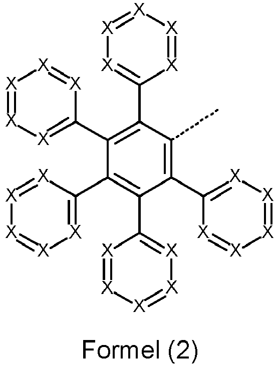 wobei die gestrichelte Bindung die Verknüpfung dieser Gruppe mit einem weiteren Teil des Metallkomplexes der Formel (1) darstellt und weiterhin gilt:
X ist bei jedem Auftreten gleich oder verschieden CR oder N mit der Maßgabe, dass maximal drei Symbole X pro Cyclus für N stehen;
R ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R auch miteinander ein Ringsystem bilden;
R¹ ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können, dabei können zwei oder mehrere Substituenten R² auch miteinander ein mono- oder polycyclisches Ringsystem bilden;
wobei die Teilstruktur neben der mit einer gestrichelten Bindung dargestellten Verknüpfung weitere Bindungen mit Teilen des Metallkomplexes der Formel (1) aufweisen kann;
mit der Maßgabe, dass die bidentaten Liganden L des Metallkomplexes jeweils mindestens eine Ir-C-Bindung aufweisen.

2. Metallkomplex nach Anspruch 1, **dadurch gekennzeichnet, dass** die Teilstruktur der Formel (2) mindestens einer der Formeln (2-1), (2-2) und/oder (2-3) entspricht, 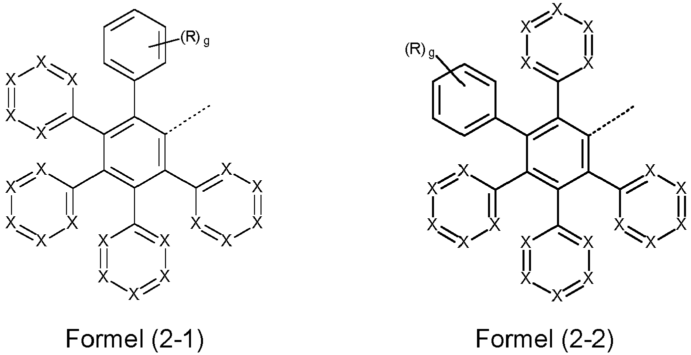 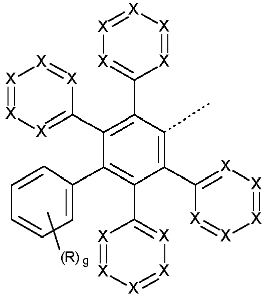 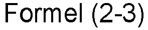 wobei die verwendeten Symbole R und X die in Anspruch 1 genannten Bedeutungen aufweisen und g 0, 1, 2, 3, 4 oder 5, vorzugsweise 0, 1, 2 oder 3 ist, wobei die Teilstruktur neben der mit einer gestrichelten Bindung dargestellten Verknüpfung weitere Bindungen mit Teilen des Metallkomplexes der Formel (1) aufweisen kann.

3. Metallkomplex nach Anspruch 1 oder 2, **dadurch gekennzeichnet, dass** die Teilstruktur der Formel (2) der Formel (2-4) entspricht, 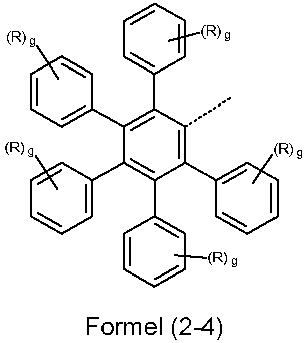 wobei die verwendeten Symbole R und X die in Anspruch 1 genannten Bedeutungen aufweisen und g gleich oder verschieden bei jedem Auftreten 0, 1, 2, 3, 4 oder 5, vorzugsweise 0, 1, 2 oder 3 ist, wobei die Teilstruktur neben der mit einer gestrichelten Bindung dargestellten Verknüpfung weitere Bindungen mit Teilen des Metallkomplexes der Formel (1) aufweisen kann.

4. Metallkomplex nach mindestens einem der Ansprüche 1 bis 3, **dadurch gekennzeichnet, dass** die mit einer gestrichelten Bindung in Formel (2), (2-1), (2-2), (2-3) bzw. (2-4) dargestellte Verknüpfung der Teilstruktur gemäß Formel (2), (2-1), (2-2), (2-3) und/oder (2-4) mit einem aromatischen oder heteroaromatischen Ringsystem, vorzugsweise einem Aryl- oder Heteroarylrest mit vorzugsweise 5 bis 40 Ringatomen verbunden ist.

5. Metallkomplex nach Anspruch 4, **dadurch gekennzeichnet, dass** die mit einer gestrichelten Bindung in Formel (2), (2-1), (2-2), (2-3) bzw. (2-4) dargestellte Verknüpfung der Teilstruktur gemäß Formel (2), (2-1), (2-2), (2-3) und/oder (2-4) mit einem Aryl- oder Heteroarylrest der Formel (Ar-1) verbunden ist, 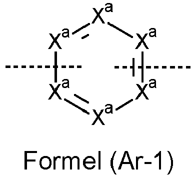 wobei die gestrichelten Bindungen die Verknüpfungen dieser Gruppe mit weiteren Teilen des Metallkomplexes der Formel (1) darstellen und die verwendeten Symbole X^{a}, N, CR oder C für den Fall, dass an X^{a} eine Bindung an die Teilstruktur der Formel (2), (2-1), (2-2), (2-3) bzw. (2-4) oder an einen weiteren Teil des Metallkomplexes der Formel (1) darstellt, und R jeweils unabhängig die in Anspruch 1 genannten Bedeutungen aufweist, wobei die Teilstruktur neben der mit einer gestrichelten Bindung dargestellten Verknüpfung weitere Bindungen mit Teilen des Metallkomplexes der Formel (1) aufweisen kann.

6. Metallkomplex nach Anspruch 4 oder 5, **dadurch gekennzeichnet, dass** das mit der Teilstruktur gemäß Formel (2), (2-1), (2-2), (2-3) und/oder (2-4) verbundene aromatische oder heteroaromatische Ringsystem direkt mit dem Metallatom M verbunden ist.

7. Metallkomplex nach einem oder mehreren der Ansprüche 1 bis 6, **dadurch gekennzeichnet, dass** die bidentaten Liganden an das Iridium über jeweils ein Kohlenstoffatom und ein Stickstoffatom oder über zwei Kohlenstoffatome koordinieren.

8. Metallkomplex nach mindestens einem der Ansprüche 1 bis 7, **dadurch gekennzeichnet, dass** der Metallkomplex mindestens einen bidentaten Ligenden der Formel (L-1), (L-2) und/oder (L-3) enthält, 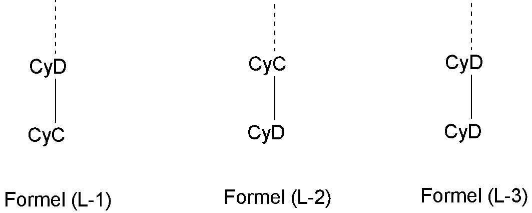 wobei für die verwendeten Symbole und Indizes gilt:
CyC ist gleich oder verschieden bei jedem Auftreten eine substituierte oder unsubstituierte Aryl- oder Heteroarylgruppe mit 5 bis 14 aromatischen Ringatomen, welche jeweils über ein Kohlenstoffatom an das Metall koordiniert und welche jeweils über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei sind die Liganden (L-1), (L-2) und/oder (L-3) miteinander über eine trivalente Brücke verknüpft und spannen so ein hexadentates Ligandensystem auf, wobei diese Bindungen an eine Brücke durch die gestrichelte Bindung angedeutet ist.

9. Metallkomplex nach einem oder mehreren der Ansprüche 1 bis 8, **dadurch gekennzeichnet, dass** mindestens einer der bidentaten Liganden ausgewählt ist aus den Strukturen der Formeln (L-1-1), (L-1-2) und (L-2-1) bis (L-2-4), 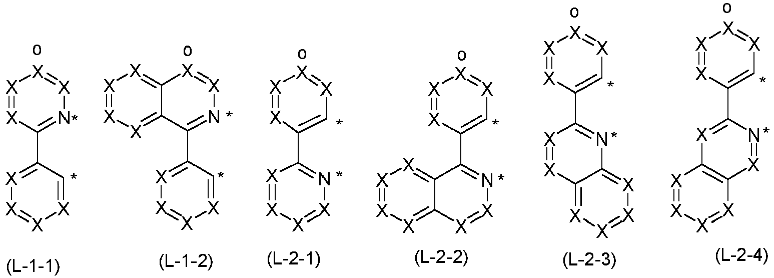 wobei die verwendeten Symbole die in Anspruch 1 genannten Bedeutungen aufweisen und an der durch * gekennzeichneten Position an das Metall koordinieren und wobei die Liganden durch eine Brücke verbunden sind, wobei die Bindung an die Brücke bevorzugt über die mit "o" markierte Position erfolgen kann; und/oder dass mindestens einer der bidentaten Liganden ausgewählt ist aus den Strukturen der Formeln (L-5) bis (L-32), 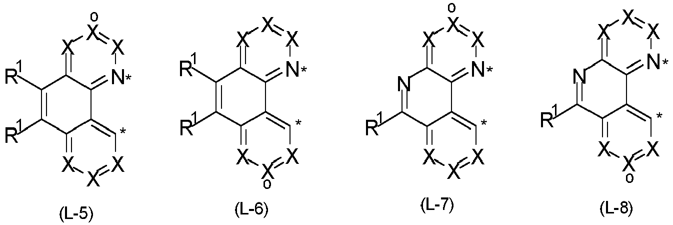 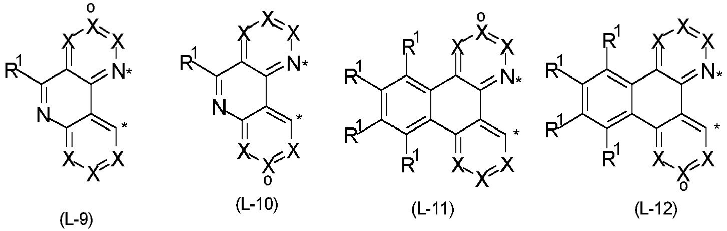 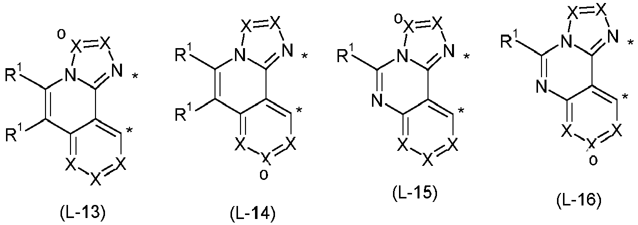 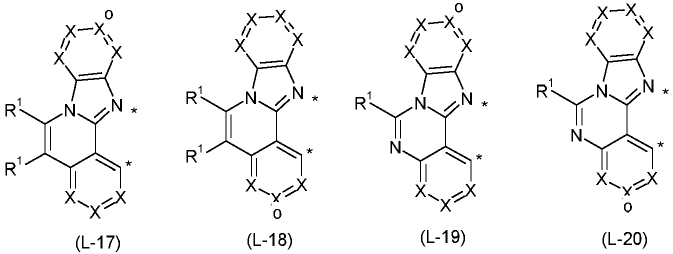 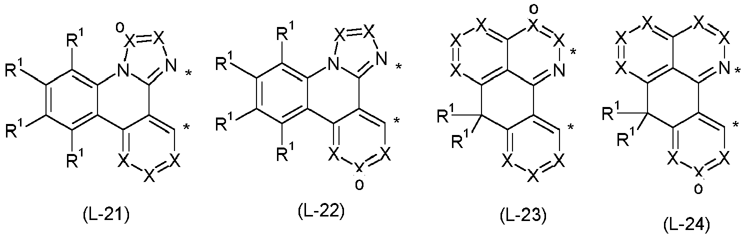 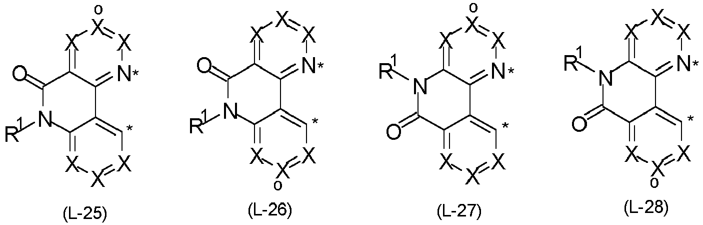 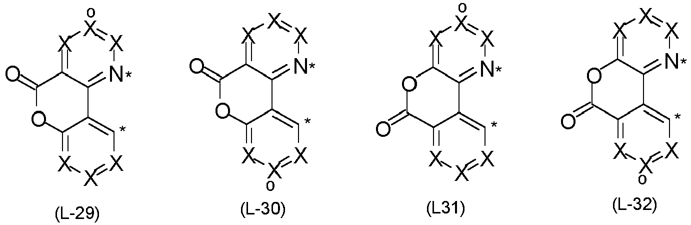 wobei die verwendeten Symbole die in Anspruch 1 genannten Bedeutungen aufweisen und an der durch * gekennzeichneten Position an das Metall koordinieren und wobei die Liganden durch eine Brücke verbunden sind, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt;
und/oder dass mindestens einer der bidentaten Liganden ausgewählt ist aus den Strukturen der folgenden Formeln (L-35) und (L-40), 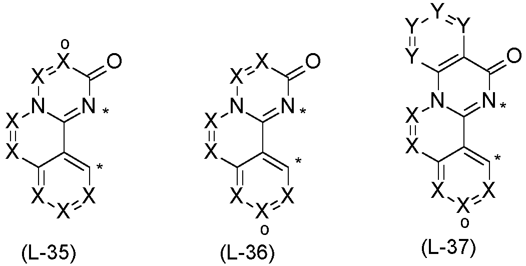 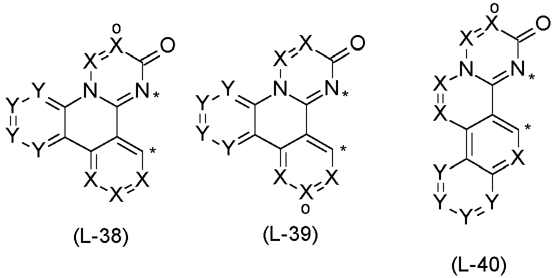 wobei R die in Anspruch 1 genannten Bedeutungen aufweist, * die Position der Koordination an das Metall darstellt, wobei die Liganden durch eine Brücke verbunden sind, wobei die Bindung an die Brücke bevorzugt über die mit "o" markierte Position erfolgen kann und für die weiteren verwendeten Symbole gilt:
X ist bei jedem Auftreten gleich oder verschieden CR oder N mit der Maßgabe, dass maximal ein Symbol X pro Cyclus für N steht, wobei X C ist, falls an dieser Position der Ligand mit einer Brücke verbunden ist;
Y ist gleich oder verschieden bei jedem Auftreten für CR¹ oder N steht und bevorzugt maximal ein Symbol Y für N;
und/oder dass mindestens einer der bidentaten Liganden ausgewählt ist aus Strukturen der folgenden Formel (L-46), 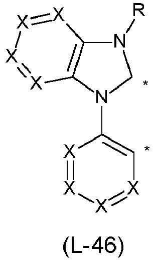 wobei X und R die in Anspruch 1 genannten Bedeutungen aufweisen, * die Position der Koordination an das Metall darstellt, wobei die Liganden durch eine Brücke verbunden sind.

10. Metallkomplex nach einem oder mehreren der Ansprüche 1 bis 9, **dadurch gekennzeichnet, dass** der Metallkomplex der allgemeinen Formel entspricht,
Ir(L)ₙ(L')ₘ Formel (1a)
wobei die Liganden L und L' bidentate Liganden darstellen und über eine Brücke verknüpft sind, so dass ein hexadentates, tripodales Ligandensystem aufgespannt wird, **dadurch gekennzeichnet, dass** die Brücke, über die die Liganden verknüpft sind, der Formel (3) oder der Formel (4) entspricht, 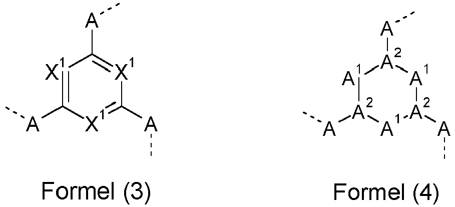 wobei die gestrichelte Bindung die Bindung der Liganden, vorzugsweise der bidentaten Liganden an diese Struktur darstellt, R, R¹ und R² die in Anspruch 1 genannten Bedeutungen aufweisen und weiterhin gilt:
X¹ ist bei jedem Auftreten gleich oder verschieden CR oder N;
A¹ ist bei jedem Auftreten gleich oder verschieden C(R)₂ oder O;
A² ist bei jedem Auftreten gleich oder verschieden CR, P(=O), B oder SiR, mit der Maßgabe, dass für A² = P(=O), B oder SiR das Symbol A¹ für O steht und das Symbol A, das an dieses A² gebunden ist, nicht für -C(=O)-NR'- oder -C(=O)-O- steht;
A ist bei jedem Auftreten gleich oder verschieden -CR=CR-, -C(=O)-NR'-, -C(=O)-O- oder eine Gruppe der folgenden Formel (5), 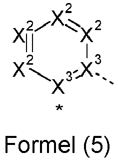 wobei die gestrichelte Bindung die Position der Bindung der Liganden, vorzugsweise der bidentaten Liganden an diese Struktur darstellt und * die Position der Verknüpfung der Einheit der Formel (5) mit der zentralen cyclischen Gruppe darstellt;
X² ist bei jedem Auftreten gleich oder verschieden CR oder N oder zwei benachbarte Gruppen X² stehen zusammen für NR, O oder S, so dass ein Fünfring entsteht, und die verbleibenden X² stehen gleich oder verschieden bei jedem Auftreten für CR oder N; oder zwei benachbarte Gruppen X² stehen zusammen für CR oder N, wenn in dem Cyclus eine der Gruppen X³ für N steht, so dass ein Fünfring entsteht; mit der Maßgabe, dass maximal zwei benachbarte Gruppen X² für N stehen;
X³ ist bei jedem Auftreten C, oder eine Gruppe X³ steht für N und die andere Gruppe X³ in demselben Cyclus steht für C; mit der Maßgabe, dass zwei benachbarte Gruppen X² zusammen für CR oder N stehen, wenn in dem Cyclus eine der Gruppen X³ für N steht;
R' ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
dabei können die drei bidentaten Liganden L und/oder L' außer durch die Brücke der Formel (3) oder (4) auch durch eine weitere Brücke zu einem Kryptat geschlossen sein.

11. Oligomer, Polymer oder Dendrimer enthaltend einen oder mehrere Metallkomplexe nach einem oder mehreren der Ansprüche 1 bis 10, wobei statt eines Wasserstoffatoms oder eines Substituenten ein oder mehrere Bindungen des Metallkomplexes zum Polymer, Oligomer oder Dendrimer vorhanden sind.

12. Formulierung enthaltend wenigstens einen Metallkomplex nach einem oder mehreren der Ansprüche 1 bis 10 und/oder ein Oligomer, Polymer oder Dendrimer nach Anspruch 11 und wenigstens eine weitere Verbindung, ausgewählt aus der Gruppe bestehend aus einem oder mehreren Lösemitteln, fluoreszierenden Emittern, phosphoreszierenden Emittern, Hostmaterialien, Matrixmaterialien, Elektronentransportmaterialien, Elektroneninjektionsmaterialien, Lochleitermaterialien, Lochinjektionsmaterialien, Elektronenblockiermaterialien und Lochblockiermaterialien.

13. Verwendung eines Metallkomplexes nach einem oder mehreren der Ansprüche 1 bis 10 oder eines Oligomers, Polymers oder Dendrimers nach Anspruch 11 oder einer Formulierung nach Anspruch 12 zur Herstellung einer elektronischen Vorrichtung, vorzugsweise als phosphoreszierender Emitter.

14. Verfahren zur Herstellung eines Metallkomplexes nach einem oder mehreren der Ansprüche 1 bis 10 oder eines Oligomers, Polymers oder Dendrimers nach Anspruch 11, **dadurch gekennzeichnet, dass** ein Metallkomplex mit einer aromatischen oder heteroaromatischen Verbindung umgesetzt wird.

15. Elektronische Vorrichtung enthaltend mindestens einen Metallkomplex nach einem oder mehreren der Ansprüche 1 bis 10 oder ein Oligomer, Polymer oder Dendrimer nach Anspruch 11, wobei die elektronische Vorrichtung bevorzugt ausgewählt ist aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen, Sauerstoff-Sensoren, Sauerstoff-Sensibilisatoren oder organischen Laserdioden.

## Claims

1. Metal complex comprising at least one structure of the general formula (1)
M(L)ₙ(L')ₘ Formula (1)
where the symbols and indices used are as follows:
M is iridium;
L is the same or different at each instance and is a bidentate ligand;
L' is the same or different at each instance and is a ligand;
n is 3;
m is 0;
where the ligands are joined by a trivalent bridge, forming a metal complex containing iridium and a hexadentate tripodal ligand,
**characterized in that** the metal complex contains at least one substructure of the formula (2): 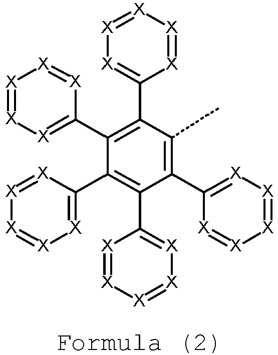 where the dotted bond represents the linkage of this group to another part of the metal complex of the formula (1) and in addition:
X is the same or different at each instance and is CR or N, with the proviso that not more than three symbols X per cycle are N;
R is the same or different at each instance and is H, D, F, Cl, Br, I, N(R¹)₂, CN, NO₂, OH, COOH, C(=O)N(R¹)₂, Si(R¹)₃, B(OR¹)₂, C(=O)R¹, P(=O) (R¹)₂, S(=O)R¹, S(=O)₂R¹, OSO₂R¹, a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, where the alkyl, alkoxy, thioalkoxy, alkenyl or alkynyl group may each be substituted by one or more R¹ radicals, where one or more nonadjacent CH₂ groups may be replaced by R¹C=CR¹, C≡C, Si(R¹)₂, C=O, NR¹, O, S or CONR¹, or an aromatic or heteroaromatic ring system which has 5 to 40 aromatic ring atoms and may be substituted in each case by one or more R¹ radicals, or an aryloxy or heteroaryloxy group which has 5 to 40 aromatic ring atoms and may be substituted by one or more R¹ radicals; at the same time, two R radicals together may also form a ring system;
R¹ is the same or different at each instance and is H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, where each alkyl, alkoxy, thioalkoxy, alkenyl or alkynyl group may be substituted by one or more R² radicals, where one or more nonadjacent CH₂ groups may be replaced by R²C=CR², C≡C, Si(R²)₂, C=O, NR², O, S or CONR², or an aromatic or heteroaromatic ring system which has 5 to 40 aromatic ring atoms and may be substituted in each case by one or more R² radicals, or an aryloxy or heteroaryloxy group which has 5 to 40 aromatic ring atoms and may be substituted by one or more R² radicals, or an aralkyl or heteroaralkyl group which has 5 to 40 aromatic ring atoms and may be substituted by one or more R² radicals, or a diarylamino group, diheteroarylamino group or arylheteroarylamino group which has 10 to 40 aromatic ring atoms and may be substituted by one or more R² radicals; at the same time, two or more R¹ radicals together may form a ring system;
R² is the same or different at each instance and is H, D, F or an aliphatic, aromatic and/or heteroaromatic organic radical, especially a hydrocarbyl radical, having 1 to 20 carbon atoms, in which one or more hydrogen atoms may also be replaced by F, at the same time, two or more R² substituents together may also form a mono- or polycyclic ring system;
where the substructure, as well as the linkage represented by a dotted bond, may have further bonds to parts of the metal complex of the formula (1);
with the proviso that the bidentate ligands L of the metal complex each have at least one Ir-C bond.

2. Metal complex according to Claim 1, **characterized in that** the substructure of the formula (2) conforms to at least one of the formulae (2-1), (2-2) and/or (2-3) 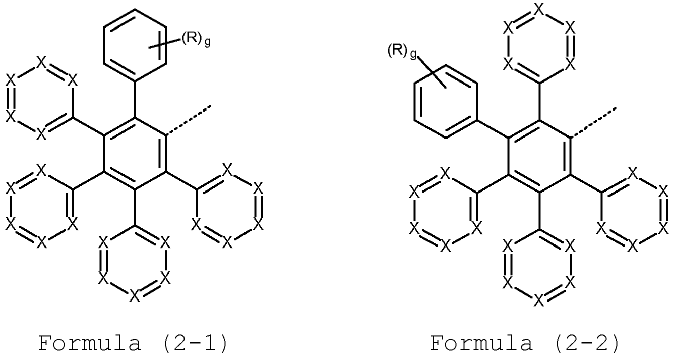 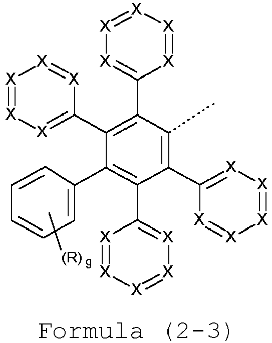 where the symbols R and X used have the definitions given in Claim 1 and g is 0, 1, 2, 3, 4 or 5, preferably 0, 1, 2 or 3, where the substructure, as well as the linkage represented by a dotted bond, may have further bonds to parts of the metal complex of the formula (1).

3. Metal complex according to Claim 1 or 2, **characterized in that** the substructure of the formula (2) conforms to the formula (2-4) 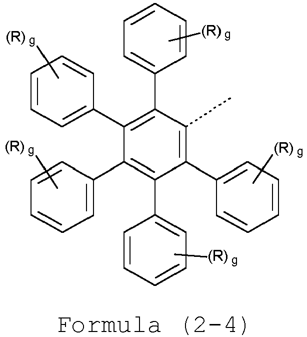 where the symbols R and X used have the definitions given in Claim 1 and g is the same or different at each instance and is 0, 1, 2, 3, 4 or 5, preferably 0, 1, 2 or 3, where the substructure, as well as the linkage represented by a dotted bond, may have further bonds to parts of the metal complex of the formula (1).

4. Metal complex according to at least one of Claims 1 to 3, **characterized in that** the linkage, represented by a dotted bond in formula (2), (2-1), (2-2), (2-3) or (2-4), of the substructure of formula (2), (2-1), (2-2), (2-3) and/or (2-4) is bonded to an aromatic or heteroaromatic ring system, preferably an aryl or heteroaryl radical having preferably 5 to 40 ring atoms.

5. Metal complex according to Claim 4, **characterized in that** the linkage, represented by a dotted bond in formula (2), (2-1), (2-2), (2-3) or (2-4), of the substructure of formula (2), (2-1), (2-2), (2-3) and/or (2-4) is bonded to an aryl or heteroaryl radical of the formula (Ar-1) 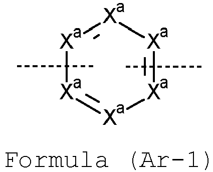 where the dotted bonds represent the linkages of this group to other parts of the metal complex of the formula (1) and the symbols X^{a} used are N, CR or C if X^{a} represents a bond to the substructure of the formula (2), (2-1), (2-2), (2-3) or (2-4) or to another part of the metal complex of the formula (1), and R in each case independently has the definitions given in Claim 1, where the substructure, as well as the linkage represented by a dotted bond, may have further bonds to parts of the metal complex of the formula (1).

6. Metal complex according to Claim 4 or 5, **characterized in that** the aromatic or heteroaromatic ring system bonded to the substructure of formula (2), (2-1), (2-2), (2-3) and/or (2-4) is bonded directly to the metal atom M.

7. Metal complex according to one or more of Claims 1 to 6, **characterized in that** the bidentate ligands coordinate to the iridium via one carbon atom and one nitrogen atom or via two carbon atoms.

8. Metal complex according to at least one of Claims 1 to 7, **characterized in that** the metal complex contains at least one bidentate ligand of the formula (L-1), (L-2) and/or (L-3) 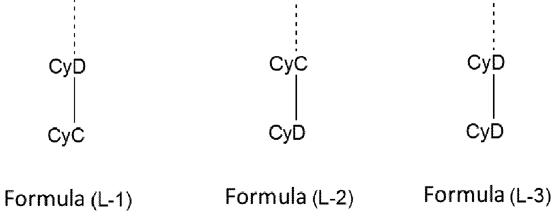 where the symbols and indices used are as follows:
CyC is the same or different at each instance and is a substituted or unsubstituted aryl or heteroaryl group which has 5 to 14 aromatic ring atoms and coordinates in each case to the metal via a carbon atom and which is bonded to CyD via a covalent bond in each case;
CyD is the same or different at each instance and is a substituted or unsubstituted heteroaryl group which has 5 to 14 aromatic ring atoms and coordinates to the metal via a nitrogen atom or via a carbene carbon atom and which is bonded to CyC via a covalent bond;
at the same time, the ligands (L-1), (L-2) and/or (L-3) are joined to one another via a trivalent bridge, thus forming a hexadentate ligand system; where these bonds to a bridge are indicated by the dotted bond.

9. Metal complex according to one or more of Claims 1 to 8, **characterized in that** at least one of the bidentate ligands is selected from the structures of the formulae (L-1-1), (L-1-2) and (L-2-1) to (L-2-4): 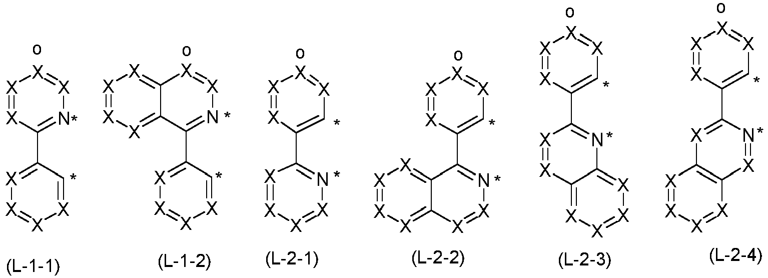 where the symbols used have the definitions given in Claim 1 and coordinate to the metal at the position identified by * and where the ligands are bonded by a bridge, where the bond to the bridge may preferably be via the position marked "○";
and/or **in that** at least one of the bidentate ligands is selected from the structures of the formulae (L-5) to (L-32): 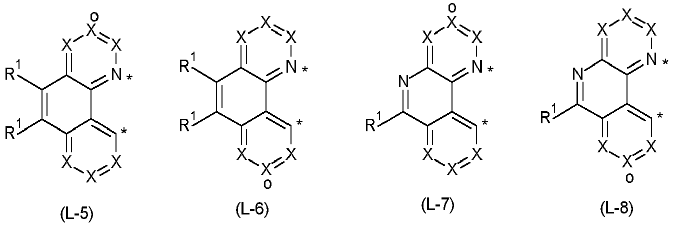 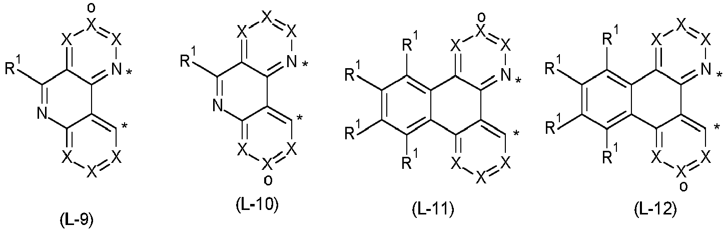 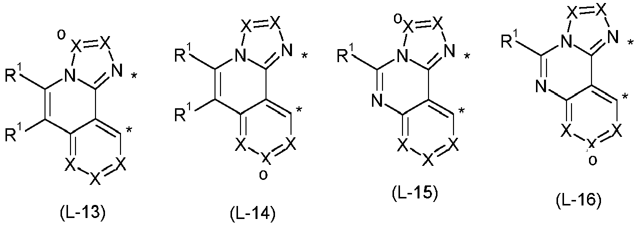 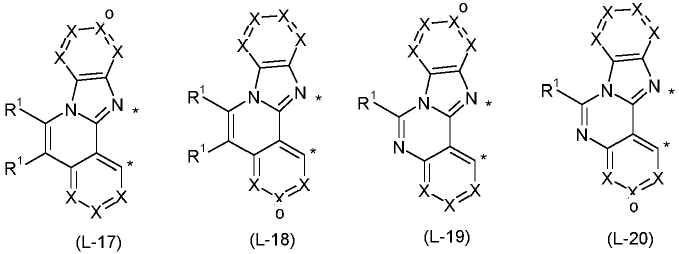 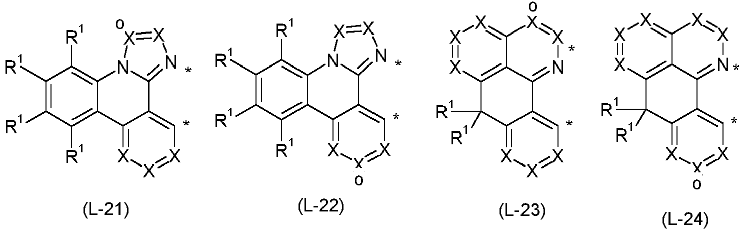 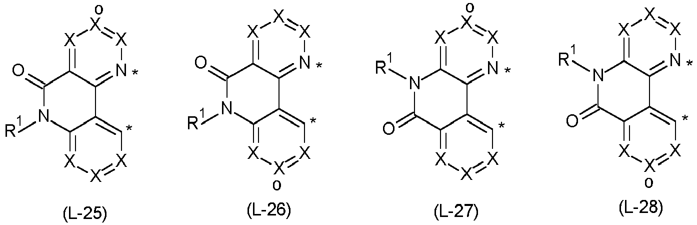 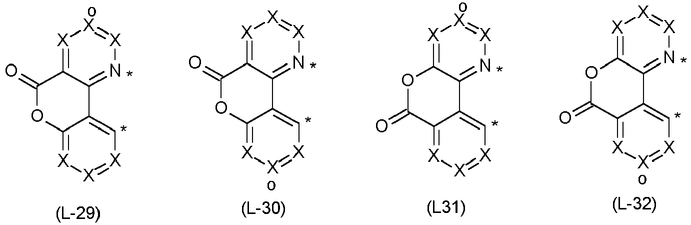 where the symbols used have the definitions given in Claim 1 and coordinate to the metal at the position identified by * and the ligands are bonded by a bridge, where the bond to the bridge may preferably be via the position marked "o", where the position marked "○" represents a carbon atom if it constitutes a bridgehead site;
and/or **in that** at least one of the bidentate ligands is selected from the structures of the following formulae (L-35) and (L-40): 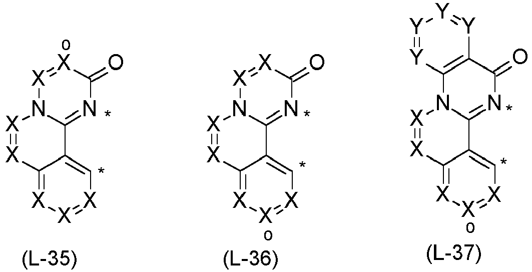 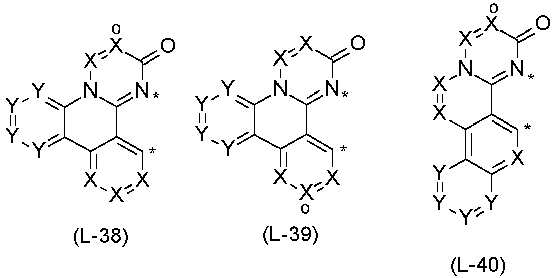 where R has the definitions given in Claim 1, * represents the position of coordination to the metal, where the ligands are bonded by a bridge, where the bond to the bridge may preferably be via the position marked "○", and the further symbols used are as follows:
X is the same or different at each instance and is CR or N, with the proviso that not more than one X symbol per cycle is N, where X is C if the ligand at this position is bonded to a bridge;
Y is the same or different at each instance and is CR¹ or N and preferably not more than one symbol Y is N;
and/or **in that** at least one of the bidentate ligands is selected from structures of the following formula (L-46) : 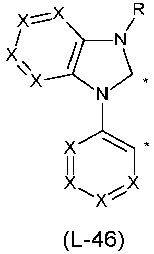 where X and R have the definitions given in Claim 1, * represents the position of coordination to the metal, where the ligands are bonded by a bridge.

10. Metal complex according to one or more of Claims 1 to 9, **characterized in that** the metal complex conforms to the general formula
Ir(L)ₙ(L')ₘ Formula (1a)
where the ligands L and L' are bidentate ligands and are joined via a bridge so as to form a hexadentate tripodal ligand system, **characterized in that** the bridge via which the ligands are joined conforms to the formula (3) or to the formula (4) 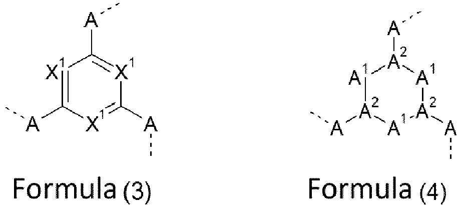 where the dotted bond represents the bond of the ligands, preferably of the bidentate ligands, to this structure, R, R¹ and R² have the definitions given in Claim 1 and in addition:
X¹ is the same or different at each instance and is CR or N;
A¹ is the same or different at each instance and is C(R)₂ or O;
A² is the same or different at each instance and is CR, P(=O), B or SiR, with the proviso that, when A² = P(=O), B or SiR, the symbol A¹ is O and the symbol A bonded to this A² is not -C(=O)-NR'- or -C(=O)-O-;
A is the same or different at each instance and is -CR=CR-, -C(=O)-NR'-, -C(=O)-O- or a group of the following formula (5): 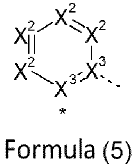 where the dotted bond represents the position of the bond of the ligands, preferably the bidentate ligands, to this structure and * represents the position of the linkage of the unit of the formula (5) to the central cyclic group;
X² is the same or different at each instance and is CR or N or two adjacent X² groups together are NR, O or S, thus forming a five-membered ring, and the remaining X² are the same or different at each instance and are CR or N; or two adjacent X² groups together are CR or N when one of the X³ groups in the cycle is N, thus forming a five-membered ring; with the proviso that not more than two adjacent X² groups are N;
X³ is C at each instance or one X³ group is N and the other X³ group in the same cycle is C; with the proviso that two adjacent X² groups together are CR or N when one of the X³ groups in the cycle is N;
R' is the same or different at each instance and is H, D, a straight-chain alkyl group having 1 to 20 carbon atoms or a branched or cyclic alkyl group having 3 to 20 carbon atoms, where the alkyl group in each case may be substituted by one or more R¹ radicals and where one or more nonadjacent CH₂ groups may be replaced by Si(R¹)₂, or an aromatic or heteroaromatic ring system which has 5 to 40 aromatic ring atoms and may be substituted in each case by one or more R¹ radicals;
at the same time, the three bidentate ligands L and/or L', apart from by the bridge of the formula (3) or (4), may also be ring-closed by a further bridge to form a cryptate.

11. Oligomer, polymer or dendrimer containing one or more metal complexes according to one or more of Claims 1 to 10, wherein, rather than a hydrogen atom or a substituent, one or more bonds of the metal complex to the polymer, oligomer or dendrimer are present.

12. Formulation comprising at least one metal complex according to one or more of Claims 1 to 10 and/or an oligomer, polymer or dendrimer according to Claim 11 and at least one further compound selected from the group consisting of one or more solvents, fluorescent emitters, phosphorescent emitters, host materials, matrix materials, electron transport materials, electron injection materials, hole conductor materials, hole injection materials, electron blocker materials and hole blocker materials.

13. Use of a metal complex according to one or more of Claims 1 to 10 or of an oligomer, polymer or dendrimer according to Claim 11 or of a formulation according to Claim 12 for production of an electronic device, preferably as phosphorescent emitter.

14. Process for preparing a metal complex according to one or more of Claims 1 to 10 or an oligomer, polymer or dendrimer according to Claim 11, **characterized in that** a metal complex is reacted with an aromatic or heteroaromatic compound.

15. Electronic device comprising at least one metal complex according to one or more of Claims 1 to 10 or an oligomer, polymer or dendrimer according to Claim 11, wherein the electronic device is preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field quench devices, light-emitting electrochemical cells, oxygen sensors, oxygen sensitizers and organic laser diodes.

## Revendications

1. Complexe métallique comprenant au moins une structure de la formule générale (1),
M(L)ₙ(L')ₘ Formule (1)
dans laquelle les symboles et indices utilisés ont les significations suivantes :
M est l'iridium ;
L est à chaque occurrence de manière identique ou différente un ligand bidentate ;
L' est à chaque occurrence de manière identique ou différente un ligand ;
n vaut 3 ;
m vaut 0 ;
les ligands étant reliés par l'intermédiaire d'un pont trivalent, un complexe métallique contenant de l'iridium et un ligand tripodal hexadentate étant ainsi formé,
**caractérisé en ce que** le complexe métallique contient au moins une structure partielle de la formule (2) : 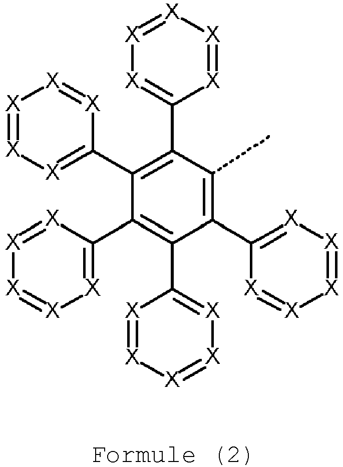 dans laquelle la liaison en pointillés représente la liaison de ce groupe avec une autre partie du complexe métallique de la formule (1), et en outre :
X est à chaque occurrence de manière identique ou différente CR ou N, à condition qu'au plus trois symboles X par cycle représentent N ;
R est à chaque occurrence de manière identique ou différente H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, un groupe alkyle, alcoxy ou thioalcoxy linéaire de 1 à 20 atomes C ou un groupe alcényle ou alcynyle de 2 à 20 atomes C ou un groupe alkyle, alcoxy ou thioalcoxy ramifié ou cyclique de 3 à 20 atomes C, le groupe alkyle, alcoxy, thioalcoxy, alcényle ou alcynyle pouvant à chaque fois être substitué avec un ou plusieurs radicaux R¹, un ou plusieurs groupes CH₂ non voisins pouvant être remplacés par R¹C=CR¹, C≡C, Si(R¹)₂, C=O, NR¹, O, S ou CONR¹, ou un système cyclique aromatique ou hétéroaromatique de 5 à 40 atomes de cycle aromatique, qui peut à chaque fois être substitué par un ou plusieurs radicaux R¹, ou un groupe aryloxy ou hétéroaryloxy de 5 à 40 atomes de cycle aromatique, qui peut être substitué par un ou plusieurs radicaux R¹ ; deux radicaux R pouvant également former l'un avec l'autre un système cyclique ;
R¹ est à chaque occurrence de manière identique ou différente H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², un groupe alkyle, alcoxy ou thioalcoxy linéaire de 1 à 20 atomes C ou un groupe alcényle ou alcynyle de 2 à 20 atomes C ou un groupe alkyle, alcoxy ou thioalcoxy ramifié ou cyclique de 3 à 20 atomes C, le groupe alkyle, alcoxy, thioalcoxy, alcényle ou alcynyle pouvant à chaque fois être substitué avec un ou plusieurs radicaux R², un ou plusieurs groupes CH₂ non voisins pouvant être remplacés par R²C=CR², C≡C, Si(R²)₂, C=O, NR², O, S ou CONR², ou un système cyclique aromatique ou hétéroaromatique de 5 à 40 atomes de cycle aromatique, qui peut à chaque fois être substitué par un ou plusieurs radicaux R², ou un groupe aryloxy ou hétéroaryloxy de 5 à 40 atomes de cycle aromatique, qui peut être substitué par un ou plusieurs radicaux R², ou un groupe aralkyle ou hétéroaralkyle de 5 à 40 atomes de cycle aromatique, qui peut être substitué par un ou plusieurs radicaux R², ou un groupe diarylamino, un groupe dihétéroarylamino ou un groupe arylhétéroarylamino de 10 à 40 atomes de cycle aromatique, qui peut être substitué par un ou plusieurs radicaux R² ; deux ou davantage de radicaux R¹ pouvant former les uns avec les autres un système cyclique ;
R² est à chaque occurrence de manière identique ou différente H, D, F ou un radical organique aliphatique, aromatique et/ou hétéroaromatique, notamment un radical hydrocarboné, de 1 à 20 atomes C, dans lequel un ou plusieurs atomes H peuvent également être remplacés par F, deux ou davantage de substituants R² pouvant également former les uns avec les autres un système cyclique mono- ou polycyclique ;
la structure partielle pouvant comprendre, en plus de la liaison représentée par une liaison en pointillés, d'autres liaisons avec des parties du complexe métallique de la formule (1) ;
à condition que les ligands bidentates L du complexe métallique comprennent à chaque fois au moins une liaison Ir-C.

2. Complexe métallique selon la revendication 1, **caractérisé en ce que** la structure partielle de la formule (2) correspond au moins à une des formules (2-1), (2-2) et/ou (2-3), 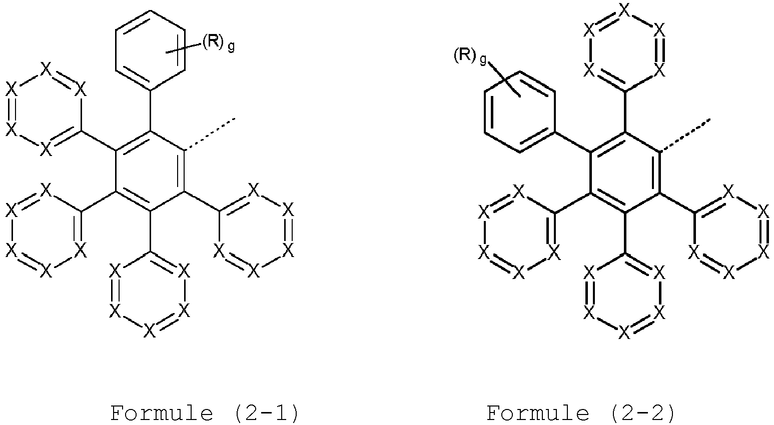 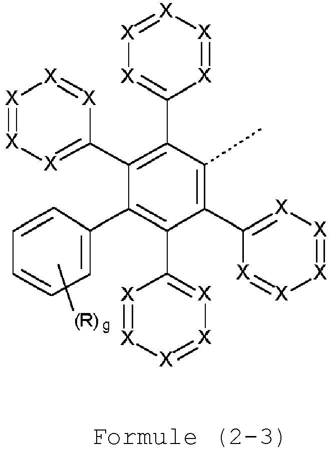 dans lesquelles les symboles R et X utilisés ont les significations indiquées dans la revendication 1 et g vaut 0, 1, 2, 3, 4 ou 5, de préférence 0, 1, 2 ou 3, la structure partielle pouvant comprendre, en plus de la liaison représentée par une liaison en pointillés, d'autres liaisons avec des parties du complexe métallique de la formule (1).

3. Complexe métallique selon la revendication 1 ou 2, **caractérisé en ce que** la structure partielle de la formule (2) correspond à la formule (2-4), 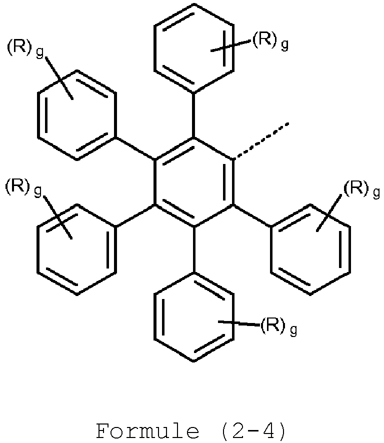 dans laquelle les symboles R et X utilisés ont les significations indiquées dans la revendication 1 et g vaut de manière identique ou différente à chaque occurrence 0, 1, 2, 3, 4 ou 5, de préférence 0, 1, 2 ou 3, la structure partielle pouvant comprendre, en plus de la liaison représentée par une liaison en pointillés, d'autres liaisons avec des parties du complexe métallique de la formule (1).

4. Complexe métallique selon au moins l'une quelconque des revendications 1 à 3, **caractérisé en ce que** la liaison de la structure partielle selon la formule (2), (2-1), (2-2), (2-3) et/ou (2-4) représentée par une liaison en pointillés dans la formule (2), (2-1), (2-2), (2-3) et (2-4) est reliée avec un système cyclique aromatique ou hétéroaromatique, de préférence un radical aryle ou hétéroaryle contenant de préférence 5 à 40 atomes de cycle.

5. Complexe métallique selon la revendication 4, **caractérisé en ce que** la liaison de la structure partielle selon la formule (2), (2-1), (2-2), (2-3) et/ou (2-4) représentée par une liaison en pointillés dans la formule (2), (2-1), (2-2), (2-3) et (2-4) est reliée avec un radical aryle ou hétéroaryle de la formule (Ar-1), 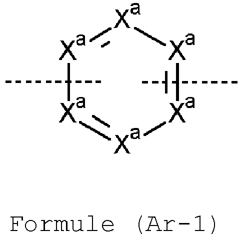 dans laquelle les liaisons en pointillés représentent les liaisons de ce groupe avec d'autres parties du complexe métallique de la formule (1) et les symboles X^{a} utilisés représentent N, CR ou C dans le cas où X^{a} représente une liaison à la structure partielle de la formule (2), (2-1), (2-2), (2-3) ou (2-4) ou à une autre partie du complexe métallique de la formule (1), et R a à chaque fois indépendamment les significations indiquées dans la revendication 1, la structure partielle pouvant comprendre, en plus de la liaison représentée par une liaison en pointillés, d'autres liaisons avec des parties du complexe métallique de la formule (1).

6. Complexe métallique selon la revendication 4 ou 5, **caractérisé en ce que** le système cyclique aromatique ou hétéroaromatique relié avec la structure partielle selon la formule (2), (2-1), (2-2), (2-3) et/ou (2-4) est relié directement avec l'atome métallique M.

7. Complexe métallique selon une ou plusieurs des revendications 1 à 6, **caractérisé en ce que** les ligands bidentates sont coordonnés à l'iridium par l'intermédiaire respectivement d'un atome de carbone et d'un atome d'azote ou par l'intermédiaire de deux atomes de carbone.

8. Complexe métallique selon une ou plusieurs des revendications 1 à 7, **caractérisé en ce que** le complexe métallique contient au moins un ligand bidentate de la formule (L-1), (L-2) et/ou (L-3), 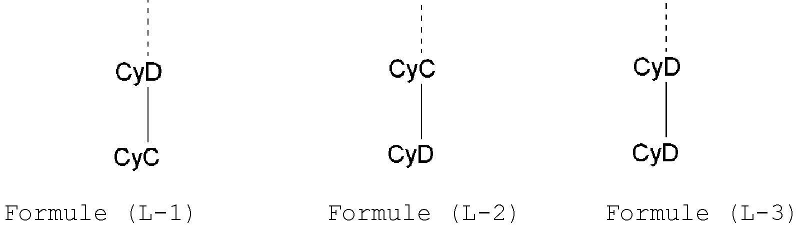 dans lesquelles les symboles et indices utilisés ont les significations suivantes :
CyC est de manière identique ou différente à chaque occurrence un groupe aryle ou hétéroaryle substitué ou non substitué de 5 à 14 atomes de cycle aromatique, qui est à chaque fois coordonné au métal par l'intermédiaire d'un atome de carbone et qui est à chaque fois relié avec CyD par l'intermédiaire d'une liaison covalente ;
CyD est de manière identique ou différente à chaque occurrence un groupe hétéroaryle substitué ou non substitué de 5 à 14 atomes de cycle aromatique, qui est coordonné au métal par l'intermédiaire d'un atome d'azote ou par l'intermédiaire d'un atome de carbone de carbène, et qui est relié avec CyC par l'intermédiaire d'une liaison covalente ;
les ligands (L-1), (L-2) et/ou (L-3) étant reliés les uns avec les autres par l'intermédiaire d'un pont trivalent et formant ainsi un système de ligand hexadentate, ces liaisons à un pont étant indiquées par la liaison en pointillés.

9. Complexe métallique selon une ou plusieurs des revendications 1 à 8, **caractérisé en ce qu'**au moins un des ligands bidentates est choisi parmi les structures des formules (L-1-1), (L-1-2) et (L-2-1) à (L-2-4), 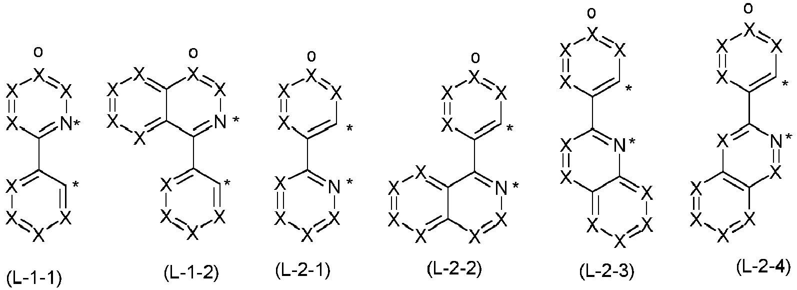 dans lesquelles les symboles utilisés ont les significations indiquées dans la revendication 1 et qui sont coordonnées au métal à la position **caractérisée par** * et dans lesquelles les ligands sont reliés par un pont, la liaison au pont pouvant de préférence avoir lieu par l'intermédiaire de la position marquée avec « ○ » ;
et/ou **en ce qu'**au moins un des ligands bidentates est choisi parmi les structures des formules (L-5) à (L-32), 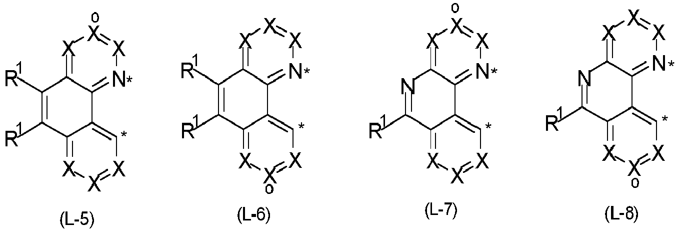 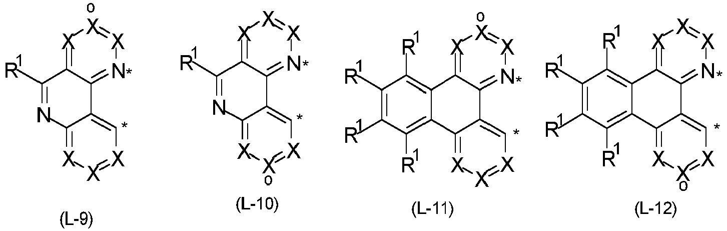 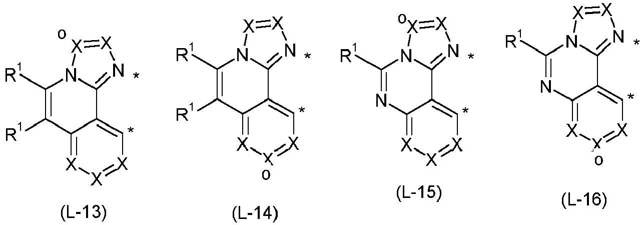 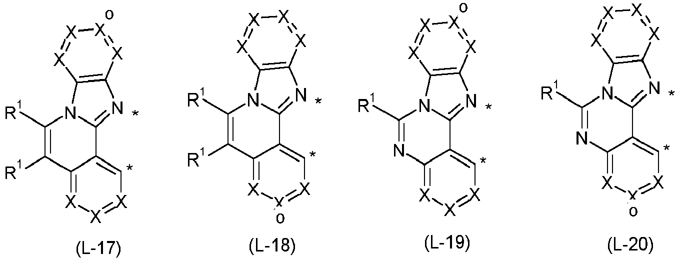 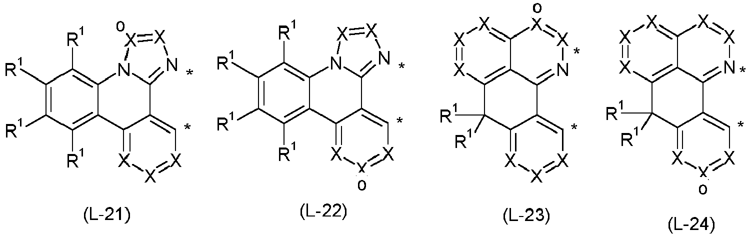 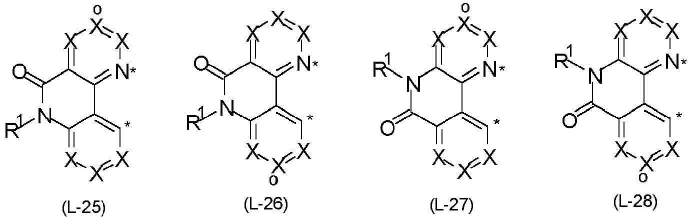 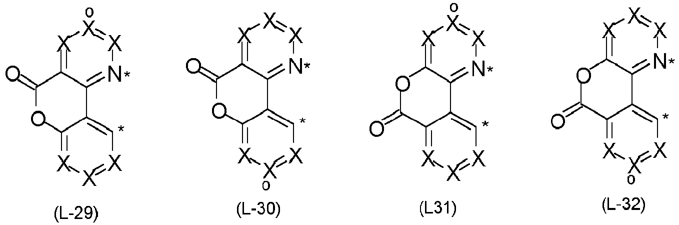 dans lesquelles les symboles utilisés ont les significations indiquées dans la revendication 1 et qui sont coordonnées au métal à la position **caractérisée par** * et dans lesquelles les ligands sont reliés par un pont, la liaison au pont pouvant de préférence avoir lieu par l'intermédiaire de la position marquée avec « ○ », la position marquée avec « ○ » représentant un atome de carbone si celui-ci représente un point de liaison de pont ;
et/ou **en ce qu'**au moins un des ligands bidentates est choisi parmi les structures des formules (L-35) et (L-40) suivantes : 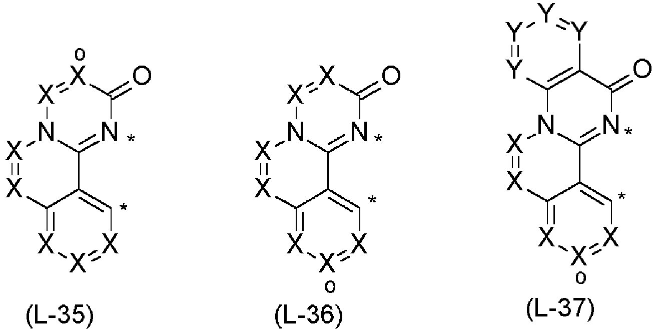 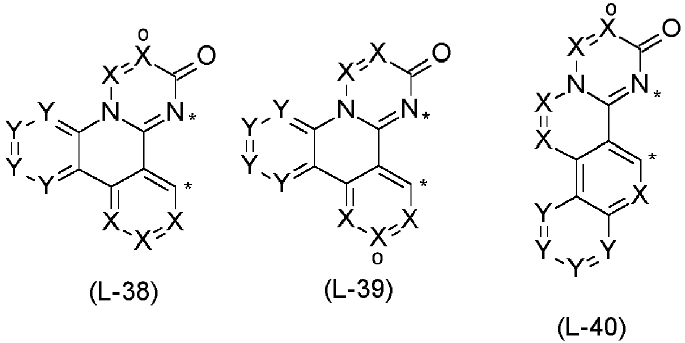 dans lesquelles R a les significations indiquées dans la revendication 1, * représente la position de coordination au métal, les ligands étant reliés par un pont, la liaison au pont pouvant de préférence avoir lieu par l'intermédiaire de la position marquée avec « ○ » et les autres symboles utilisés ayant les significations suivantes :
X est à chaque occurrence de manière identique ou différente CR ou N, à condition qu'au plus un symbole X par cycle représente N, X étant C lorsque le ligand est relié à cette position avec un pont ;
Y est de manière identique ou différente à chaque occurrence CR¹ ou N, et de préférence au plus un symbole Y représente N ;
et/ou **en ce qu'**au moins un des ligands bidentates est choisi parmi les structures de la formule (L-46) suivante, 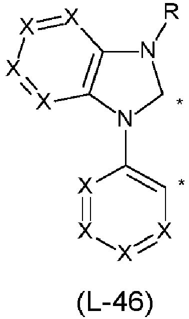
dans laquelle X et R ont les significations indiquées dans la revendication 1, * représente la position de la coordication au métal, les ligands étant reliés par un pont.

10. Complexe métallique selon une ou plusieurs des revendications 1 à 9, **caractérisé en ce que** le complexe métallique correspond à la formule générale,
Ir(L)ₙ(L')ₘ Formule (1a)
dans laquelle les ligands L et L' représentent des ligands bidentates et sont reliés par un pont, de manière à former un système de ligand tripodal hexadentate, **caractérisé en ce que** le pont par l'intermédiaire duquel les ligands sont reliés correspond à la formule (3) ou à la formule (4), 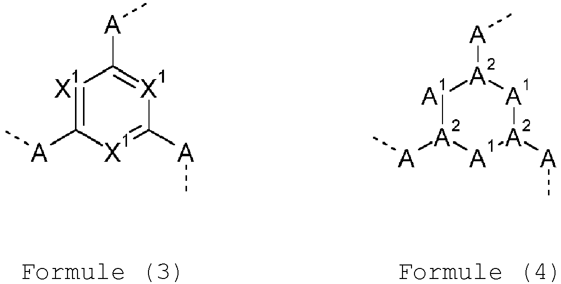 dans lesquelles la liaison en pointillés représente la liaison des ligands, de préférence des ligands bidentates, à cette structure, R, R¹ et R² ont les significations indiquées dans la revendication 1 et en outre :
X¹ est à chaque occurrence de manière identique ou différente CR ou N ;
A¹ est à chaque occurrence de manière identique ou différente C(R)₂ ou O ;
A² est à chaque occurrence de manière identique ou différente CR, P(=O), B ou SiR, à condition que pour A² = P(=O), B ou SiR, le symbole A¹ représente O et le symbole A, qui est relié à cet A², ne représente pas - C(=O)-NR'- ou -C(=O)-O- ;
A est à chaque occurrence de manière identique ou différente -CR=CR-, -C(=O)- NR'-, -C(=O)-O- ou un groupe de la formule (5) suivante, 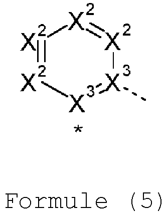
dans laquelle la liaison en pointillés représente la position de la liaison des ligands, de préférence des ligands bidentates, à cette structure, et * représente la position de la liaison de l'unité de la formule (5) avec le groupe cyclique central ;
X² est à chaque occurrence de manière identique ou différente CR ou N ou deux groupe X² voisins représentent ensemble NR, O ou S, de manière à former un cycle à cinq chaînons, et les X² restants représentent de manière identique ou différente à chaque occurrence CR ou N ; ou dex groupes X² voisins représentent ensemble CR ou N, lorsqu'un des groupes X³ dans le cycle représente N, de manière à former un cycle à cinq chaînons ; à condition qu'au plus deux groupes X² voisins représentent N ;
X³ est à chaque occurrence C, ou un groupe X³ représente N et l'autre groupe X³ dans le même cycle représente C ; à condition que deux groupes X² voisins représentent ensemble CR ou N, lorsqu'un des groupes X³ dans le cycle représente N ;
R' est à chaque occurrence de manière identique ou différente H, D, un groupe alkyle linéaire de 1 à 20 atomes C ou un groupe alkyle ramifié ou cyclique de 3 à 20 atomes C, le groupe alkyle pouvant à chaque fois être substitué avec un ou plusieurs radicaux R¹ et un ou plusieurs groupes CH₂ non voisins pouvant être remplacés par Si(R¹)₂, ou un système cyclique aromatique ou hétéroaromatique de 5 à 40 atomes de cycle aromatique, qui peut à chaque fois être substitué par un ou plusieurs radicaux R¹ ;
les trois ligands bidentates L et/ou L' pouvant en plus du pont de la formule (3) ou (4) également être fermés en un cryptate par un pont supplémentaire.

11. Oligomère, polymère ou dendrimère contenant un ou plusieurs complexes métalliques selon une ou plusieurs des revendications 1 à 10, dans lequel au lieu d'un atome d'hydrogène ou d'un substituant, une ou plusieurs liaisons du complexe métallique au polymère, oligomère ou dendrimère sont présentes.

12. Formulation contenant au moins un complexe métallique selon une ou plusieurs des revendications 1 à 10 et/ou un oligomère, polymère ou dendrimère selon la revendication 11 et au moins un composé supplémentaire, choisi dans le groupe constitué par un ou plusieurs solvants, émetteurs fluorescents, émetteurs phosphorescents, matériaux hôtes, matériaux de matrice, matériaux de transport d'électrons, matériaux d'injection d'électrons, matériaux conducteurs de trous, matériaux d'injection de trous, matériaux de blocage d'électrons et matériaux de blocage de trous.

13. Utilisation d'un complexe métallique selon une ou plusieurs des revendications 1 à 10 ou d'un oligomère, polymère ou dendrimère selon la revendication 11 ou d'une formulation selon la revendication 12 pour la fabrication d'un dispositif électronique, de préférence en tant qu'émetteur phosphorescent.

14. Procédé de fabrication d'un complexe métallique selon une ou plusieurs des revendications 1 à 10 ou d'un oligomère, polymère ou dendrimère selon la revendication 11, **caractérisé en ce qu'**un complexe métallique est mis en réaction avec un composé aromatique ou hétéroaromatique.

15. Dispositif électronique contenant au moins un complexe métallique selon une ou plusieurs des revendications 1 à 10 ou un oligomère, polymère ou dendrimère selon la revendication 11, le dispositif électronique étant de préférence choisi dans le groupe constitué par les dispositifs électroluminescents organiques, les commutateurs intégrés organiques, les transistors à effet de champ organiques, les transistors à film mince organiques, les transistors électroluminescents organiques, les cellules solaires organiques, les détecteurs optiques organiques, les photorécepteurs organiques, les dispositifs d'extinction de champ organiques, les cellules électrochimiques électroluminescentes, les capteurs d'oxygène, les sensibilisateurs d'oxygène ou les diodes lasers organiques.
